# EUROPEAN PATENT APPLICATION

(11) **EP 4 574 831 A1**
(43) Date of publication of application: **25.06.2025**
(21) Application number: 23854876.2
(22) Date of filing: 14.08.2023
(51) Int. Cl.: C07F 5/02, C09K 11/06, H10K 50/10

(54) **BORON-CONTAINING COMPOUND, AND LIGHT-EMITTING MATERIAL AND LIGHT-EMITTING ELEMENT USING SAME**

(30) Priority: 18.08.2022 JP 2022130784
(71) Applicant: Kyushu University, National University Corporation, Nishi-ku Fukuoka-shi Fukuoka 819-0395 (JP); Nippon Soda Co., Ltd., Tokyo 100-7010 (JP)
(72) Inventor: YASUDA, Takuma, Fukuoka-shi, Fukuoka 819-0395 (JP); MIN, Hyukgi, Fukuoka-shi, Fukuoka 819-0395 (JP); KIM, Hyung Jong, Fukuoka-shi, Fukuoka 819-0395 (JP); TANAKA, Katsunori, Odawara-shi, Kanagawa 250-0280 (JP)
(74) Representative: Mewburn Ellis LLP
(86) International application number: PCT/JP2023/029422
(87) International publication number: WO 2024/038842

(57) **Abstract**

The present invention relates to a compound represented by formula (I) (in the formula, R¹ is a C1-4 alkyl group or the like, and A¹ and A² are each independently a group, etc. represented by formula (II), in which R² and R³ are each independently a hydrogen atom, a C1-4 alkyl group, or the like, and * is a bonded section), a light-emitting material containing said compound, and a light-emitting element containing said light-emitting material.

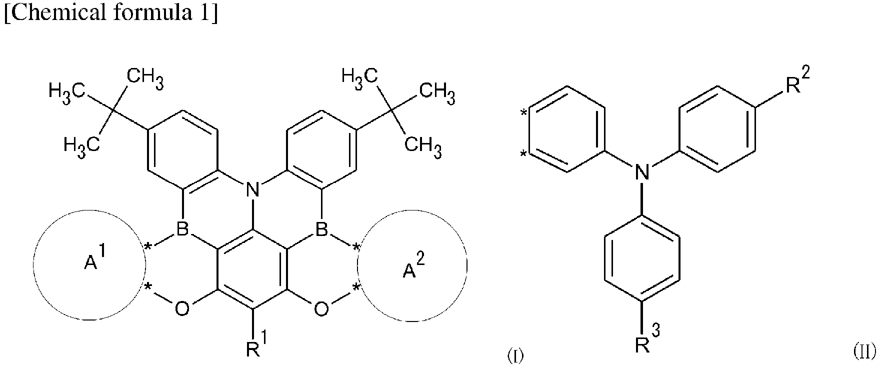

## Description

### TECHNICAL FIELD

The present invention relates to a boron-containing compound, a light-emitting material and a light-emitting element using the same. In further detail, the present invention relates to a boron-containing compound which exhibits excellent luminescent characteristics, as well as a light-emitting material and a light-emitting element using the same.

Priority is claimed on Japanese Patent Application No. 2022-130784, filed August 18, 2022, the content of which is incorporated herein by reference.

### BACKGROUND ART

The following boron-containing compounds have been proposed in Patent Document 1 as boron-containing compounds having light-emitting properties, for example.

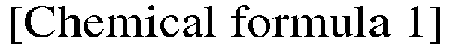

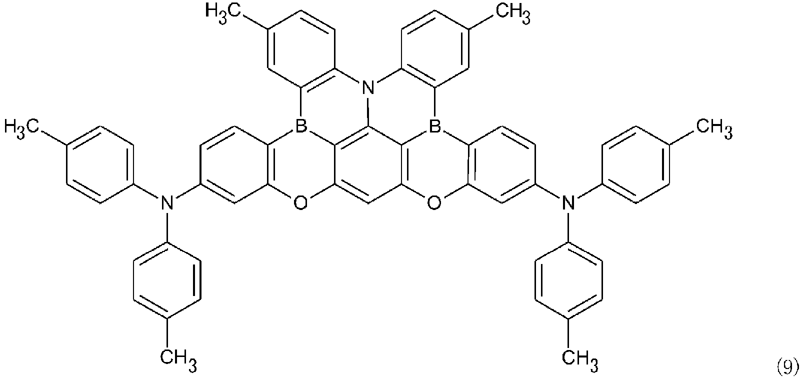

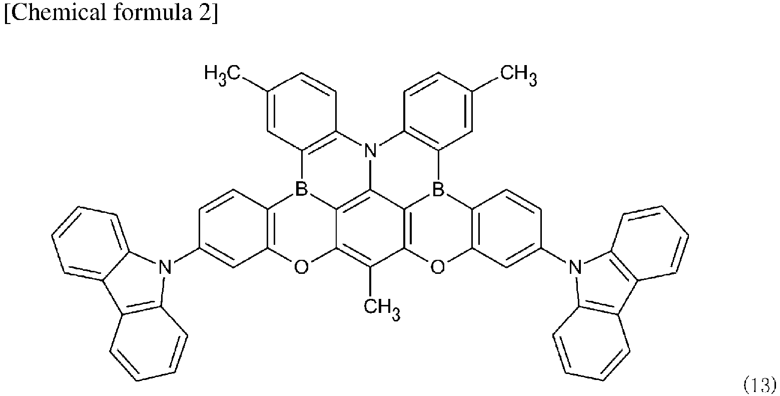

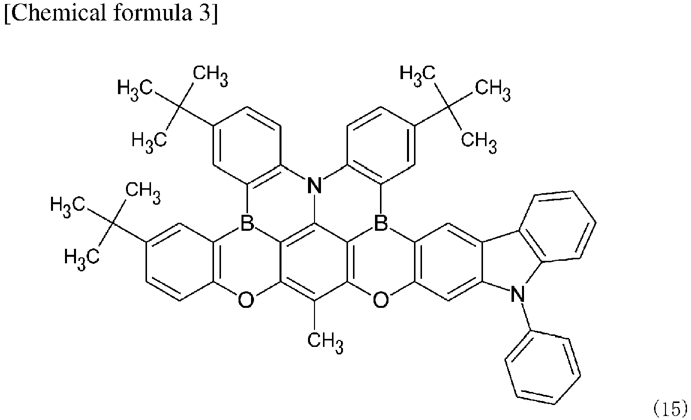

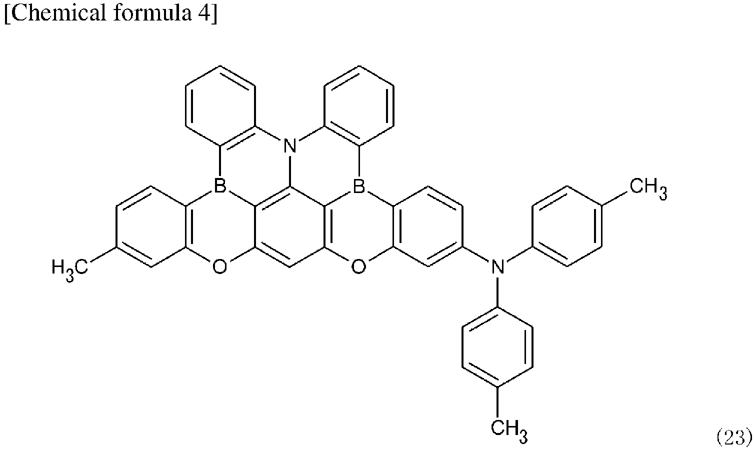

### Citation List

### Patent Document

Patent Document 1: US 2020 / 0185635 A1

### SUMMARY OF INVENTION

### Technical Problem

An object of the present invention is to provide a novel boron-containing compound which exhibits excellent luminescent characteristics, as well as a light-emitting material and a light-emitting element using the same.

### Solution to Problem

As a result of intensive studies to solve the above problems, the present invention including the following aspects has been completed.

Namely, the present invention encompasses the following aspects.
[1] A compound of formula (1). 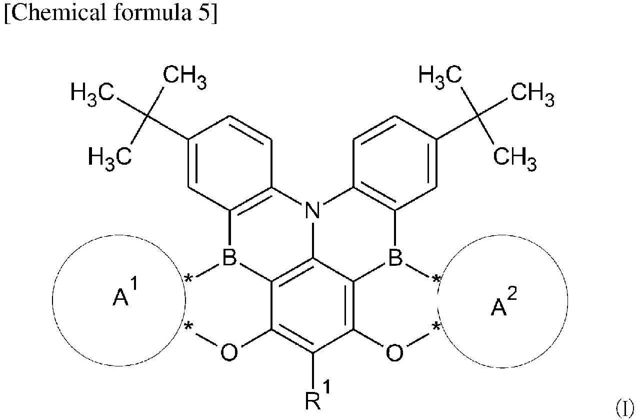 In the formula (I),
   R¹ is a C1-4 alkyl group, a substituted or unsubstituted phenyl group, a substituted or unsubstituted naphthyl group, a substituted or unsubstituted anthryl group or a substituted or unsubstituted phenanthryl group,
   A¹ and A² are each independently a group of formula (II), a group of formula (III), a group of formula (IV), a group of formula (V), a group of formula (VI), a group of formula (VII), a group of formula (VIII) or a group of formula (IX), 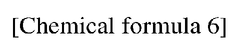 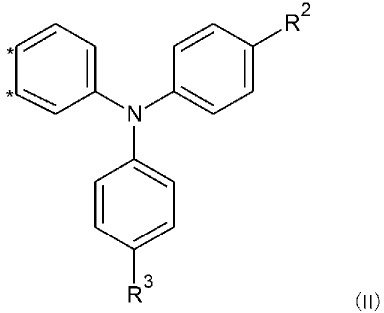 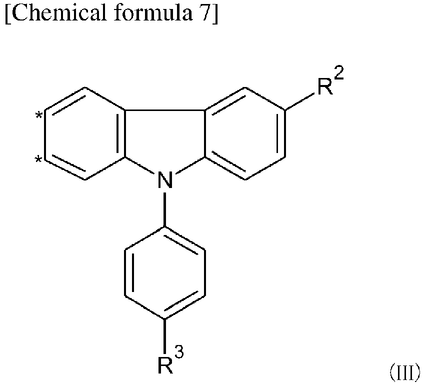 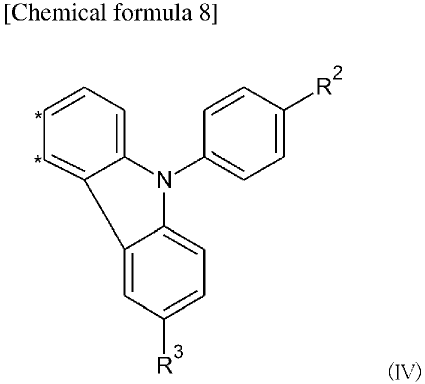 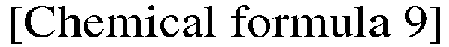 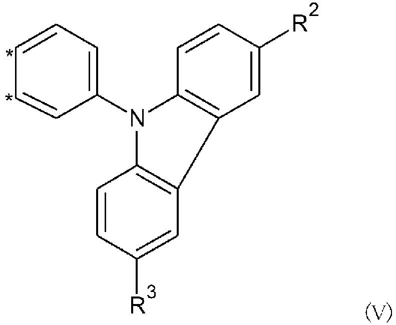 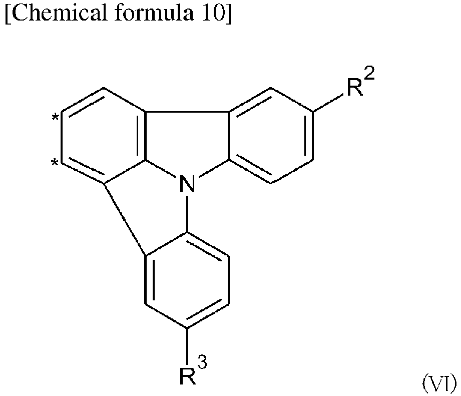 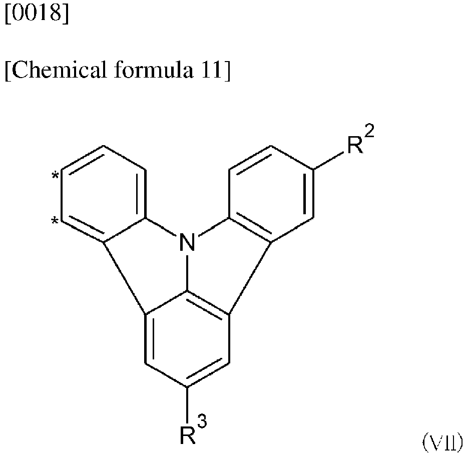 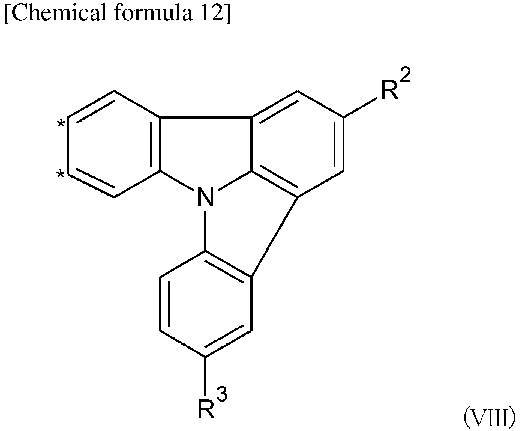 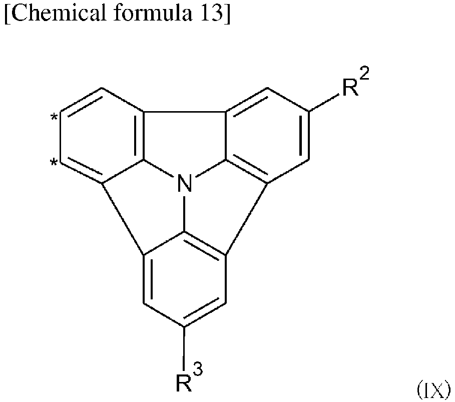
      in the formula (11), formula (111), formula (IV), formula (V), formula (VI), formula (VII), formula (VIII) and formula (IX), R² and R³ are each independently a hydrogen atom, a C1-4 alkyl group or a substituted or unsubstituted phenyl group, and
      * indicates a binding site.
[2] The compound according to [1], wherein in the formula (II), formula (III), formula (IV), formula (V), formula (VI), formula (VII), formula (VIII) and formula (IX), R² and R³ are each independently a hydrogen atom or t-butyl group.
[3] A light-emitting material containing the compound of [1] or [2].
[4] A light-emitting element containing the light-emitting material of [3]. Advantageous Effects of Invention

The boron-containing compound according to the present invention is useful as a light-emitting material. Some of the light-emitting materials according to the present invention emit delayed fluorescence. The light-emitting element containing the light-emitting material according to the present invention can realize excellent luminescent efficiency.

### BRIEF DESCRIPTION OF DRAWINGS

[FIG. 1] This drawing indicates results of absorption spectra measured in Test Example 1.
[FIG. 2] This drawing indicates results of PL spectra measured in Test Example 1.
[FIG. 3] This drawing indicates results of transient TRPLcharacteristics measured in Test Example 1.
[FIG. 4] This drawing indicates results of PL spectra measured in Test Example 2.
[FIG. 5] This drawing indicates results of transient TRPL characteristics measured in Test Example 2.
[FIG. 6] This drawing indicates results of PL spectra measured in Test Example 3.
[FIG. 7] This drawing indicates results of voltage-current density-luminescent intensity characteristics measured in Test Example 3.
[FIG. 8] This drawing indicates luminescent intensity-external quantum efficiency characteristics of light-emitting elements measured in Test Example 3.

### DESCRIPTION OF EMBODIMENTS

A boron-containing compound contained in a light-emitting material according to the present invention is a compound of formula (I).

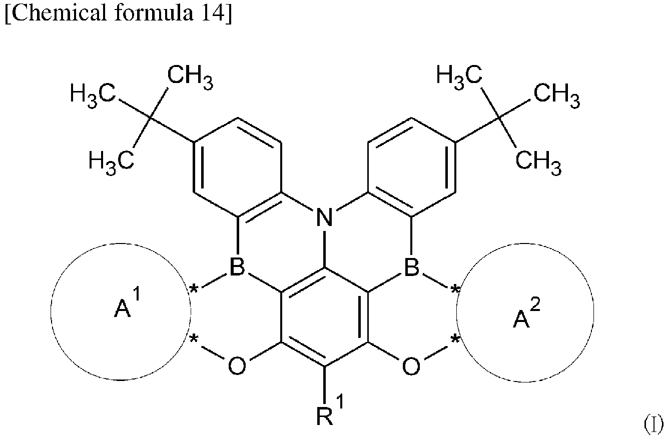

In the present invention, the term "unsubstituted" refers to a group consisting of a mother nucleus. In the case where only the name of a group serving as a mother nucleus is provided in the absence of the description "substituted", this refers to "unsubstituted" unless specifically indicated otherwise.

On the other hand, the term "substituted" refers to any hydrogen atom of a group serving as a mother nucleus being substituted with a group (substituent) having a structure that is identical to or different from the mother nucleus. Thus, a "substituent" is another group bound to a group serving as the mother nucleus. There may be one substituent or two or more substituents. Two or more substituents may be identical to or different from each other.

The term "C1-6", for example, indicates that the number of carbon atoms of the group serving as the mother nucleus is 1 to 6. The number of carbon atoms does not include the number of carbon atoms present in substituents. For example, a butyl group having an ethoxy group as a substituent is classified as a C2 alkoxy C4 alkyl group.

There are no particular limitations on "substituents" provided that they are chemically acceptable and achieve the effects of the present invention.

Specific examples of groups that can be "substituents" include the following groups:
C1-6 alkyl groups such as a methyl group, an ethyl group, a n-propyl group, an i-propyl group, a n-butyl group, a s-butyl group, an i-butyl group, a t-butyl group, a n-pentyl group, and a n-hexyl group;
C2-6 alkenyl groups such as a vinyl group, a 1-propenyl group, a 2-propenyl group (an allyl group), a 1-butenyl group, a 2-butenyl group, a 3-butenyl group, a 1-methyl-2-propenyl group, and a 2-methyl-2-propenyl group;
C2-6 alkynyl groups such as an ethynyl group, a 1-propynyl group, a 2-propynyl group, a 1-butynyl group, a 2-butynyl group, a 3-butynyl group, and a 1-methyl-2-propynyl group;
C3-6 cycloalkyl groups such as a cyclopropyl group, a cyclobutyl group, a cyclopentyl group, and a cyclohexyl group;
aryl groups such as a phenyl group, a tolyl group, a xylyl group, a trimethylphenyl group and a naphthyl group;
phenyl C1-6 alkyl groups such as a benzyl group and a phenethyl group;
3- to 6-membered heterocyclyl groups;
3- to 6-membered heterocyclyl C1-6 alkyl groups;
a hydroxy group;
C1-6 alkoxy groups such as a methoxy group, an ethoxy group, a n-propoxy group, an i-propoxy group, a n-butoxy group, a s-butoxy group, an i-butoxy group, and a t-butoxy group;
C2-6 alkenyloxy groups such as a vinyloxy group, an allyloxy group, a propenyloxy group, and a butenyloxy group;
C2-6 alkynyloxy groups such as an ethynyloxy group, and a propargyloxy group;
a phenoxy group, and a naphthoxy group;
phenyl C1-6 alkoxy groups such as a benzyloxy group, and a phenethyloxy group;
5- or 6-membered heteroaryloxy groups such as a thiazolyloxy group, and a pyridyloxy group;
5- or 6-membered heteroaryl C1-6 alkyloxy groups such as a thiazolylmethyloxy group, and a pyridylmethyloxy group;
a formyl group;
C1-6 alkylcarbonyl groups such as an acetyl group, and a propionyl group;
a formyloxy group;
C1-6 alkylcarbonyloxy groups such as an acetyloxy group, and a propionyloxy group;
a benzoyl group;
C1-6 alkoxycarbonyl groups such as a methoxycarbonyl group, an ethoxycarbonyl group, a n-propoxycarbonyl group, an i-propoxycarbonyl group, a n-butoxycarbonyl group, and a t-butoxycarbonyl group;
C1-6 alkoxycarbonyloxy groups such as a methoxycarbonyloxy group, an ethoxycarbonyloxy group, a n-propoxycarbonyloxy group, an i-propoxycarbonyloxy group, a n-butoxycarbonyloxy group, and a t-butoxycarbonyloxy group;
a carboxyl group;
halogeno groups such as a fluoro group, a chloro group, a bromo group, and an iodo group;
C1-6 haloalkyl groups such as a chloromethyl group, a chloroethyl group, a trifluoromethyl group, a 1,2-dichloro-n-propyl group, a 1-fluoro-n-butyl group, and a perfluoro-n-pentyl group;
C2-6 haloalkenyl groups such as a 2-chloro-1-propenyl group, and a 2-fluoro-1-butenyl group;
C2-6 haloalkynyl groups such as a 4,4-dichloro-1-butynyl group, a 4-fluoro-1-pentynyl group, and a 5-bromo-2-pentynyl group;
C1-6 haloalkoxy groups such as a trifluoromethoxy group, a 2-chloro-n-propoxy group, and a 2,3-dichlorobutoxy group;
C2-6 haloalkenyloxy groups such as a 2-chloropropenyloxy group, and a 3-bromobutenyloxy group;
C1-6 haloalkylcarbonyl groups such as a chloroacetyl group, a trifluoroacetyl group, and a trichloroacetyl group;
an amino group;
C1-6 alkyl-substituted amino groups such as a methylamino group, a dimethylamino group, and a diethylamino group;
an anilino group, and a naphthylamino group;
phenyl C1-6 alkylamino groups such as a benzylamino group, and a phenethylamino group;
a formylamino group;
C1-6 alkylcarbonylamino groups such as an acetylamino group, a propanoylamino group, a butyrylamino group, and an i-propylcarbonylamino group;
C1-6 alkoxycarbonylamino groups such as a methoxycarbonylamino group, an ethoxycarbonylamino group, a n-propoxycarbonylamino group, and an i-propoxycarbonylamino group;
unsubstituted or substituted aminocarbonyl groups such as an aminocarbonyl group, a dimethylaminocarbonyl group, a phenylaminocarbonyl group, and a N-phenyl-N-methylaminocarbonyl group;
imino C1-6 alkyl groups such as an iminomethyl group, a (1-imino)ethyl group, and a (1-imino)-n-propyl group;
substituted or unsubstituted N-hydroxyimino C1-6 alkyl groups such as a N-hydroxy-iminomethyl group, a (1-(N-hydroxy)-imino)ethyl group, a (1-(N-hydroxy)-imino)propyl group, a N-methoxy-iminomethyl group, and a (1-(N-methoxy)-imino)ethyl group;
an aminocarbonyloxy group;
C1-6 alkyl-substituted aminocarbonyloxy groups such as an ethylaminocarbonyloxy group, and a dimethylaminocarbonyloxy group;
a mercapto group;
C1-6 alkylthio groups such as a methylthio group, an ethylthio group, a n-propylthio group, an i-propylthio group, a n-butylthio group, an i-butylthio group, a s-butylthio group, and a t-butylthio group;
C1-6 haloalkylthio groups such as a trifluoromethylthio group, and a 2,2,2-trifluoroethylthio group;
a phenylthio group, and a naphthylthio group;
5- or 6-membered heteroarylthio groups such as a thiazolylthio group, and a pyridylthio group;
C1-6 alkylsulfinyl groups such as a methylsulfinyl group, an ethylsulfinyl group, and a t-butylsulfinyl group;
C1-6 haloalkylsulfinyl groups such as a trifluoromethylsulfinyl group, and a 2,2,2-trifluoroethylsulfinyl group;
a phenylsulfinyl group;
5- or 6-membered heteroarylsulfinyl groups such as a thiazolylsulfinyl group, and a pyridylsulfinyl group;
C1-6 alkylsulfonyl groups such as a methylsulfonyl group, an ethylsulfonyl group, and a t-butylsulfonyl group;
C1-6 haloalkylsulfonyl groups such as a trifluoromethylsulfonyl group, and a 2,2,2-trifluoroethylsulfonyl group;
a phenylsulfonyl group;
5- or 6-membered heteroarylsulfonyl groups such as a thiazolylsulfonyl group, and a pyridylsulfonyl group;
C1-6 alkylsulfonyloxy groups such as a methylsulfonyloxy group, an ethylsulfonyloxy group, and a t-butylsulfonyloxy group;
C1-6 haloalkylsulfonyloxy groups such as a trifluoromethylsulfonyloxy group, and a 2,2,2-trifluoroethylsulfonyloxy group;
tri C1-6 alkyl-substituted silyl groups such as a trimethylsilyl group, a triethylsilyl group, and a t-butyldimethylsilyl group;
a triphenylsilyl group;
a cyano group; and a nitro group.

Any hydrogen atom of the "substituent" may be substituted with a group having a different structure. Examples of such a substituent include C1-6 alkyl groups, C1-6 haloalkyl groups, C1-6 alkoxy groups, C1-6 haloalkoxy groups, halogeno groups, a cyano group, and a nitro group.

The "3- to 6-membered heterocyclyl group" contains, as a ring member atom, one to four hetero atoms selected from the group consisting of a nitrogen atom, an oxygen atom and a sulfur atom. The heterocyclyl group may be monocyclic or polycyclic. If at least one ring of a polycyclic heterocyclyl group is a hetero ring, the remaining rings thereof may be any of saturated alicyclic rings, unsaturated alicyclic rings and aromatic rings. Examples of the "3- to 6-membered heterocyclyl group" include 3- to 6-membered saturated heterocyclyl groups, 5- or 6-membered heteroaryl groups, and 5- or 6-membered partially unsaturated heterocyclyl groups.

Examples of the "3- to 6-membered saturated heterocyclyl groups" include an aziridinyl group, an epoxy group, a pyrrolidinyl group, a tetrahydrofuranyl group, a thiazolidinyl group, a piperidyl group, a piperazinyl group, a morpholinyl group, a dioxolanyl group, and a dioxanyl group.

Examples of the "5-membered heteroaryl groups" include a pyrrolyl group, a furyl group, a thienyl group, an imidazolyl group, a pyrazolyl group, an oxazolyl group, an isoxazolyl group, a thiazolyl group, an isothiazolyl group, a triazolyl group, an oxadiazolyl group, a thiadiazolyl group, and a tetrazolyl group.

Examples of the "6-membered heteroaryl groups" include a pyridyl group, a pyrazinyl group, a pyrimidinyl group, a pyridazinyl group, and a triazinyl group.

Examples of the "5- or 6-membered partially unsaturated heterocyclyl groups" include: 5-membered partially unsaturated heterocyclyl groups such as a pyrrolinyl group, a dihydrofuranyl group, a dihydrothiophenyl group, an imidazolynyl group, a pyrazolynyl group, an oxazolynyl group, an isooxazolynyl group, a thiazolynyl group, and an isothiazolynyl group; and 6-membered partially unsaturated heterocyclyl groups such as a dihydropyranyl group.

In the formula (1), R¹ is a C1-4 alkyl group, a substituted or unsubstituted phenyl group, a substituted or unsubstituted naphthyl group, a substituted or unsubstituted anthryl group or a substituted or unsubstituted phenanthryl group.

The "C1-6 alkyl group" as R¹ may be a linear chain or a branched chain. Examples of the "C1-6 alkyl group" as R¹ include a methyl group, an ethyl group, a n-propyl group, an i-propyl group, a n-butyl group, an i-butyl group, a s-butyl group, and a t-butyl group.

The "naphthyl group" as R¹ may be any of a 1-naphthyl group and a 2-naphthyl group. The "anthryl group" as R¹ may be any of a 1-anthryl group, a 2-anthryl group and a 9-anthryl group. The "phenanthryl group" as R¹ may be any of a 1-phenanthryl group, a 2-phenanthryl group, a 3-phenanthryl group, a 4-phenanthryl group and a 9-phenanthryl group.

Preferable examples of a substituent on the "phenyl group", "naphthyl group", "anthryl group", or "phenanthryl group" as R¹ include: alkyl groups such as a methyl group, an ethyl group, and a t-butyl group; aryl groups such as a phenyl group, a tolyl group, a xylyl group, a naphthyl group, an anthryl group, and a phenanthryl group; and N-arylamino groups such as a N-phenylamino group, and a N-t-butylphenylamino group. A phenyl-substituted phenyl group is a biphenylyl group. The biphenylyl group may be any of a 2-biphenylyl group, a 3-biphenylyl group, and a 4-biphenylyl group.

Among them, R¹ is preferably a C1-4 alkyl group, and more preferably a methyl group.

In the formula (I), A¹ and A² are each independently a group of formula (II), a group of formula (III), a group of formula (IV), a group of formula (V), a group of formula (VI), a group of formula (VII), a group of formula (VIII) or a group of formula (IX), and preferably a group of formula (II), a group of formula (III), or a group of formula (IV), and it is more preferable that A¹ and A² be the same groups as each other.

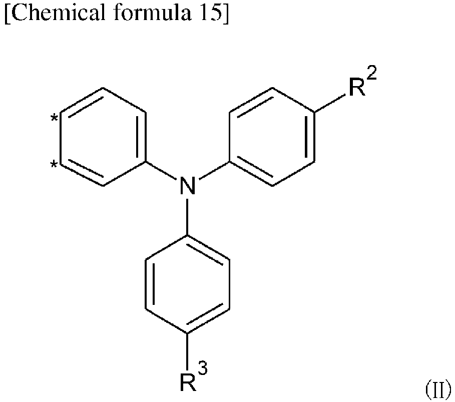

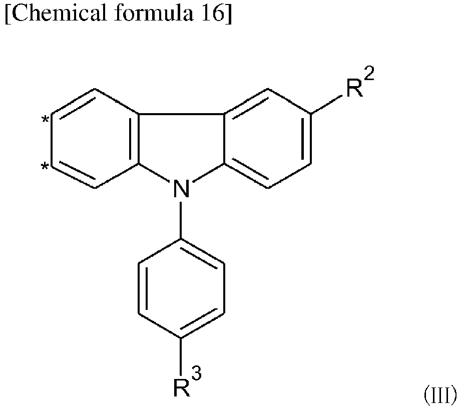

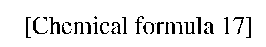

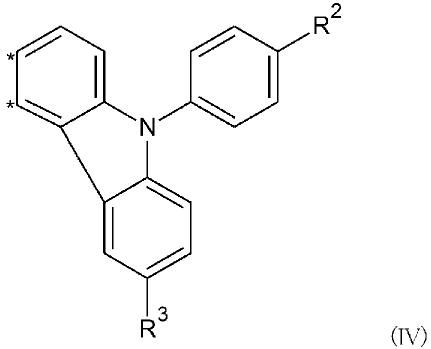

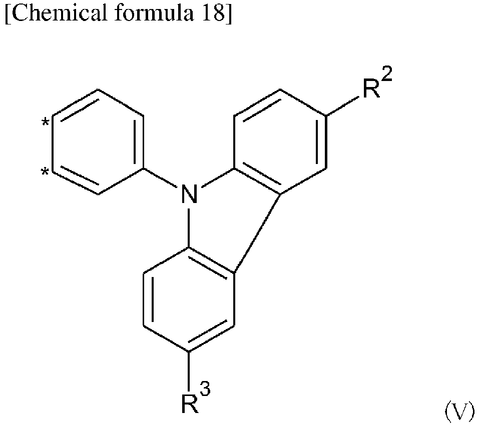

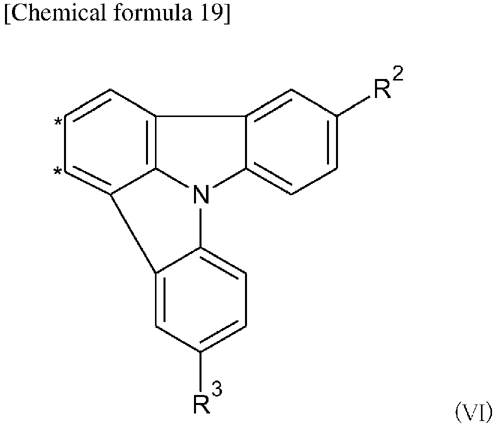

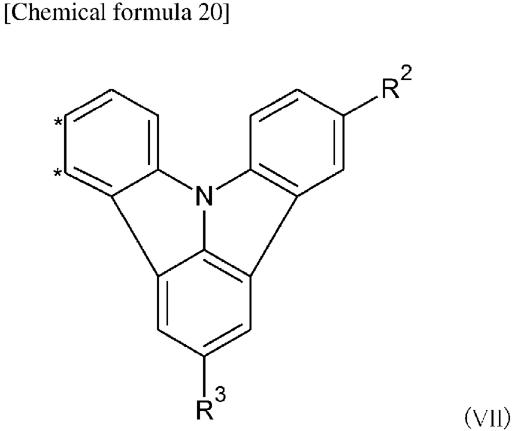

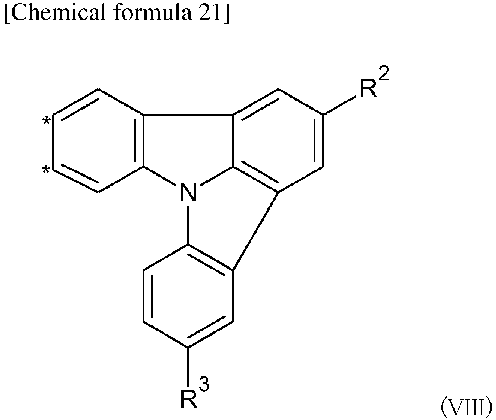

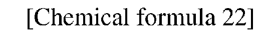

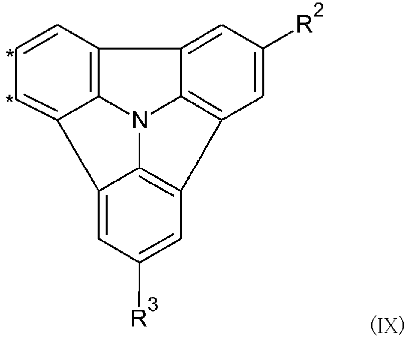

In the formula (II), formula (III), formula (IV), formula (V), formula (VI), formula (VII), formula (VIII) and formula (IX), R² and R³ are each independently a hydrogen atom, a C1-4 alkyl group or a substituted or unsubstituted phenyl group, preferably a hydrogen atom or a C1-4 alkyl group, and more preferably a hydrogen atom or a t-butyl group.

In the formula (II), formula (III), formula (IV), formula (V), formula (VI), formula (VII), formula (VIII) and formula (IX), * is a binding site.

Examples of groups of formula (II), formula (III), formula (IV), formula (V), formula (VI), formula (VII), formula (VIII) or formula (IX) include a N,N-diphenylaminobenzene-3,4-diyl group, a N,N-bis(4-C1-4 alkylphenyl)aminobenzene-3,4-diyl group, a N-(4-C1-4 alkylphenyl)-N-phenylaminobenzene-3,4-diyl group; a 9-phenyl-9H-carbazole-2,3-diyl group, a 9-(4-C1-4 alkylphenyl)-6-C1-4 alkyl-9H-carbazole-2,3-diyl group; a 9-phenyl-9H-carbazole3,4-diyl group, a 9-(4-C1-4 alkylphenyl)-6-C1-4 alkyl-9H-carbazole-3,4-diyl group; a 4-(9H-carbazol-9-yl)benzene-3,4-diyl group, a 4-(3,6-diC1-4 alkyl-9H-carbazol-9-yl))benzene-3,4-diyl group, and a 4-(3-C1-4 alkyl-9H-carbazol-9-yl)benzene-3,4-diyl group.

The "C1-4 alkyl group" as R² or R³ may be a linear chain or a branched chain. Examples of the "C1-4 alkyl group" as R¹ include a methyl group, an ethyl group, a n-propyl group, an i-propyl group, a n-butyl group, an i-butyl group, a s-butyl group, and a t-butyl group.

Preferable examples of a substituent on the "phenyl group" as R² or R³ include: alkyl groups such as a methyl group, an ethyl group, and a t-butyl group; aryl groups such as a phenyl group, a tolyl group, a xylyl group, a naphthyl group, an anthryl group, and a phenanthryl group; and N-arylamino groups such as a N-phenylamino group, and a N-t-butylphenylamino group. A phenyl-substituted phenyl group is a biphenylyl group. The biphenylyl group may be any of a 2-biphenylyl group, a 3-biphenylyl group, and a 4-biphenylyl group.

Specific examples of the boron-containing compound according to the present invention include the following compounds and among them a compound of the following formula (I-1), (I-6) or (I-7) is preferable.

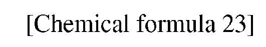

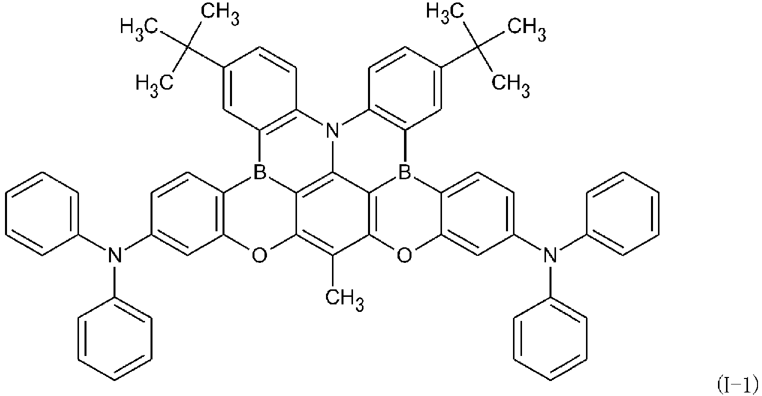

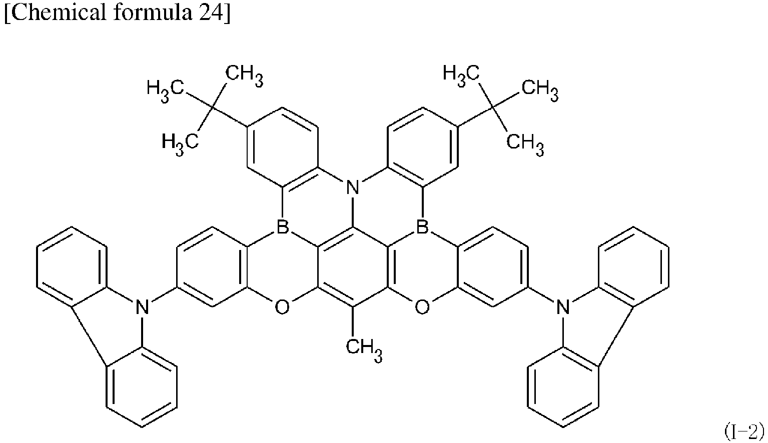

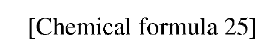

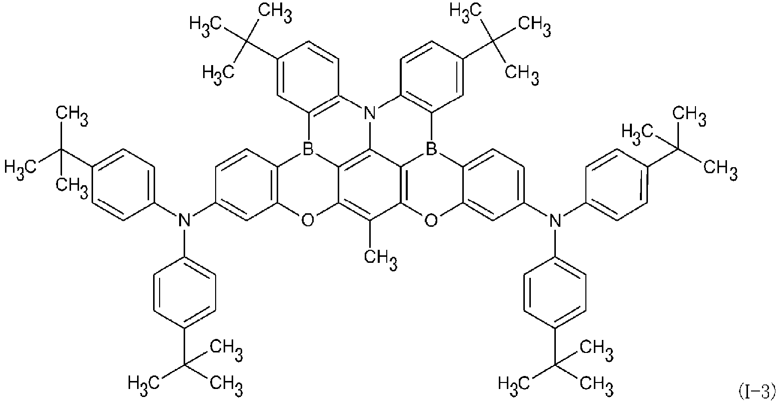

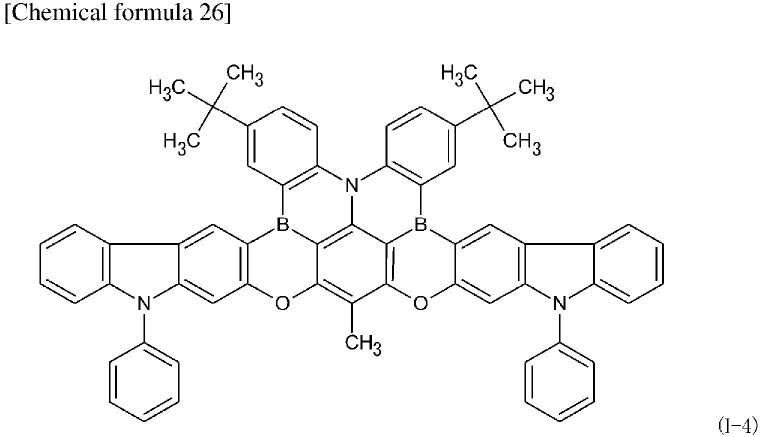

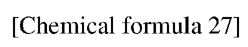

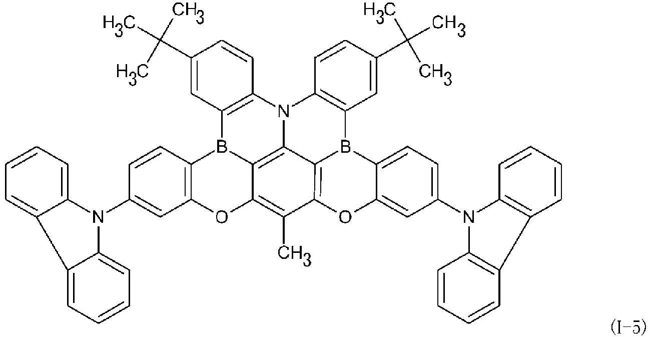

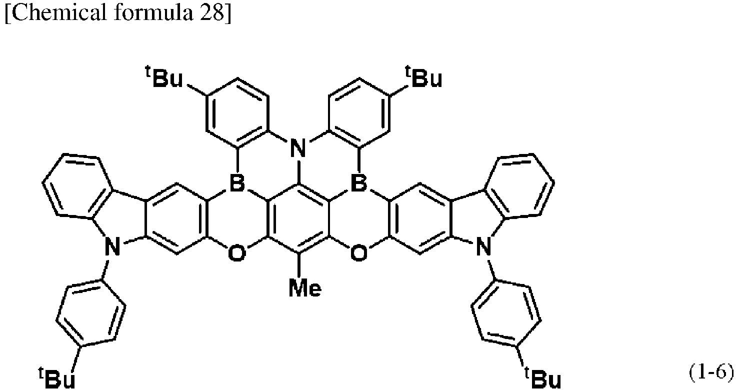

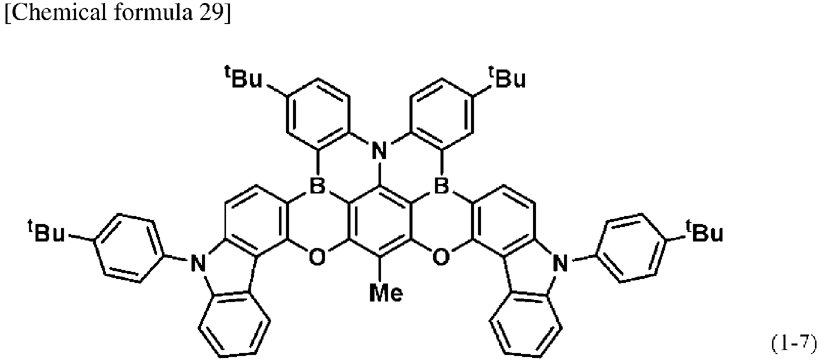

The boron-containing compound according to the present invention may be obtained by carrying out conventionally-known synthesis reactions described in Patent Document 1 or the like in combination.

For example, the compound of formula (I-1) may be obtained by the following method.

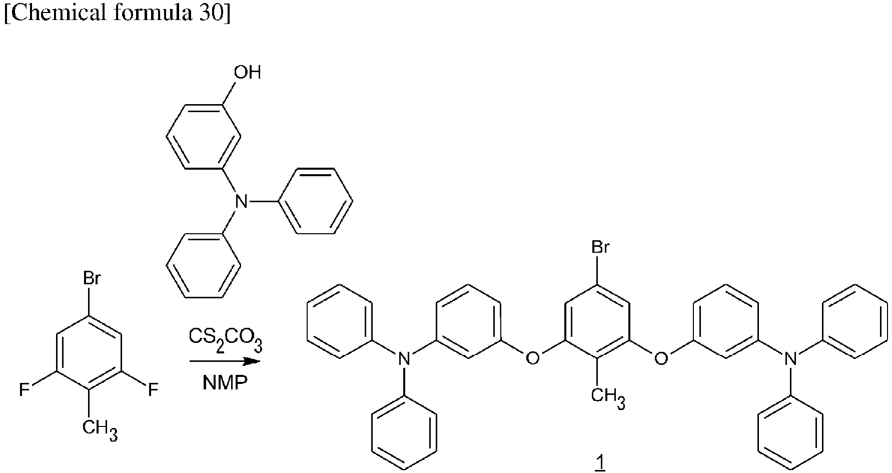

A mixture composed of 5-bromo-1,3-difluoro-2-methylbenzene, 3-(diphenylamino)phenol, Cs₂CO₃ and N-methyl-2-pyrrolidone (NMP) is reacted under nitrogen atmosphere to obtain a compound 1.

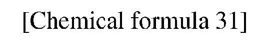

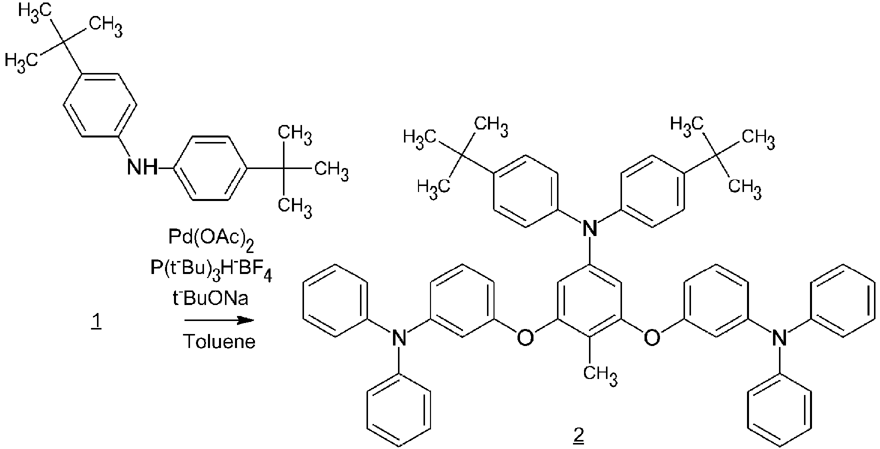

A mixture composed of the compound 1, bis(4-(tert-butyl)phenyl)amine, NaO(t-Bu), Pd(OAc)₂ and P(t-Bu)₃H·BF₄ was put into dried toluene, and reacted under nitrogen atmosphere to obtain a compound 2.

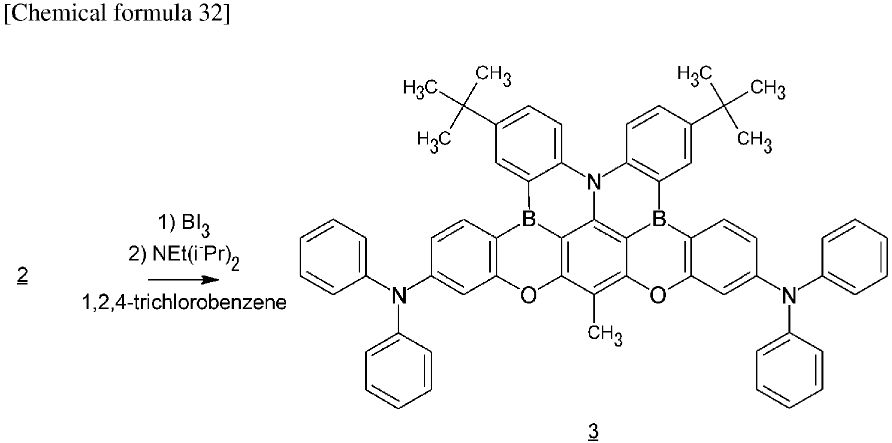

The compound 2 was dissolved in dried 1,2,4-trichlorobenzene, and then BI₃ was added gradually to the obtained solution at room temperature, followed by allowing the reaction to proceed at room temperature under nitrogen atmosphere, diluting the obtained solution with dichloromethane, and then adding NEt(i-Pr)₂ gradually thereto, thereby allowing the reaction to proceed to obtain a compound 3 of formula (1-1).

For example, the compound of the formula (I-6) may be obtained by the following method.

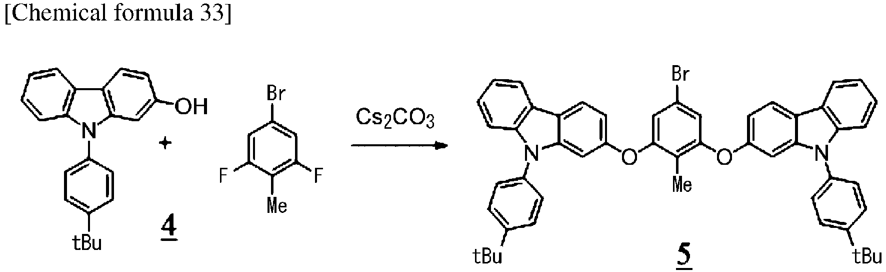

A mixture composed of 5-bromo-1,3-difluoro-2-methylbenzene, 9-(4-(t-butyl)phenyl)9H-carbazol-2-ol and N-methyl-2-pyrrolidone (NMP) was reacted under nitrogen atmosphere to obtain a compound 5.

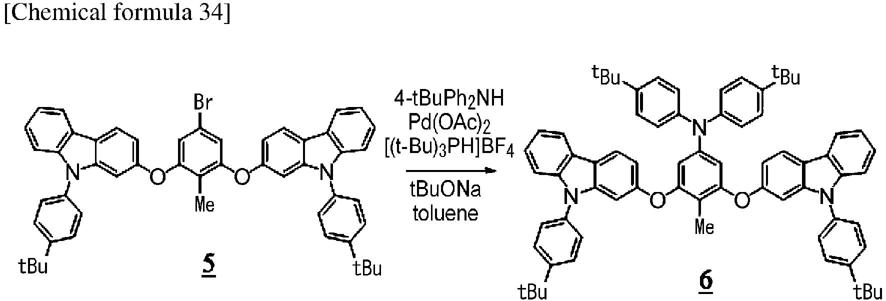

A mixture composed of the compound 5, bis(4-(tert-butyl)phenyl)amine, NaO(t-Bu), Pd(OAc)₂ and P(t-Bu)₃H·BF₄ was reacted under nitrogen atmosphere to obtain a compound 6.

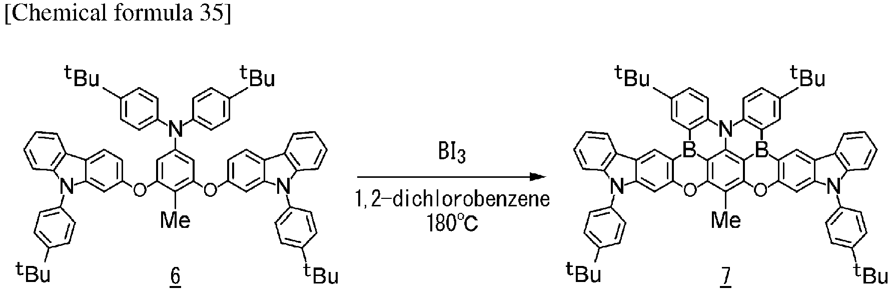

N,N-bis(4-(tert-butyl)phenyl)-3,5-bis((9-(4-(tert-butyl)phenyl)-9H-carbazol-2-yl)oxy)-4-methylaniline was dissolved in dried 1,2-dichlorobenzene, followed by adding BI₃ gradually thereto at room temperature to allow the reaction to proceed at room temperature under nitrogen atmosphere, thereby obtaining a compound 7 of formula (I-6).

For example, the compound of the formula (I-7) may be obtained by the following method.

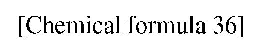

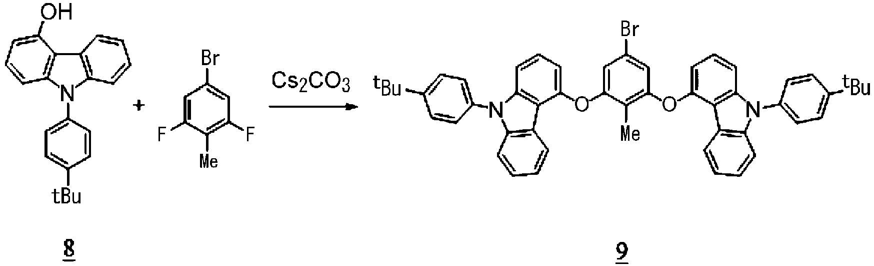

A mixture composed of 5-bromo-1,3-difluoro-2-methylbenzene, 9-(4-(t-butyl)phenyl)9H-carbazol-4-ol, Cs₂CO₃ and N-methyl-2-pyrrolidone (NMP) was reacted under nitrogen atmosphere to obtain a compound 9.

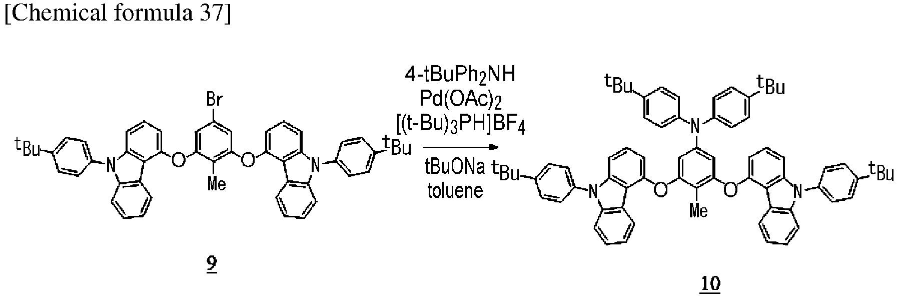

A mixture composed of the compound 9, bis(4-(tert-butyl)phenyl)amine, NaO(t-Bu), Pd(OAc)₂ and P(t-Bu)₃H·BF₄ was put in dried toluene to allow the reaction to proceed under nitrogen atmosphere, thereby obtaining a compound 10.

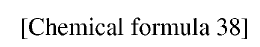

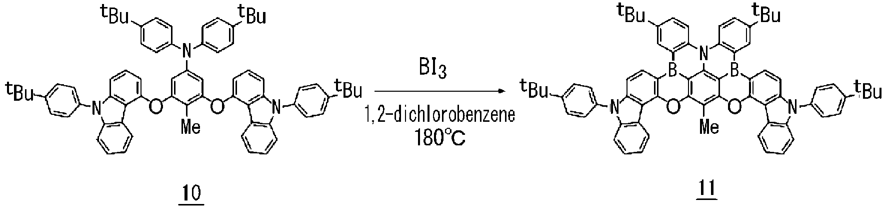

N,N-bis(4-(tert-butyl)phenyl)-3,5-bis((9-(4-(tert-butyl)phenyl)-9H-carbazol-4-yl)oxy)-4-methylaniline was dissolved in dried 1,2-dichlorobenzene, followed by adding BI₃ gradually thereto at room temperature to allow the reaction to proceed at room temperature under nitrogen atmosphere, thereby obtaining a compound 11 of formula (I-7).

Purification of the synthesized compound may be carried out by purification with column chromatography, adsorption purification using silica gel, activated carbon, activated clay or the like, or recrystallization or crystallization using a solvent. Identification of compounds may be carried out by NMR analysis or the like.

The light-emitting material according to the present invention makes it possible to provide a light-emitting element such as an organic photoluminescence element or an organic electroluminescence element. The boron-containing compound according to the present invention which is available in a light-emitting material assists the light-emission of another light-emitting material (host material), and therefore the compound may be doped with other light-emitting materials.

The organic photoluminescence element according to the present invention is formed by providing a luminescent layer containing a light-emitting material according to the present invention on a substrate. The luminescent layer may be formed by conducting a coating method such as spin coating, a printing method such as an ink-jet printing method, a vapor deposition method, or the like.

The organic electroluminescence element according to the present invention is formed by providing organic layers between an anode and a cathode. The term "organic layers" in the present invention refers to layers located between an anode and a cathode, the layers being substantially composed of organic substances, and the layers may include inorganic substances provided that the performance of the light-emitting element according to the present invention is not impaired.

The structure of one embodiment of an organic electroluminescence element according to the present invention is composed of a substrate, an anode, a hole injection layer, a hole transport layer, an electron-blocking layer, a luminescent layer, a hole-blocking layer, an electron-transporting layer, and a cathode, which are provided in this order, and an electron injection layer may be further provided between the electron-transporting layer and the cathode. In the multilayered structure, it is possible to omit some of the organic layers, and, for example, an anode, a hole transport layer, a luminescent layer, an electron-transporting layer, an electron injection layer, and a cathode may be provided on a substrate in this order, alternatively, or an anode, a hole transport layer, a luminescent layer, an electron-transporting layer, and a cathode may be provided on a substrate in this order. The light-emitting material according to the present invention may be doped not only in a light-luminescent layer, but also in a hole injection layer, a hole transport layer, an electron-blocking layer, a hole-blocking layer, an electron-transporting layer, or an electron injection layer.

The substrate is to be a support of the light-emitting element, and a silicon plate, a quartz plate, a glass plate, a metal plate, a metal foil, a resin film, or a resin sheet is used. In particular, a glass plate, or a transparent plate of synthetic resin such as polyester, polymethacrylate, polycarbonate, or polysulfone is preferred. In the case where a synthetic resin substrate is used, it is necessary to pay attention to the gas barrier property. In the case where the gas barrier property of the substrate is too low, the light-emitting element may be deteriorated by the outside air passing through the substrate. Therefore, it is preferable to ensure the gas barrier properties on either one or both sides of the synthetic resin substrate provided with a dense silicon oxide film or the like.

An anode is provided on the substrate. A material having a high work function is generally used to form the anode. Examples of the anode material include: metals such as aluminum, gold, silver, nickel, palladium, and platinum; metal oxides such as indium oxide, tin oxide, ITO, zinc oxide, In2O3-ZnO, and IGZO; metal halides such as copper iodide, carbon black, and conductive polymers such as poly (3-methylthiophene), polypyrrole, and polyaniline. The anode is usually formed using a sputtering method, or a vacuum deposition method. In the case of fine particles of metal such as silver, fine particles of copper iodide, carbon black, conductive metal oxide fine particles or conductive polymer fine powders, the fine particles are dispersed in a suitable binder resin solution, and then applied on a substrate to form an anode. Furthermore, in the case of the conductive polymer, the conductive polymer may be subjected to electrolytic polymerization to form a thin film directly on a substrate, or may be applied on a substrate to form an anode.

The anode may also be formed by laminating at least two substances different from each other. The thickness of the anode varies depending on the required transparency. In the case where transparency is required, the transmittance of visible light is usually at least 60%, and preferably at least 80%. In this case, the thickness is usually from 10 to 1000 nm, and preferably from 10 to 200 nm. In the case where the anode may be opaque, the thickness of the anode may be approximately the same as that of the substrate. It is preferable that the sheet resistance of the anode be at least several hundred Ω/square.

In a hole injection layer which is provided as needed, a porphyrin compound such as copper phthalocyanine, a naphthalene diamine derivative, a star-burst type triphenylamine derivative, a trimer or a tetramer of triphenylamin such as an arylamine compound having a structure in which at least three triphenylamin structures are bonded with single bonds or divalent groups free from hetero atoms in a molecule thereof, an acceptor heterocyclic compound such as hexacyano azatriphenylene or a coating type polymer material may be used. These materials may be subjected to deposition or a known method such as a spin coating method or an inkjet method to form a thin film.

It is preferable that the hole transport material used in the hole transport layer provided as needed exhibit a high hole injection efficiency from an anode and realize transportation of the injected holes efficiently. For this purpose, a small ionization potential, high transparency to visible light, high hole mobility, excellent stability, and suppressed generation of impurities which become traps during manufacture or use are preferable. Besides the aforementioned general requirements, when application to a vehicle display is intended, it is further preferable that the heat resistance of the element be high. Therefore, a material having a value of 70°C or more as Tg is desirable.

In the hole transport layer which is provided as needed, a triazole derivative, an oxadiazole derivative, an imidazole derivative, a carbazole derivative, an indolocarbazole derivative, a polyarylalkane derivative, a pyrazoline derivative, a pyrazolone derivative, a phenylenediamine derivative, an arylamine derivative, an amino-substituted chalcone derivative, an oxazole derivative, a styryl anthracene derivative, a fluorenone derivative, a hydrazone derivative, a stilbene derivative, a silazane derivative, an aniline copolymer, an electroconductive high-molecular oligomer or the like may be used. More specifically, a compound having a m-carbazolylphenyl group, a benzidine derivative such as N, N'-diphenyl-N, N'-di(m-tolyl)-benzidine (hereinafter abbreviated as TPD), N, N'-diphenyl-N, N'-di(α-naphthyl)-benzidine (hereinafter abbreviated as NPD), N, N, N', N'-tetrabiphenylbenzidine, or 1,1-bis[(di-4-tolylamino)phenyl]cyclohexane (hereinafter abbreviated as TAPC), various triphenylamine trimers or tetramers, or a carbazole derivative may be used. One kind of these may be used, or at least two kinds thereof may be used in combination. The hole transport layer may be a film of a single layer structure, or may be a film of a laminated structure. Further, in the hole injection or transport layer, a coating type polymer material such as poly(3,4-ethylenedioxythiophene) (hereinafter abbreviated as PEDOT) / poly(styrenesulfonate) (hereinafter, abbreviated as PSS) may be used. These materials may be subjected to deposition or another known method such as a spin coating method or an inkjet method to form a thin film.

In the hole injection layer or the hole transport layer, materials in which tris-bromophenyl amine hexachloro antimony is P-doped to materials commonly used in the layer, or polymer compounds having the structure of the PD as the partial structure thereof may be used. As the hole injection or transport host material, a carbazole derivative such as CBP, TCTA, mCP, or the like may be used.

Compounds (hi1) to (hi7) which may be preferably used as hole injection materials are shown below.

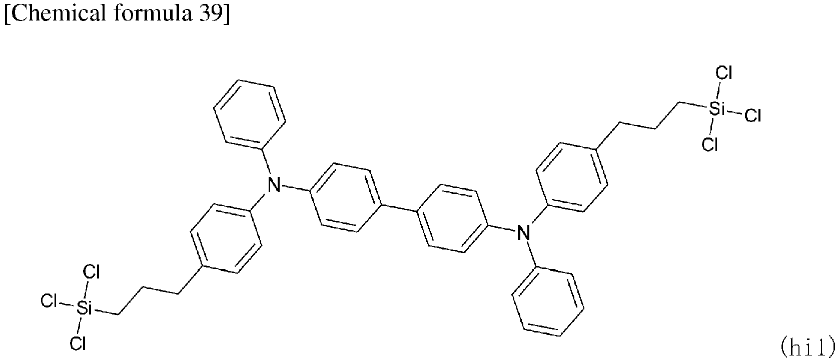

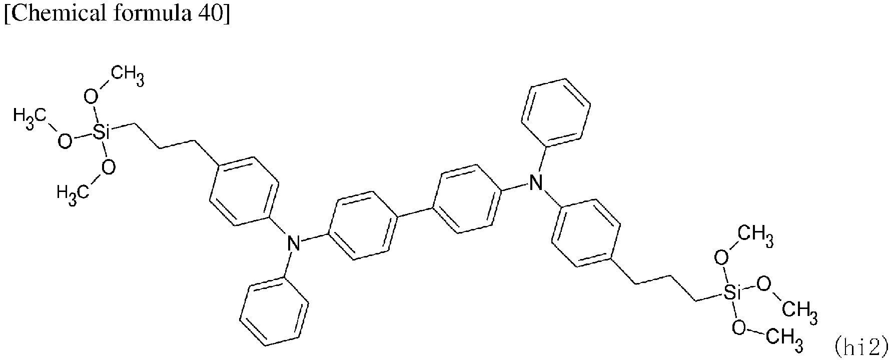

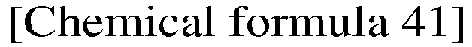

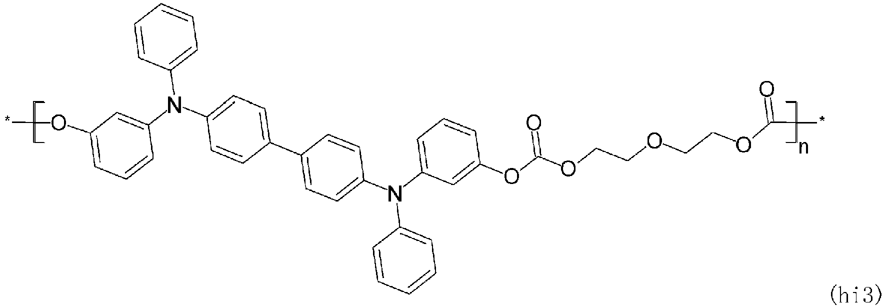

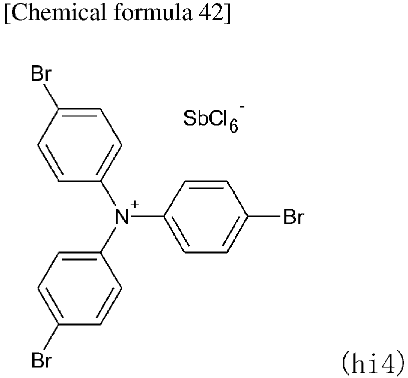

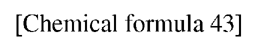

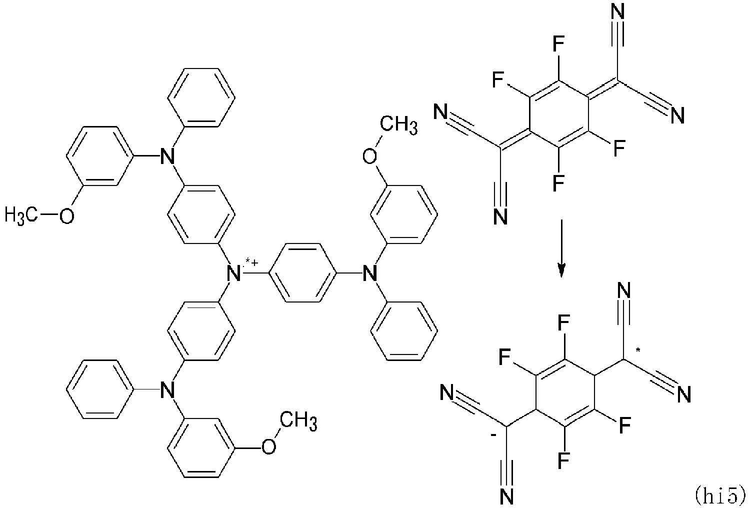

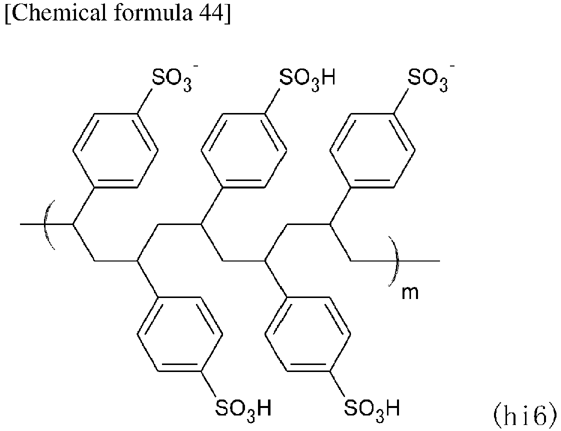

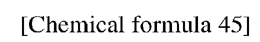

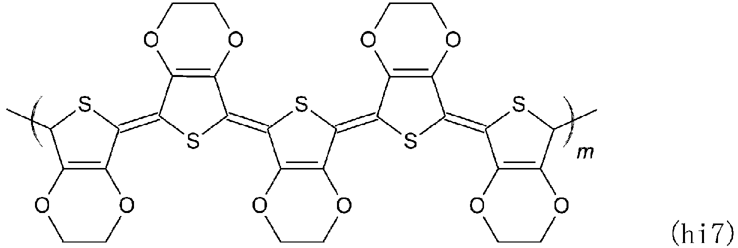

Compounds (ht1) to (ht38) which may be preferably used as hole transport materials are shown below.

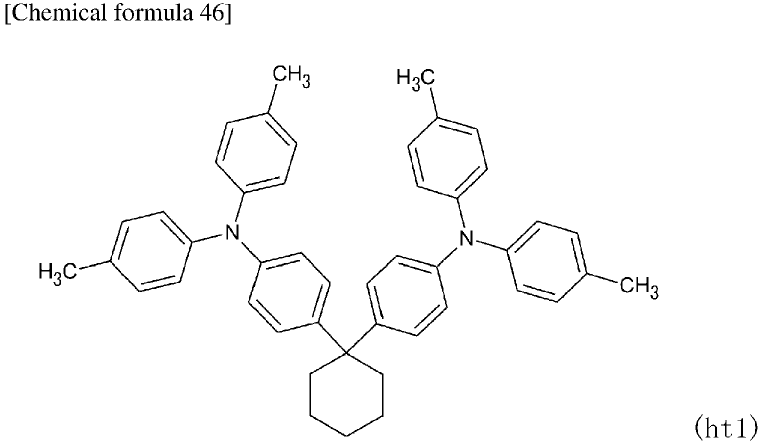

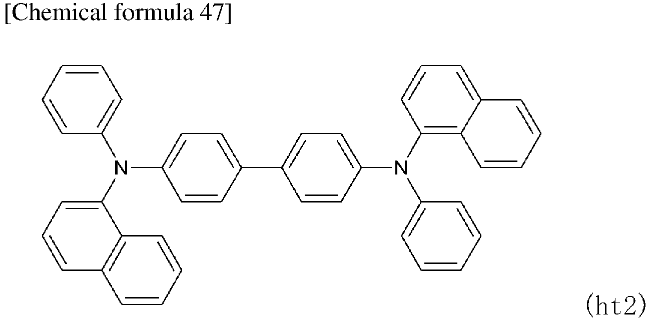

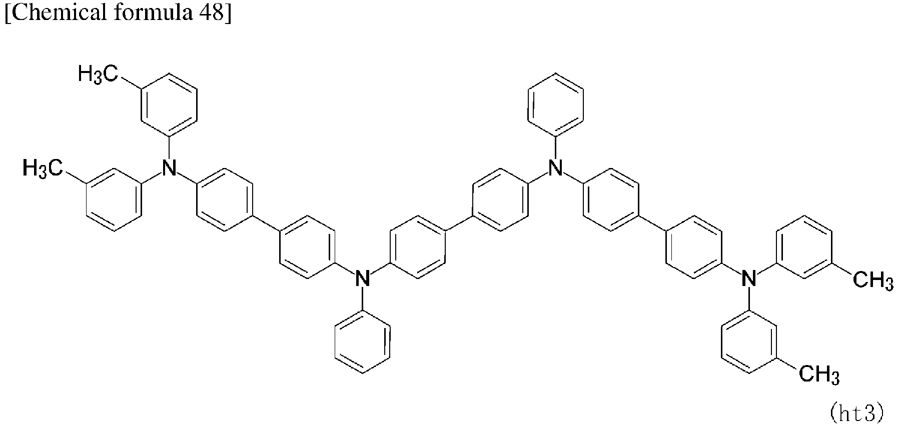

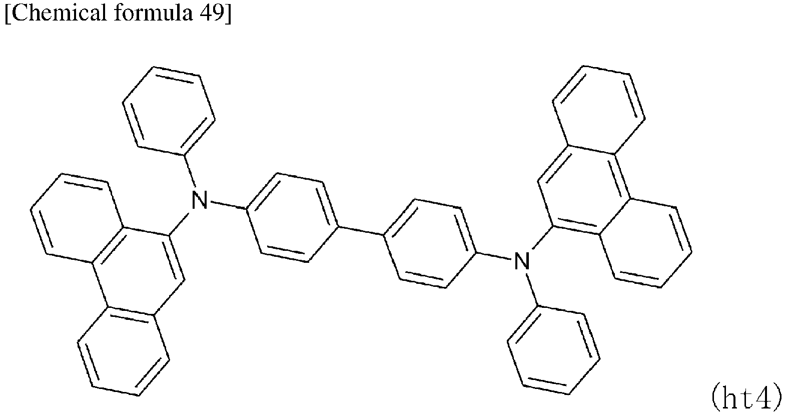

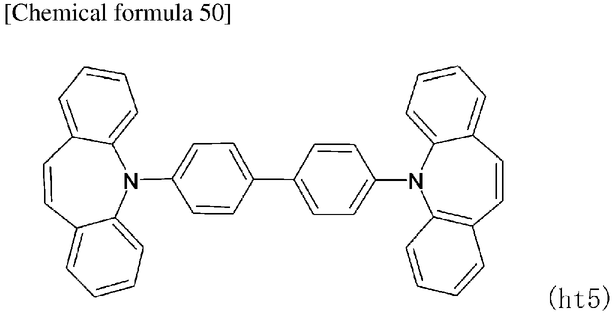

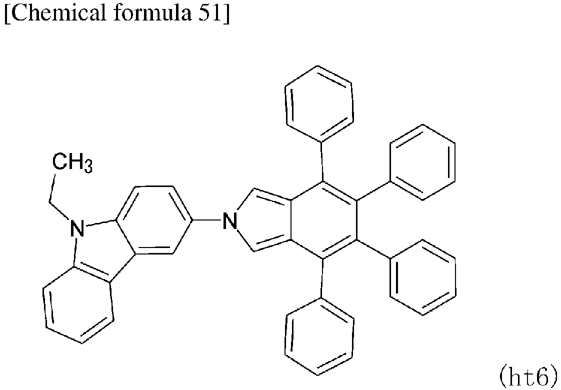

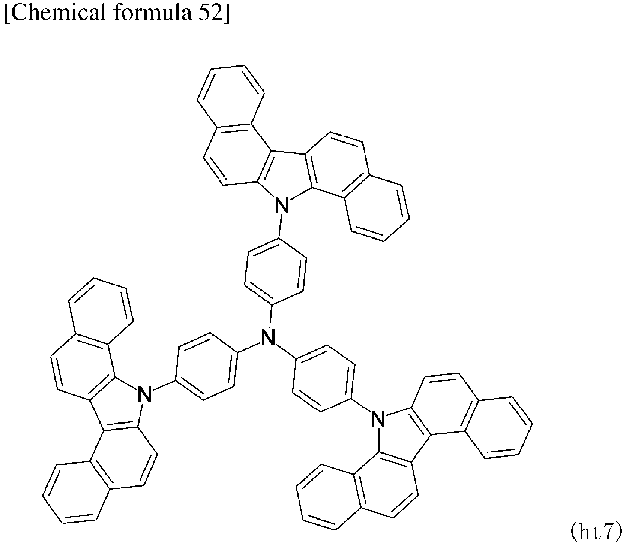

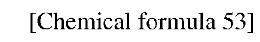

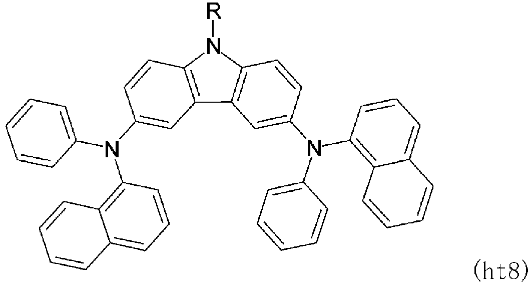

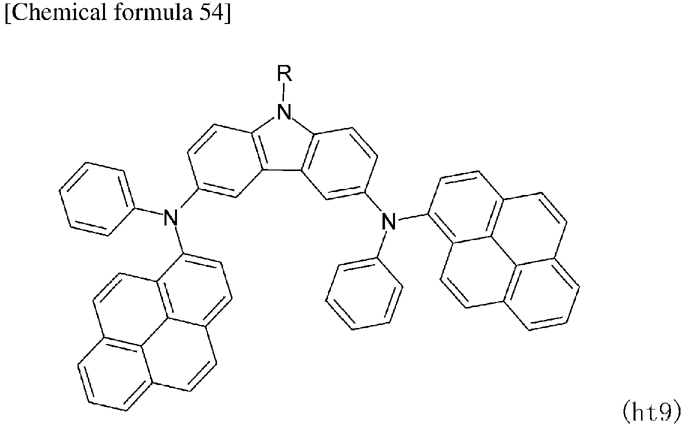

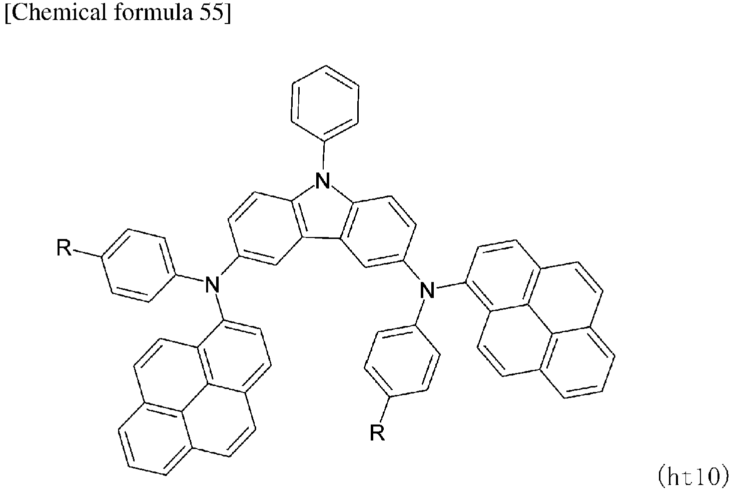

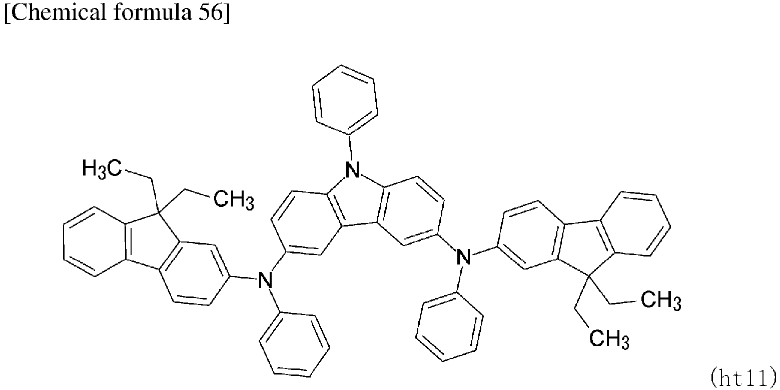

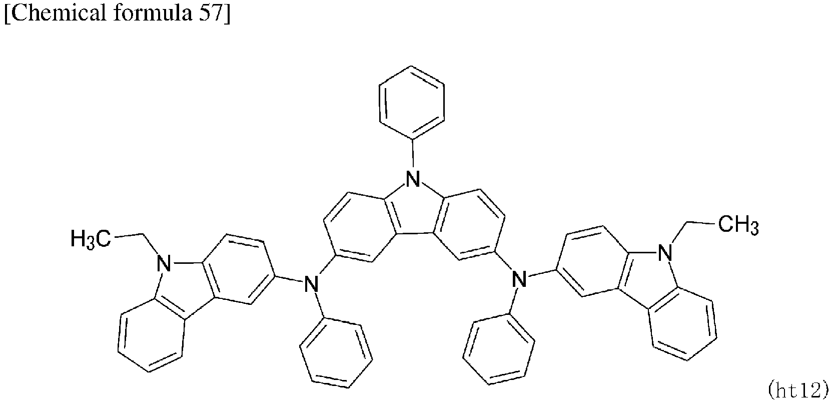

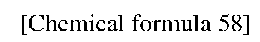

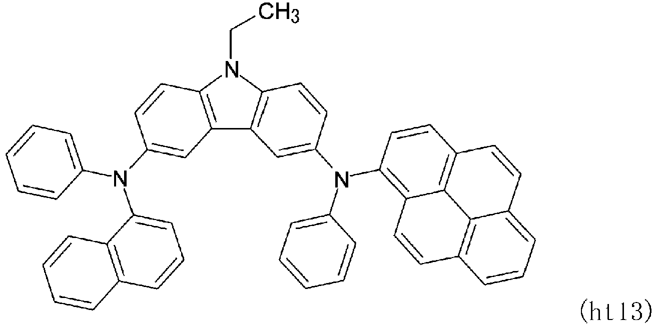

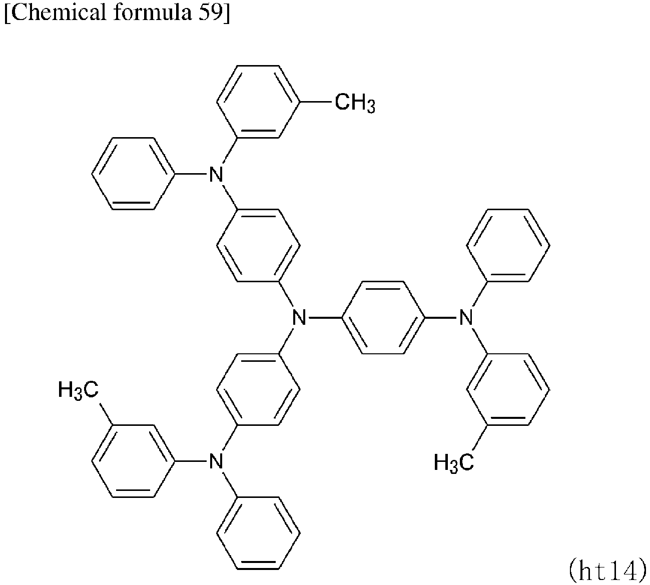

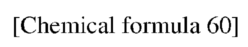

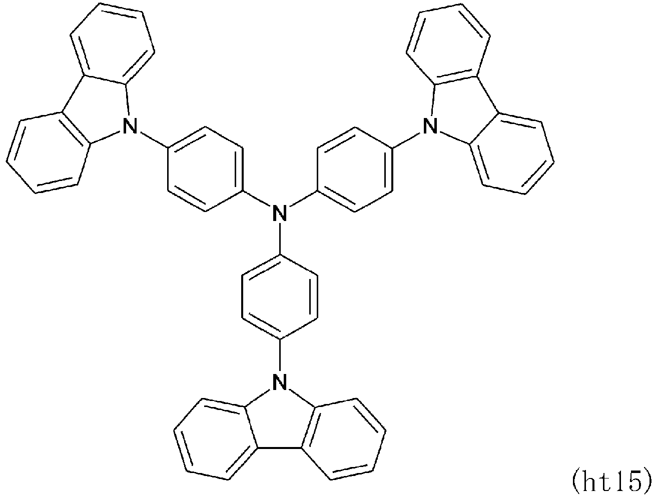

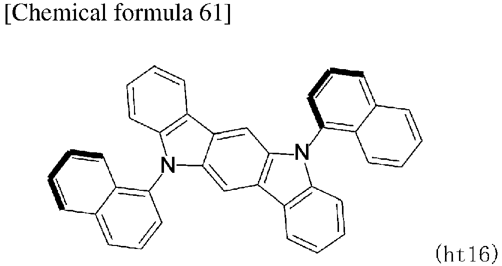

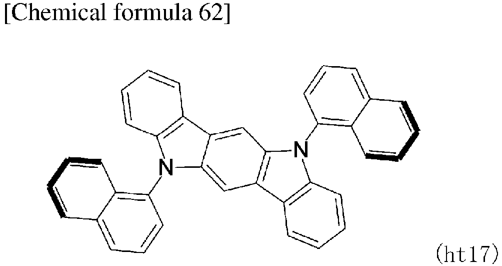

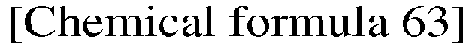

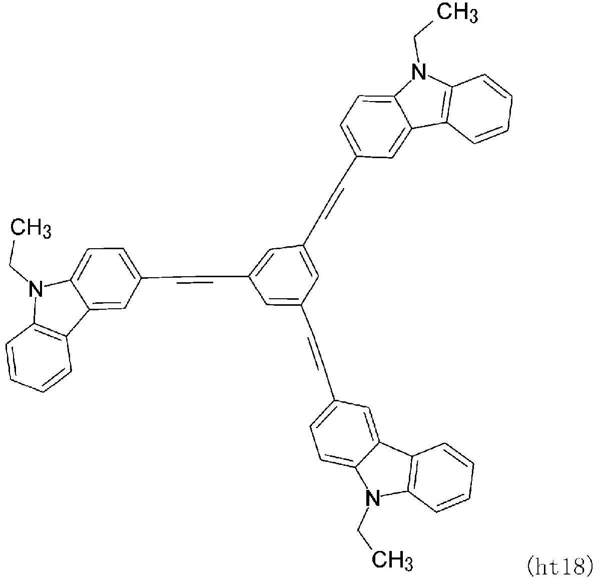

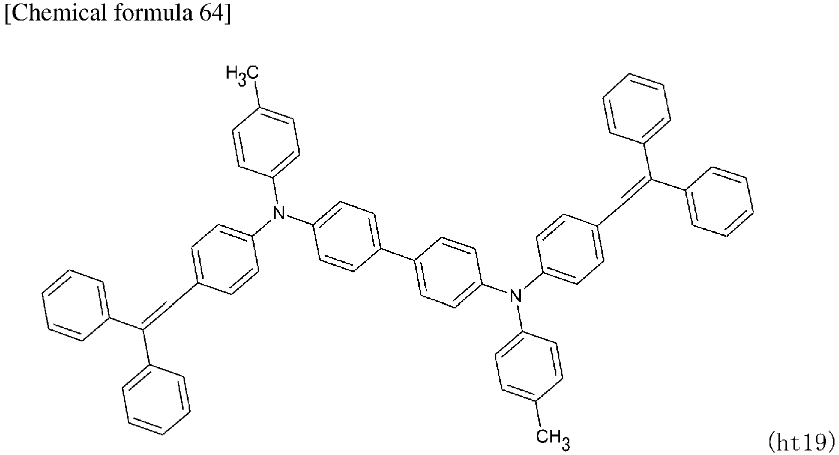

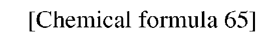

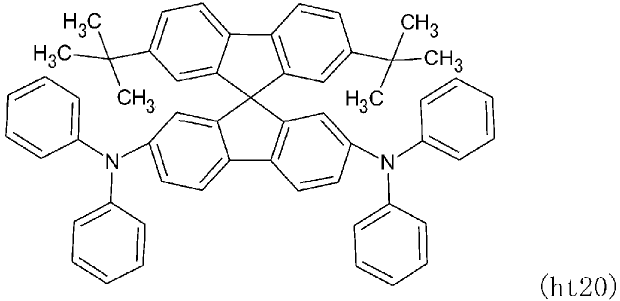

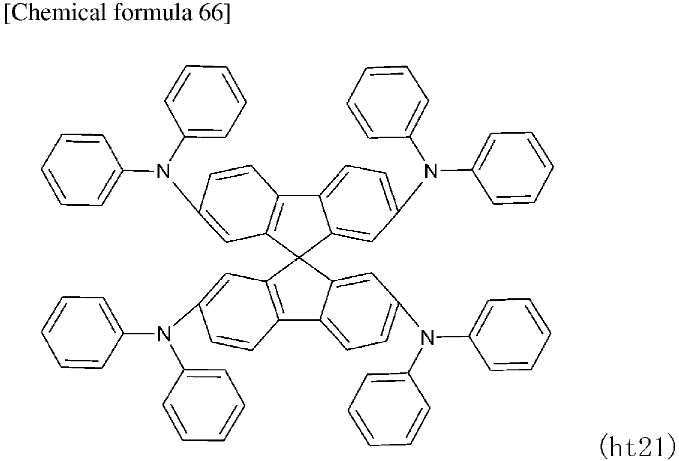

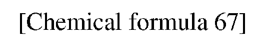

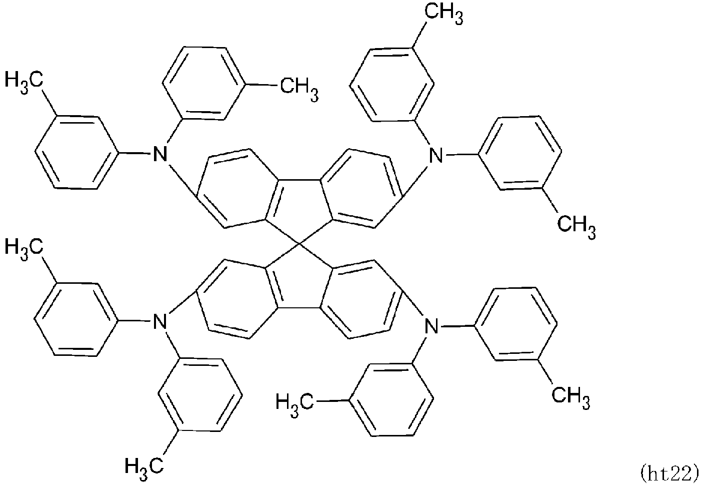

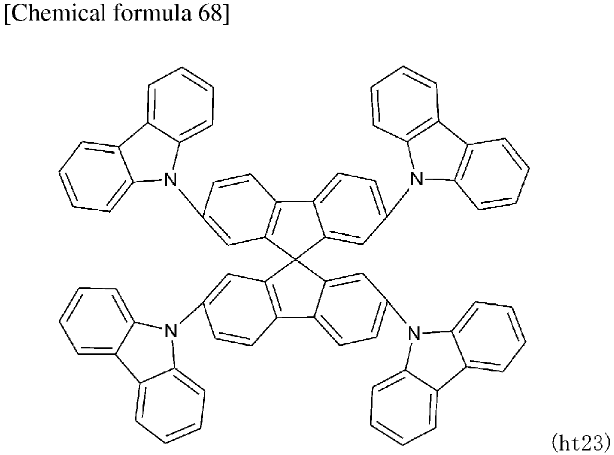

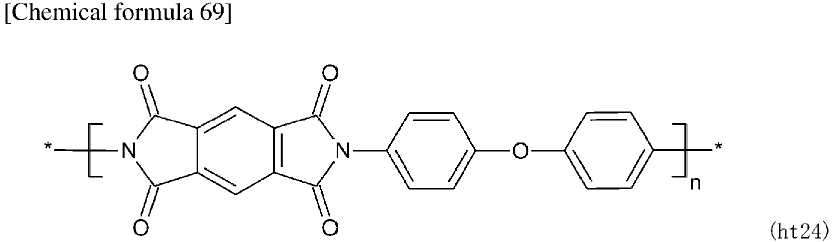

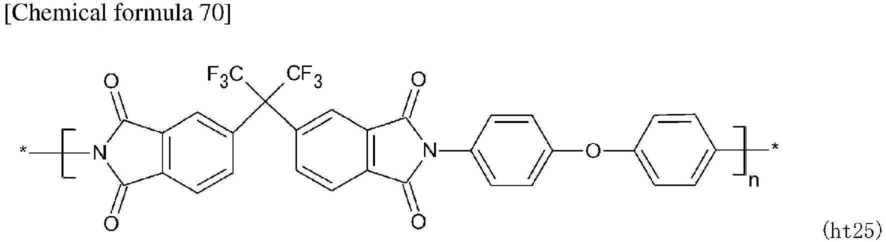

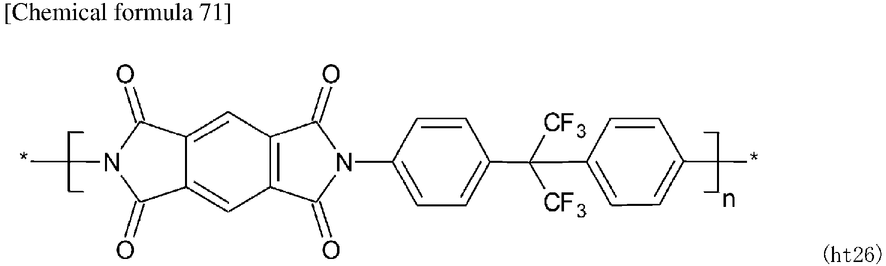

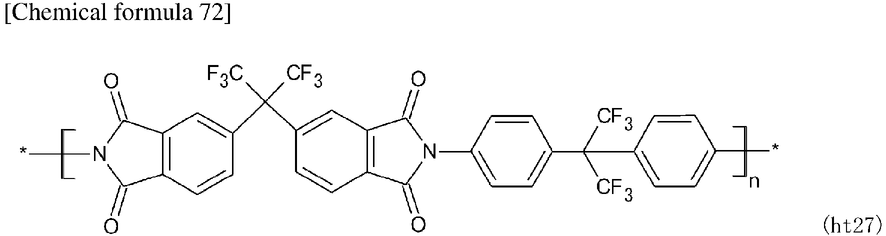

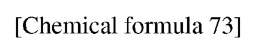

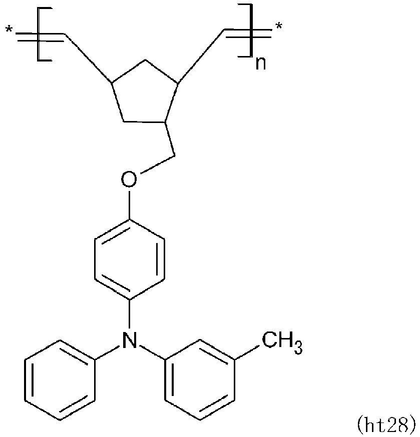

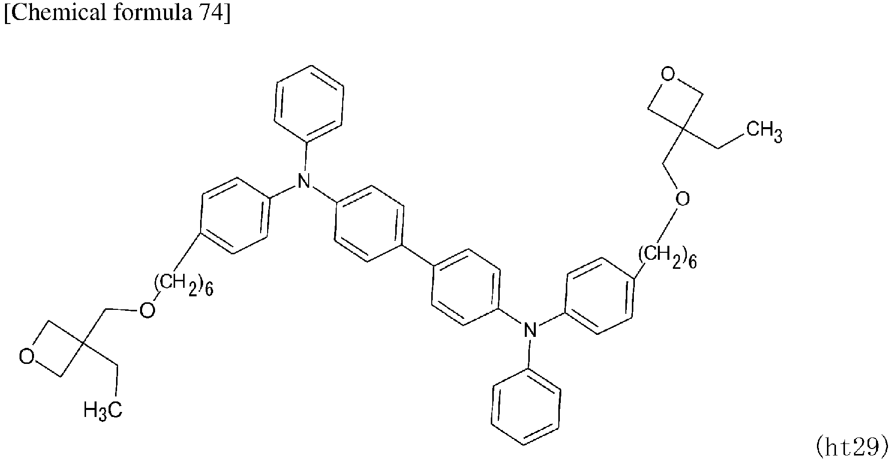

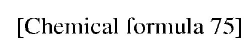

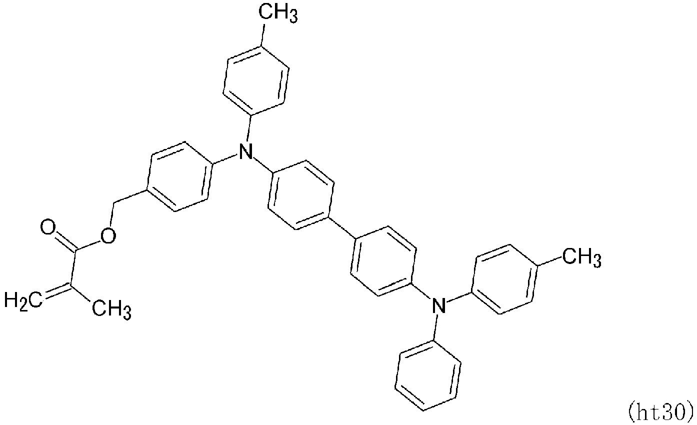

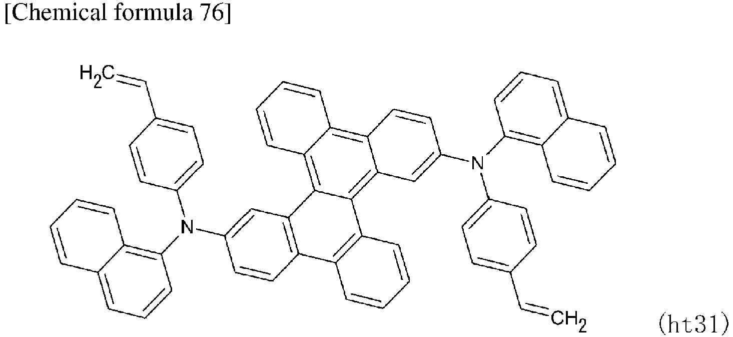

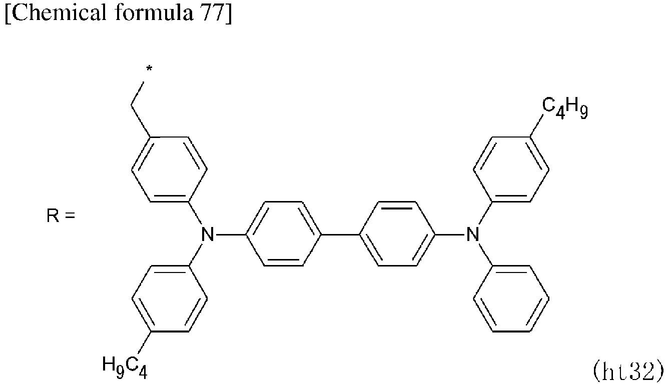

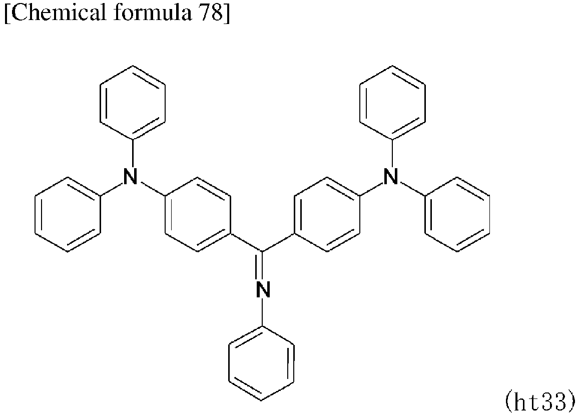

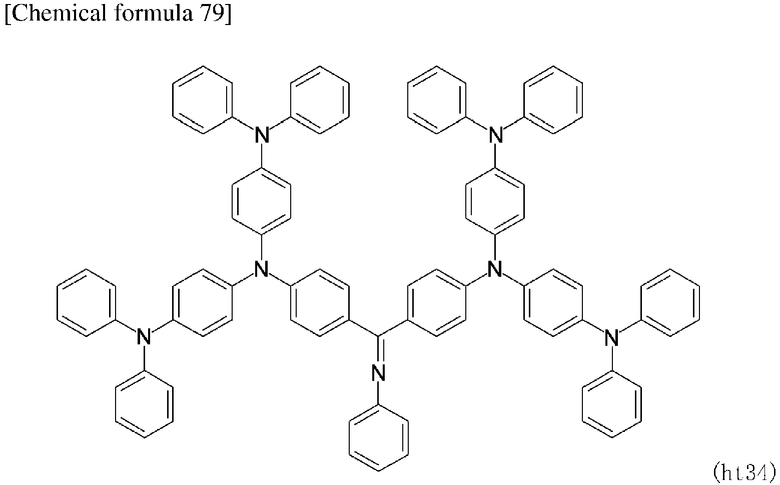

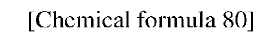

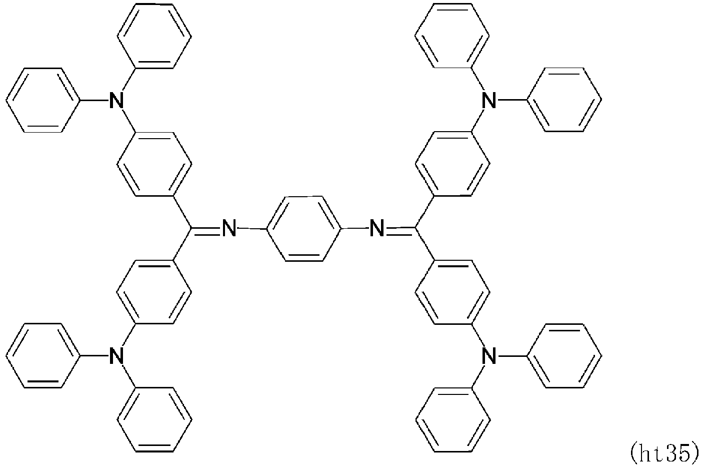

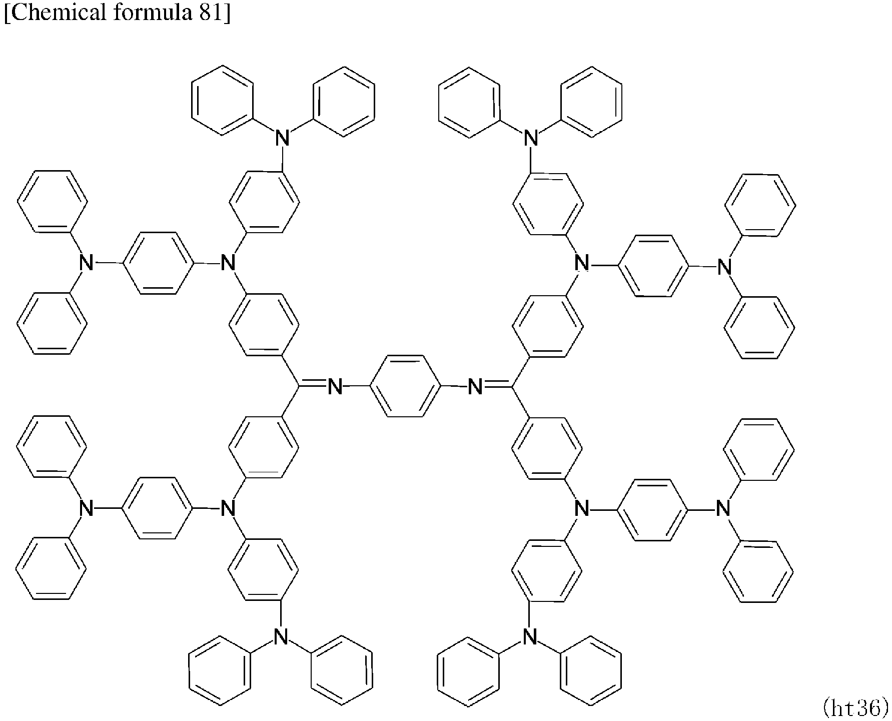

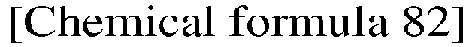

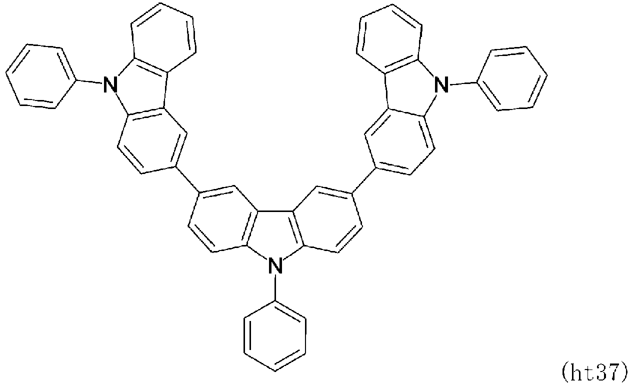

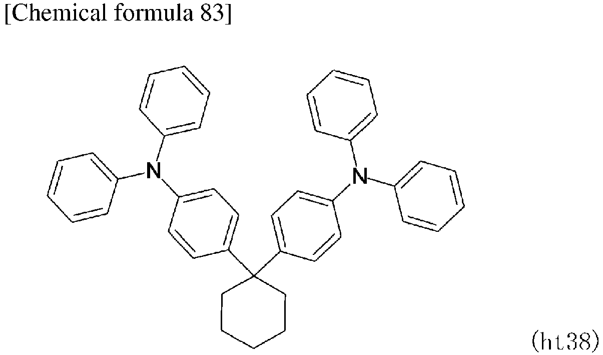

In an electron-blocking layer which is provided as needed, a compound having an electron blocking action, such as a carbazole derivative such as 4,4',4"-tri(N-carbazolyl) triphenylamine (hereinafter abbreviated as TCTA), 9,9-bis[4-(carbazol-9-yl) phenyl] fluorene, 1,3-bis(carbazol-9-yl) benzene (hereinafter abbreviated as mCP), 1,3-bis(1,8-dimethylcarbazol-9-yl) benzene (hereinafter abbreviated as mMCP), or 2,2-bis(4-carbazol-9-yl-phenyl) adamantane (hereinafter, abbreviated as Ad-Cz), or a compound having a triphenylsilyl group and a triarylamine structure, such as 9-[4-(carbazol-9-yl) phenyl]-9-[4- (triphenylsilyl) phenyl]-9H-fluorene may be used. One of the materials may be used alone or at least two thereof may be used in combination. The electron-blocking layer may be a film having a single layer structure, or may be a film having a laminated structure. The materials may be subjected to deposition or another known method such as a spin coating method or an inkjet method to form a thin film.

Compounds (es1) to (es5) which may be preferably used as electron-blocking materials are shown below.

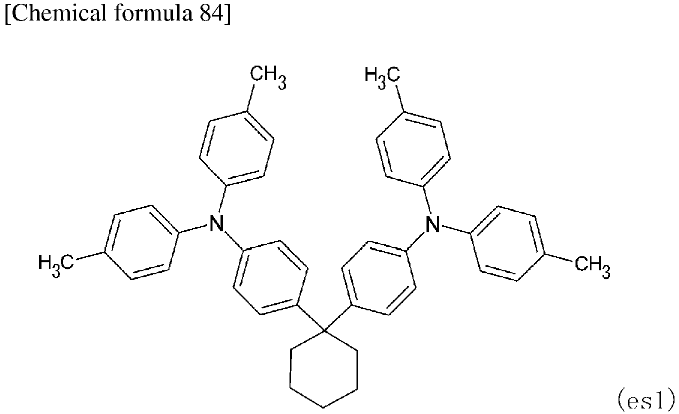

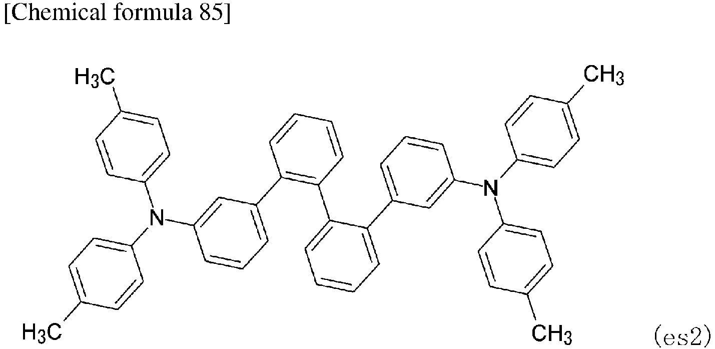

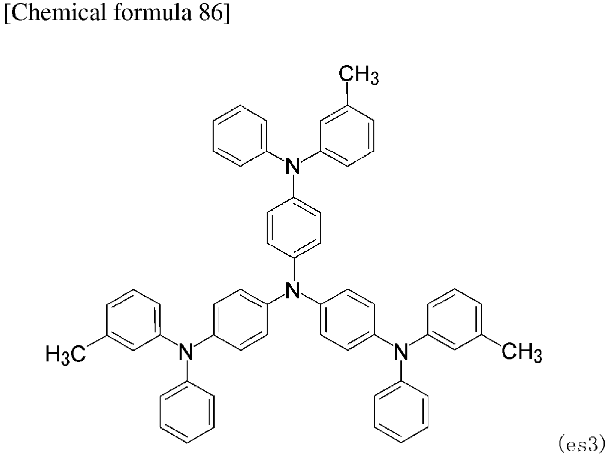

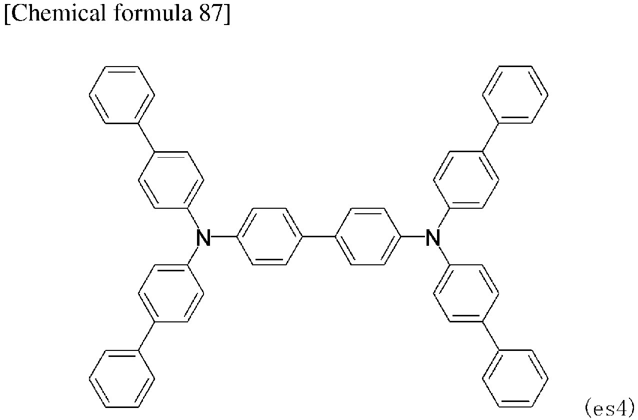

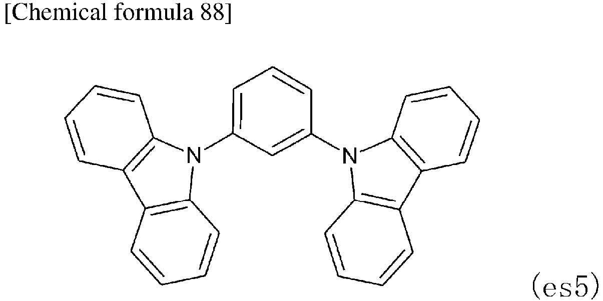

A luminescent layer is a layer configured to exhibit light-emission by generating excitons due to recombination of holes and electrons respectively injected from an anode or a cathode. The luminescent layer may be formed using a light-emitting material according to the present invention alone, or may be formed by doping the light-emitting material according to the present invention to a host material. Examples of the host material include: metal complexes of quinolinol derivatives such as tris (8-hydroxyquinoline) aluminum (hereinafter abbreviated as Alq3); anthracene derivatives, bisstyrylbenzene derivatives, pyrene derivatives, oxazole derivatives, polyparaphenylene vinylene derivatives, compounds having a bipyridyl group and an ortho-terphenyl structure, 1,3-bis(carbazol-9-yl) benzene (hereinafter abbreviated as mCP), 3,3'-di(9H-carbazol-9-yl)-1,1'-biphenyl (hereinafter abbreviated as mMCBP), thiazole derivatives, benzimidazole derivatives, and polydialkylfluorene derivatives. The luminescent layer may contain a known dopant. Examples of the dopant include quinacridone, coumarin, rubrene, anthracene, perylene and derivatives thereof, benzopyran derivatives, rhodamine derivatives, and aminostyryl derivatives. A phosphorescent material such as a green phosphorescent material such as Ir(ppy)3, a blue phosphorescent material such as FIrpic, or Flr6, or a red phosphorescent material such as Btp2Ir (acac) may also be used. One of the materials may be used alone, or at least two thereof may be used in combination. The luminescent layer may be a film of a single layer structure, or may be a film of a laminated structure. The materials may be subjected to deposition or another known method such as a spin coating method or an inkjet method to form a thin-film.

In the case where a host material is used, the lower limit of the amount of the light-emitting material according to the present invention which may be contained in the luminescent layer is preferably 0.1% by mass and more preferably 1% by mass, and the upper limit thereof is preferably 50% by mass, more preferably 20% by mass, and even more preferably 10% by mass.

Compounds (el1) to (el40) which may be preferably used as host materials in the luminescent layer are shown below.

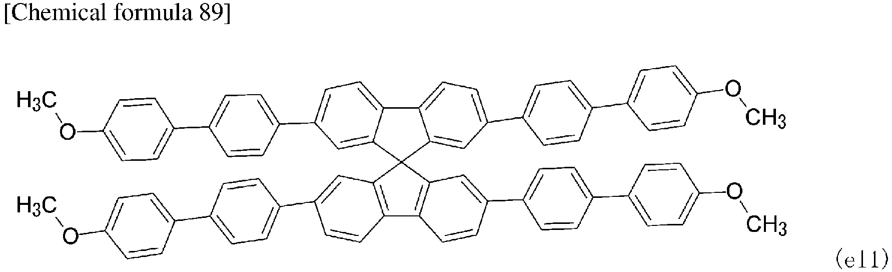

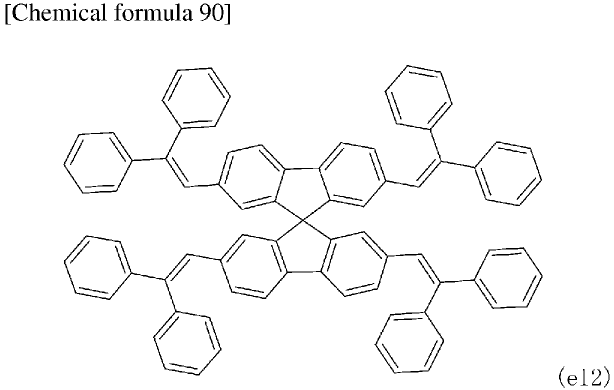

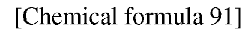

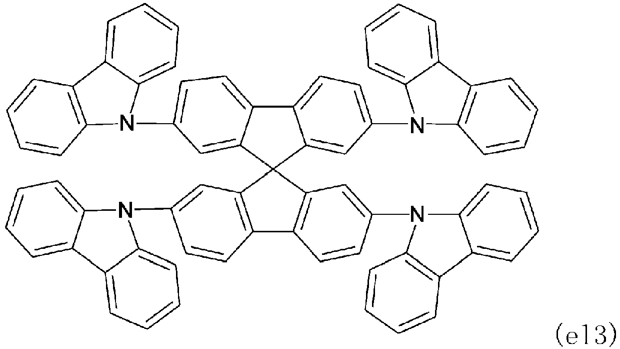

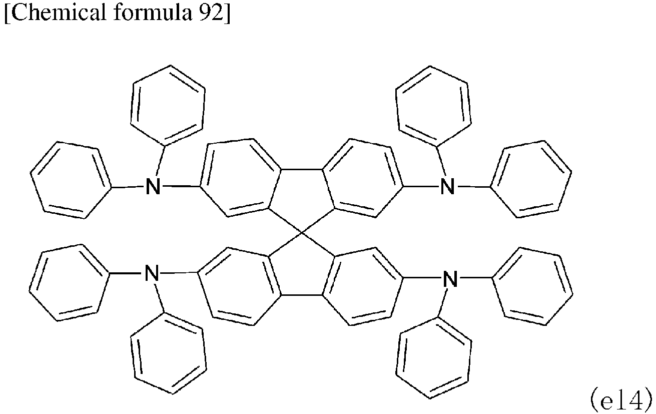

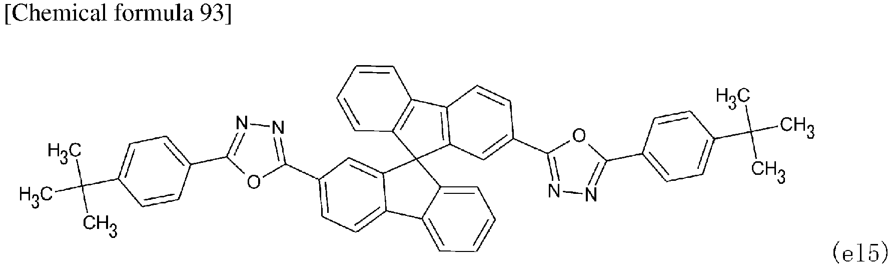

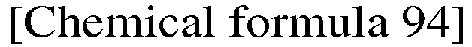

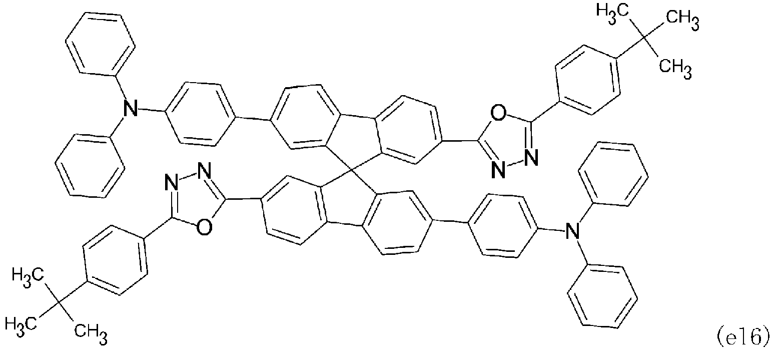

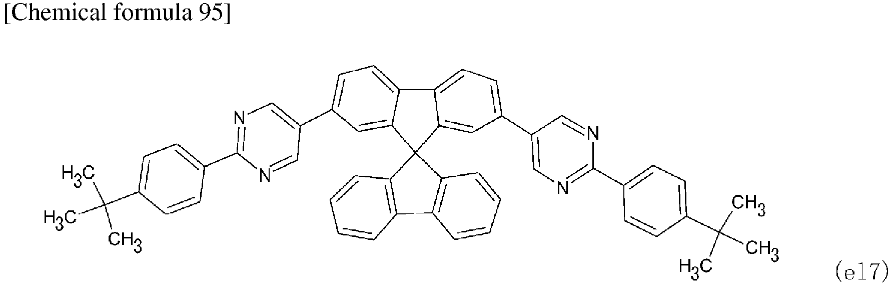

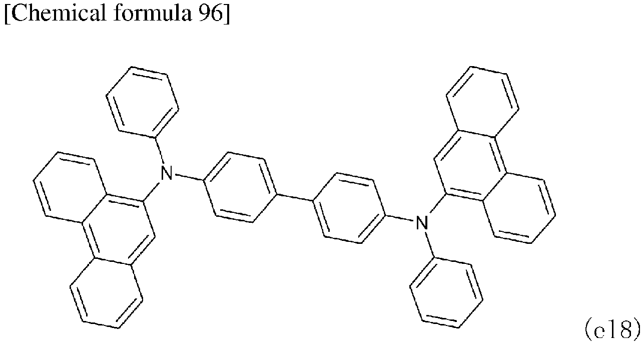

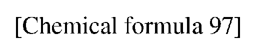

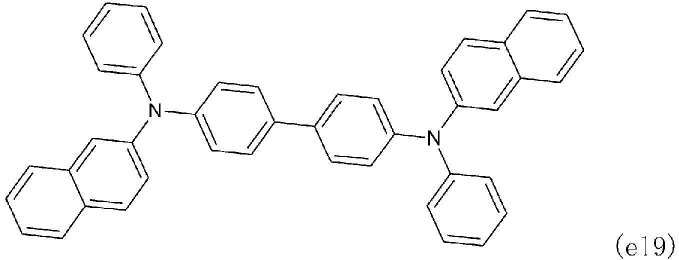

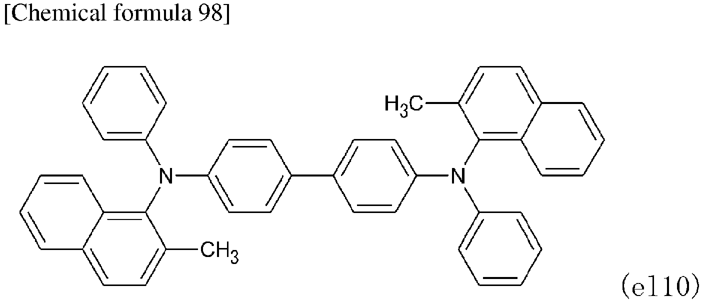

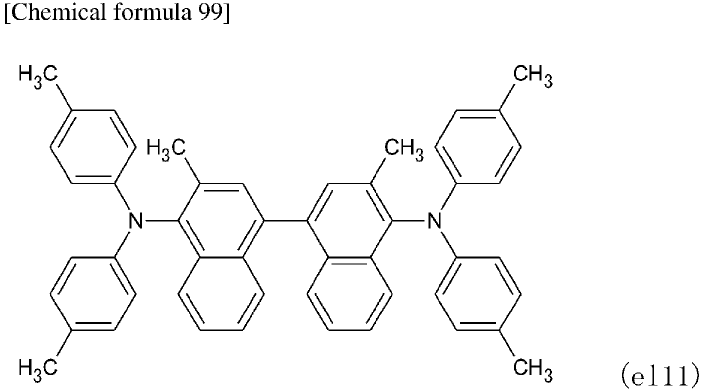

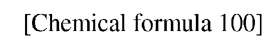

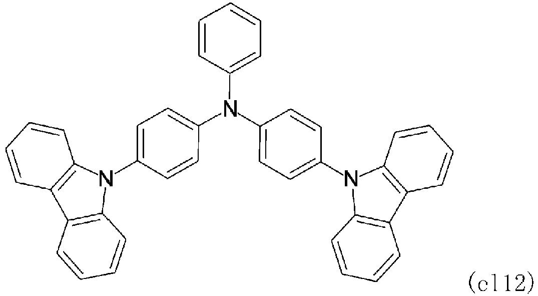

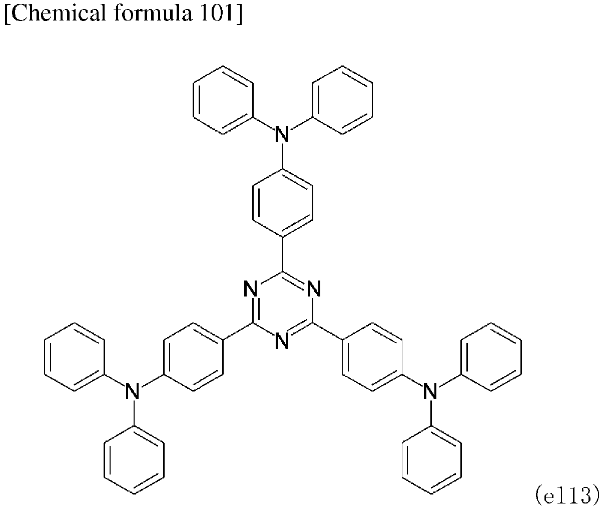

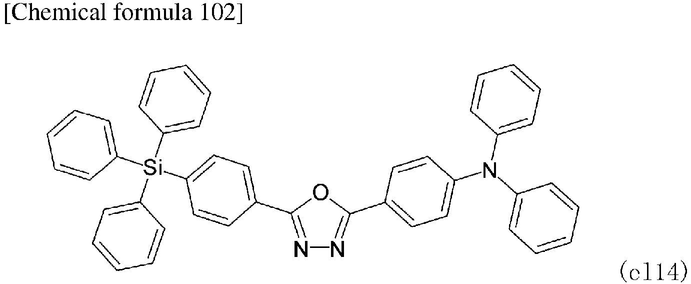

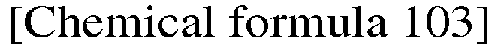

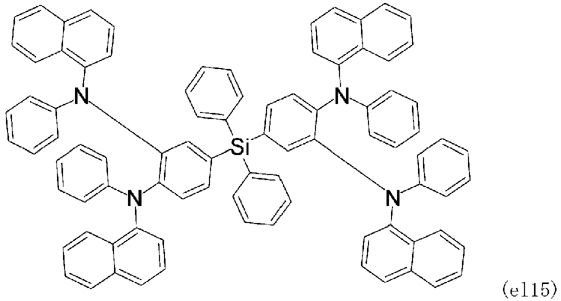

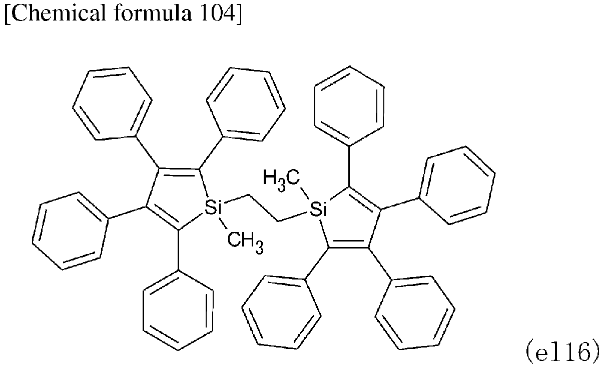

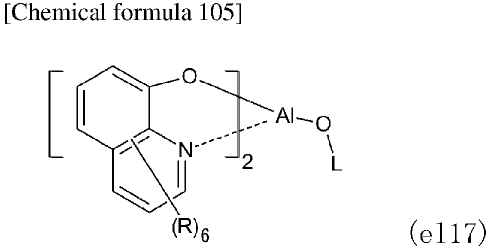

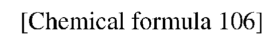

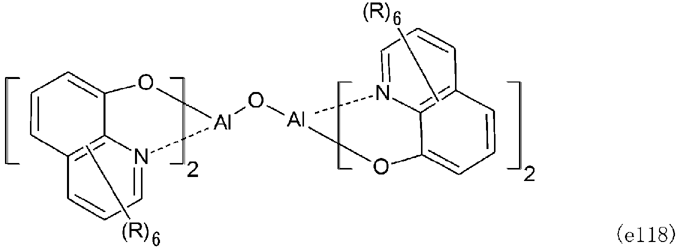

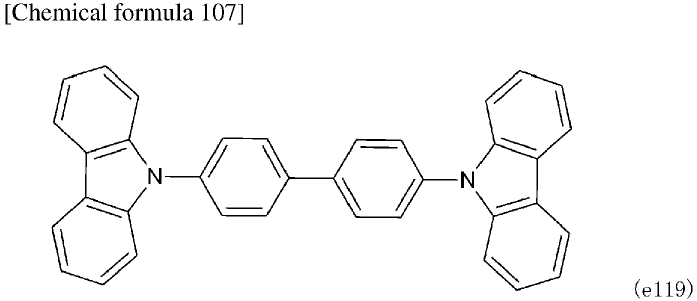

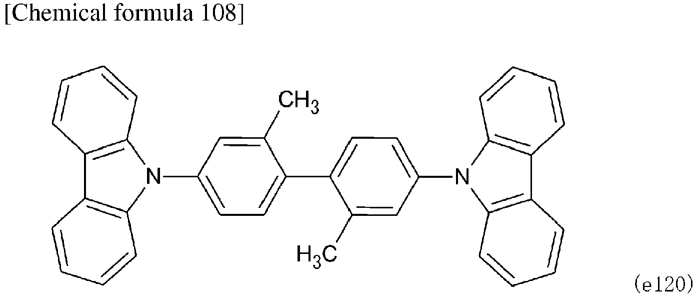

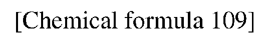

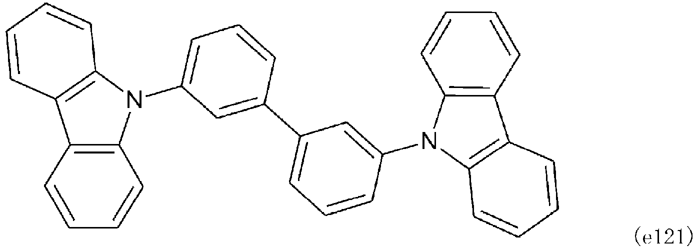

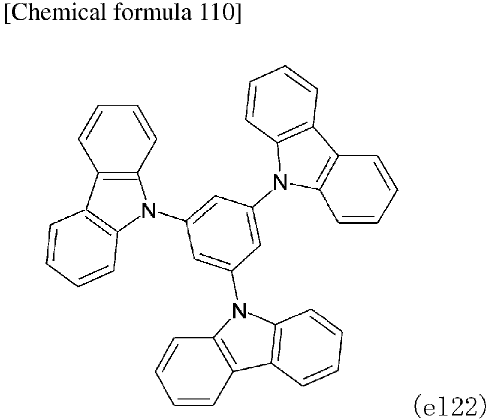

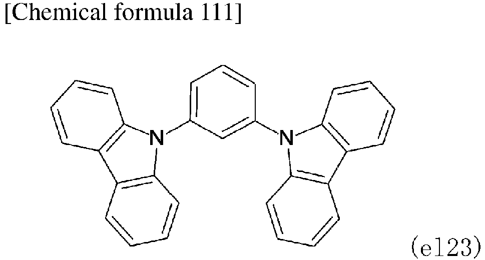

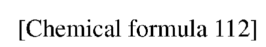

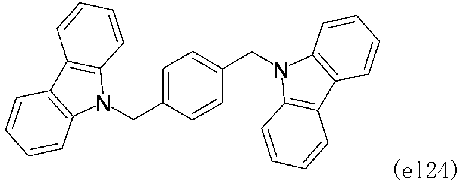

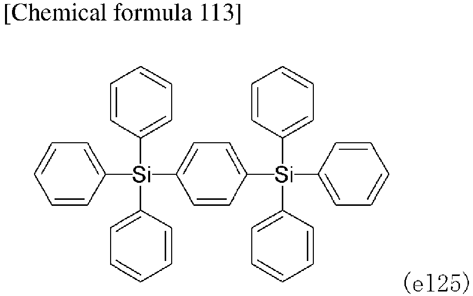

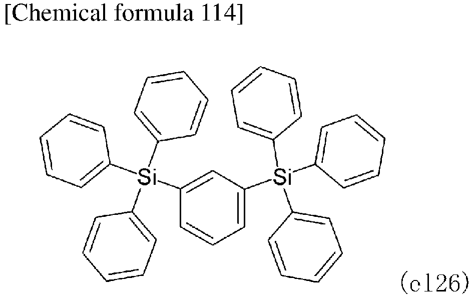

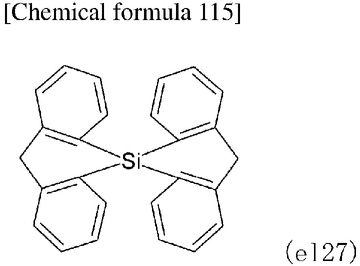

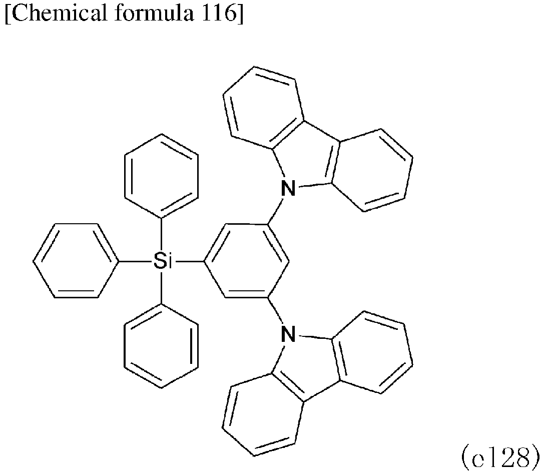

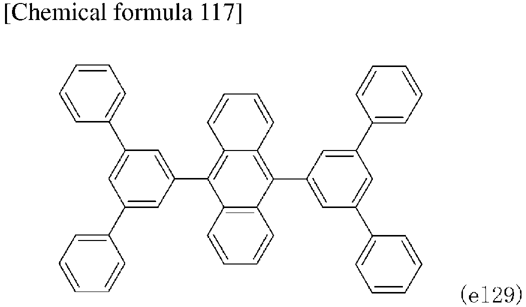

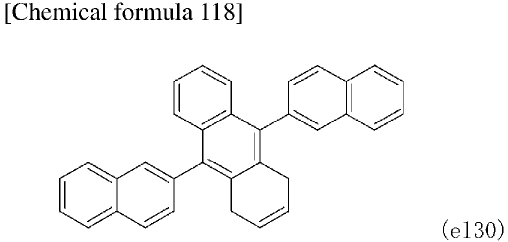

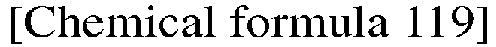

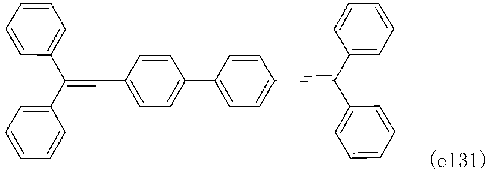

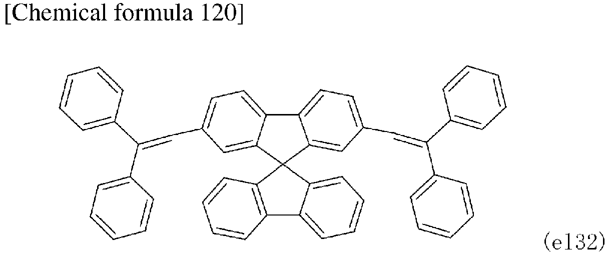

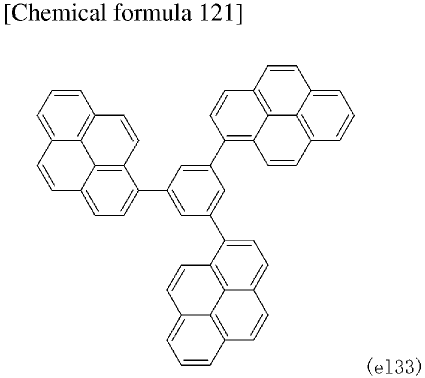

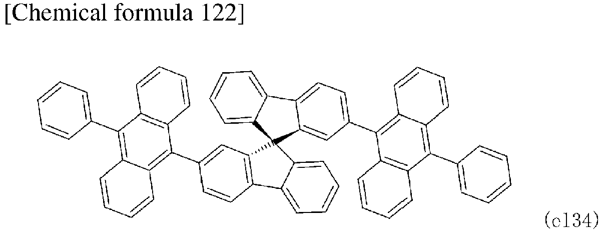

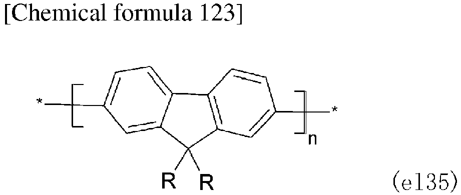

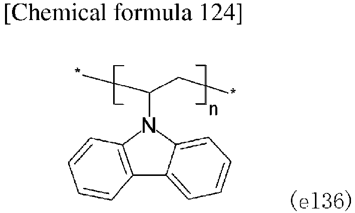

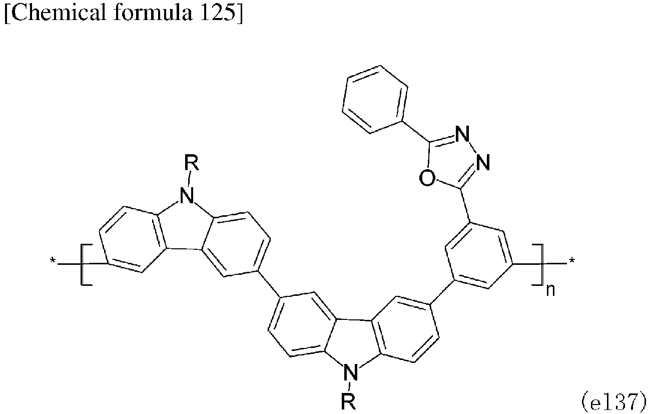

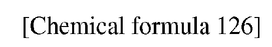

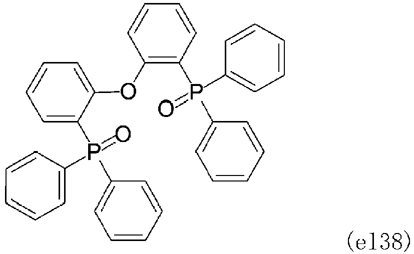

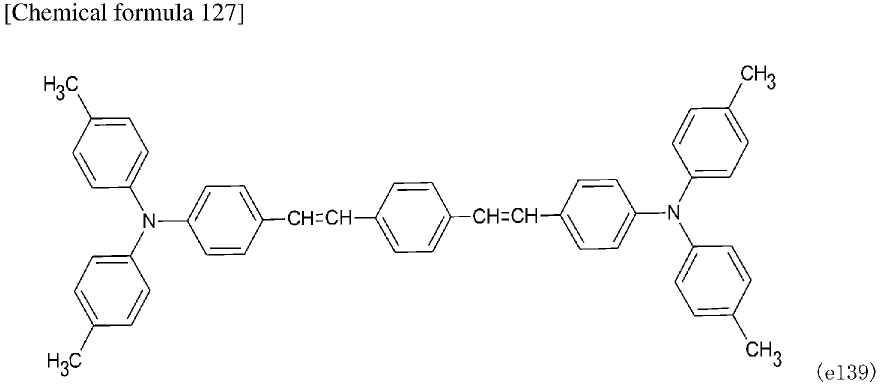

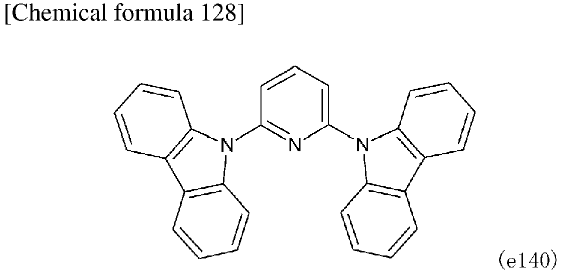

In a hole-blocking layer which is provided as needed, a compound having a hole-blocking action, such as a compound having both a bipyridyl group and an ortho-terphenyl structure, a phenanthroline derivative such as bathocuproine (hereinafter abbreviated as BCP), a metal complex of a quinolinol derivative such as aluminum (III) bis (2-methyl-8 quinolinate)-4-phenylphenolate (hereinafter, abbreviated as BAlq), various rare earth complexes, an oxazole derivative, a triazole derivative, or a triazine derivative may be used. These materials may also serve as materials of the electron-transporting layer. One of the materials may be used alone, or at least two thereof may be used in combination. The hole-blocking layer may be a film of a single layer structure, or may be a film of a laminated structure. The materials may be subjected to deposition or another known method such as a spin coating method or an inkjet method to form a thin-film.

Compounds (hs1) to (hs11) which may be preferably used as hole-blocking materials are shown below.

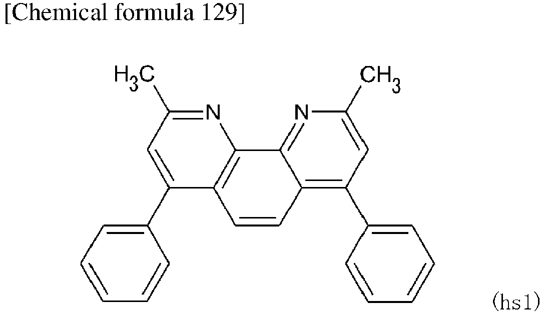

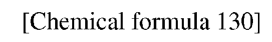

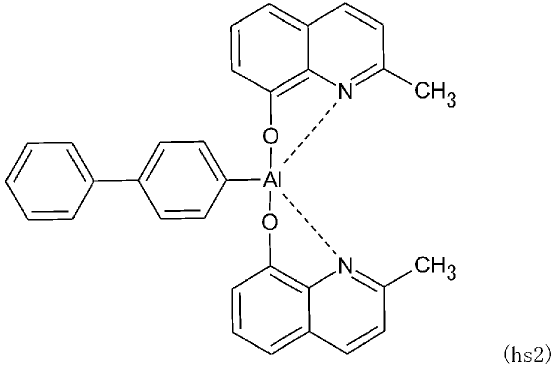

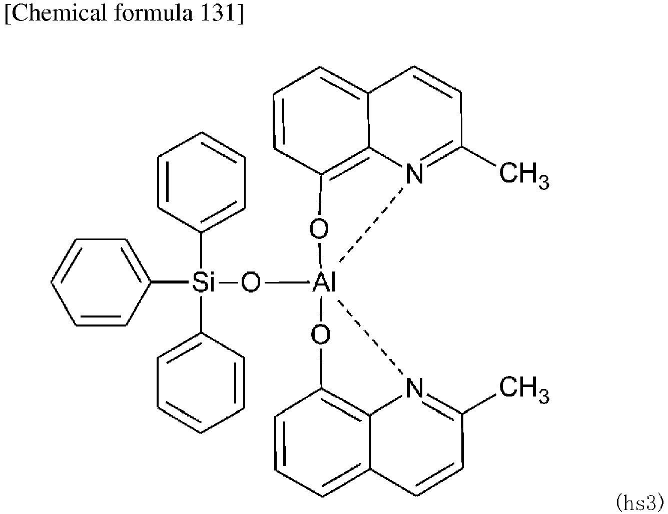

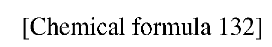

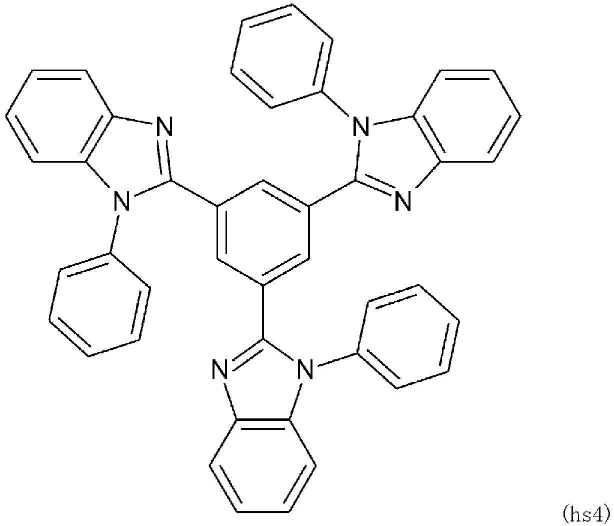

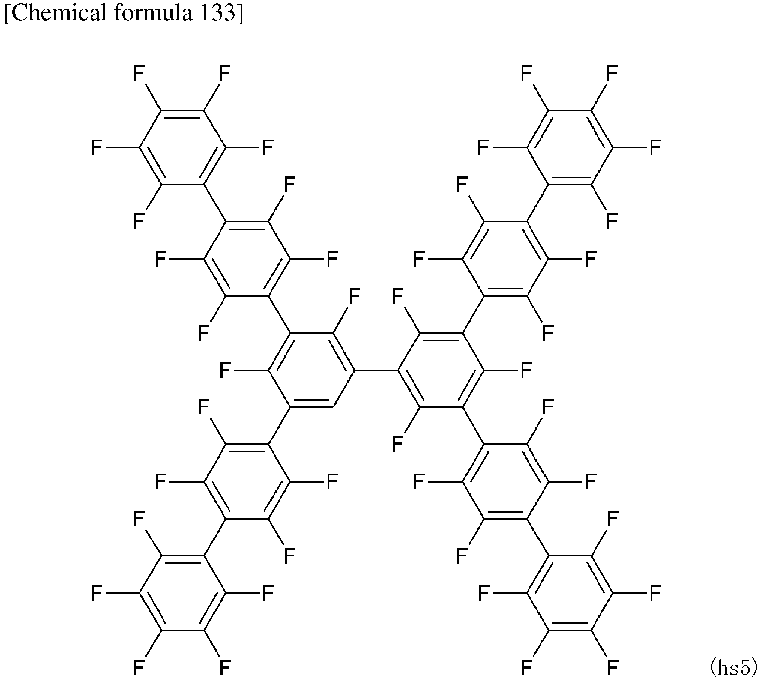

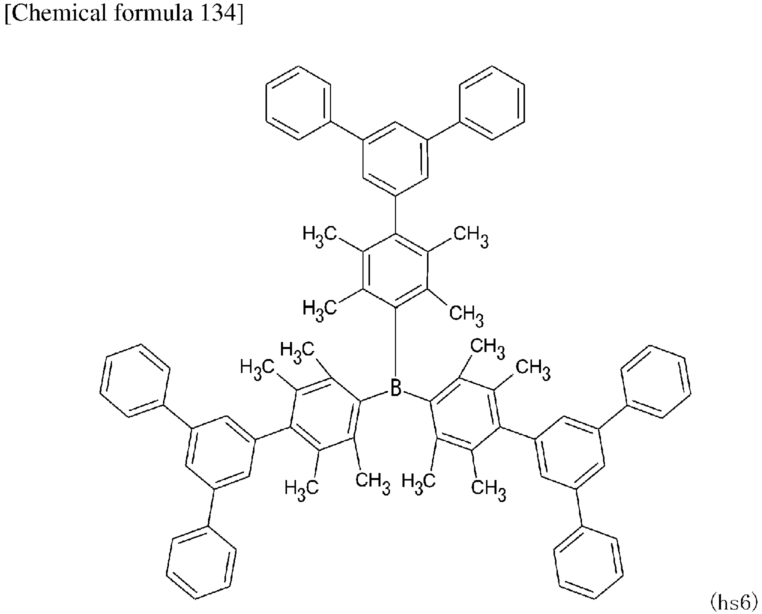

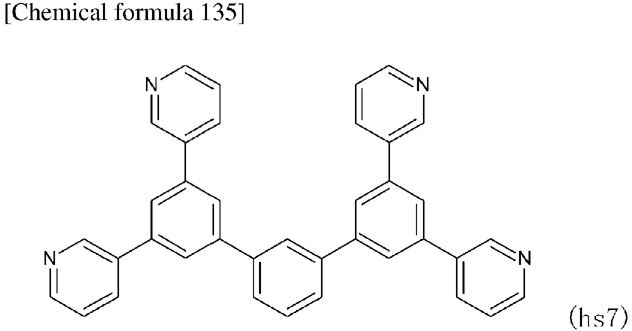

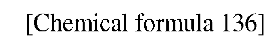

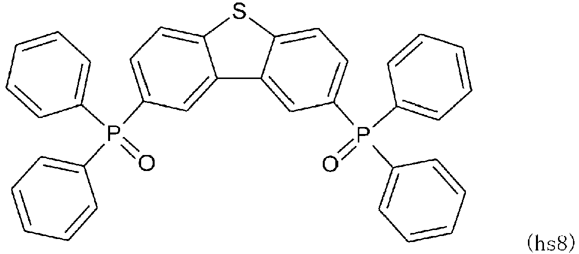

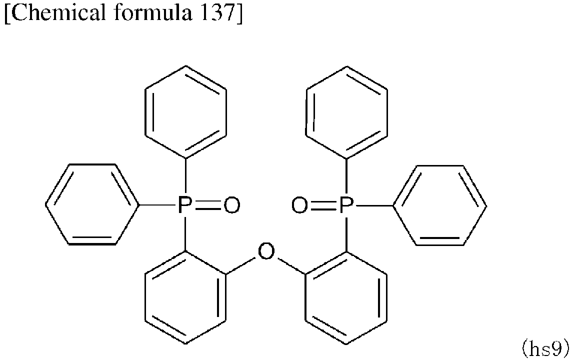

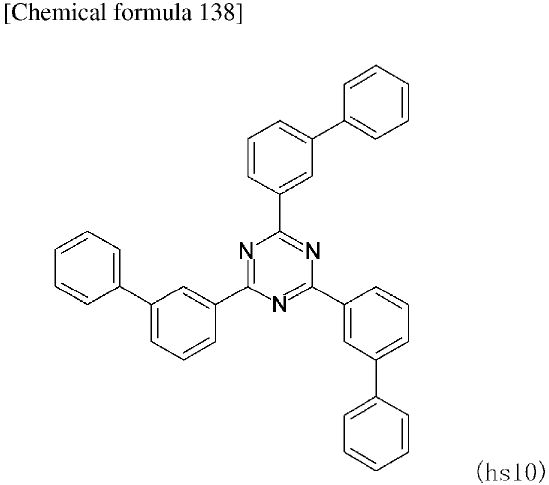

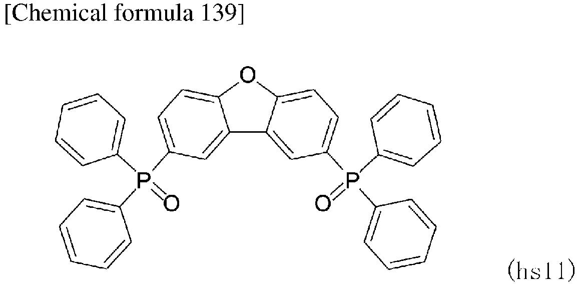

In addition to metal complexes of quinolinol derivatives such as Alq3 or BAlq, various other metal complexes, triazole derivatives, triazine derivatives, oxadiazole derivatives, thiadiazole derivatives, carbodiimide derivatives, quinoxaline derivatives, phenanthroline derivatives, or silole derivatives may be used in the electron-transporting layer which is provided as needed. One of the materials may be used alone, or at least two thereof may be used in combination. The electron-transporting layer may be a film of a single layer structure, or may be a film of a laminated structure. The materials may be subjected to deposition or another known method such as a spin coating method or an inkjet method to form a thin-film.

Although in an electron injection layer which is provided as needed, alkali metal salts such as lithium fluoride or cesium fluoride, alkaline earth metal salts such as magnesium fluoride, or metal oxides such as aluminum oxide may be used, the materials may not be contained in a preferred selection of an electron-transporting layer and a cathode.

In the electron injection layer or the electron-transporting layer, a material in which a metal such as cesium is n-doped to a material commonly used in the layer may be used.

Compounds (et1) to (et30) which are preferably used as electron-transporting materials are shown below.

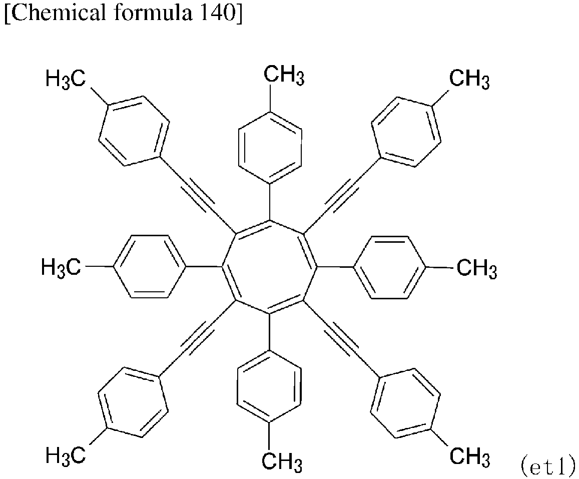

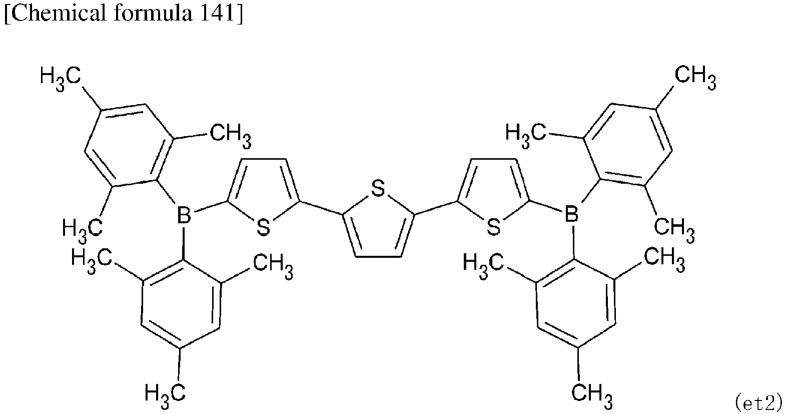

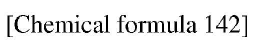

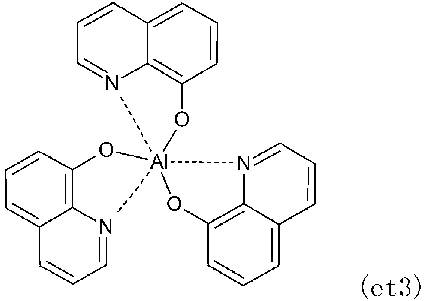

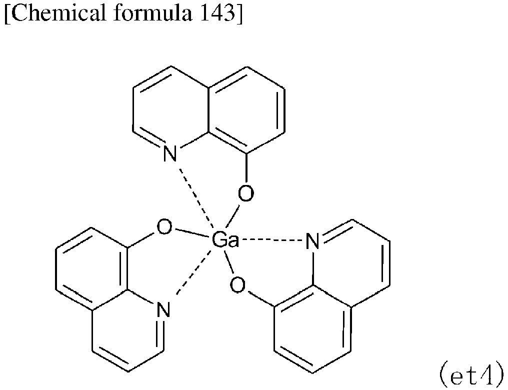

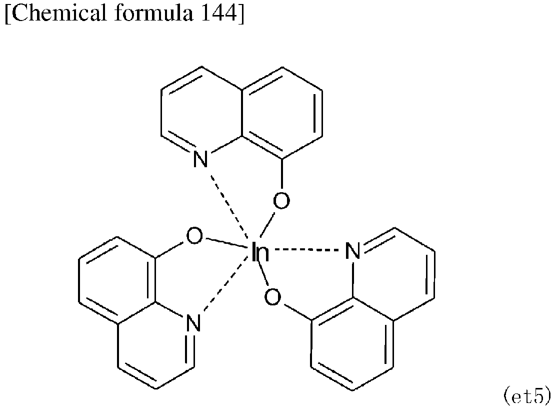

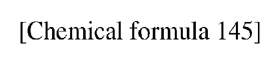

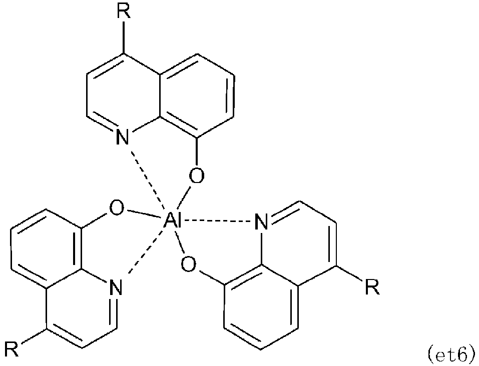

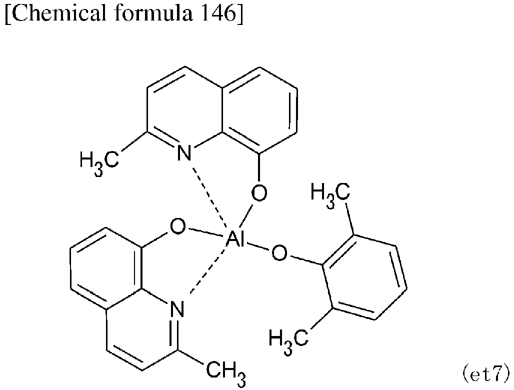

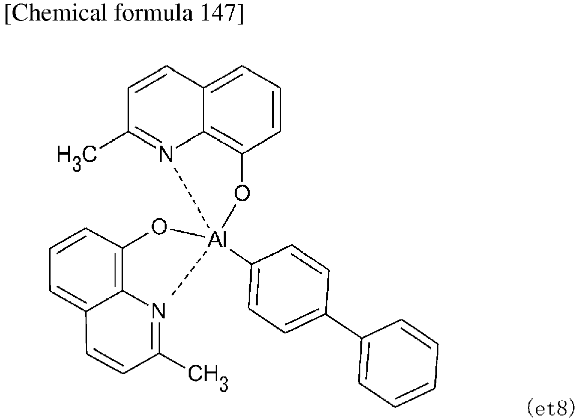

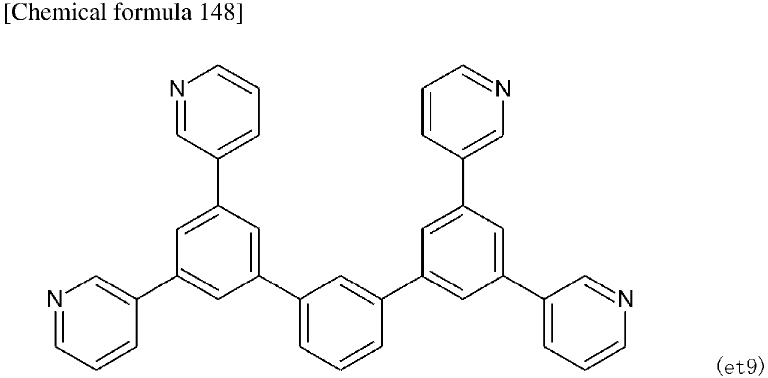

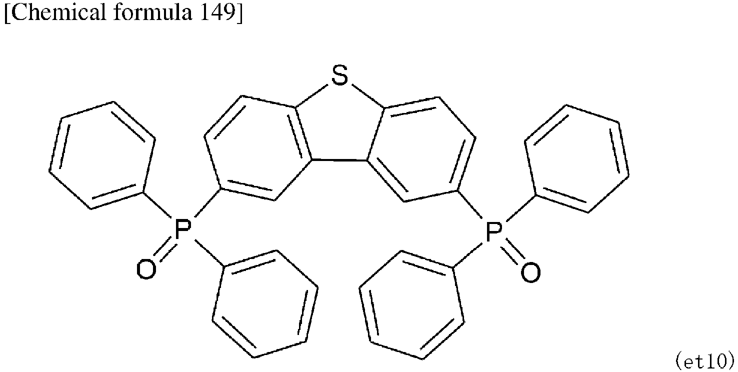

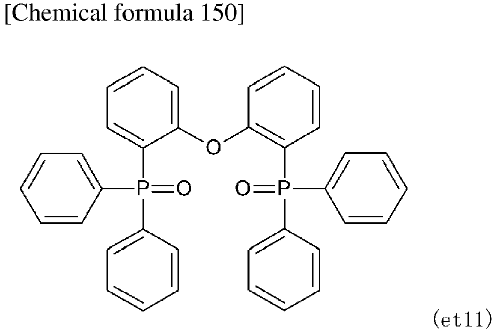

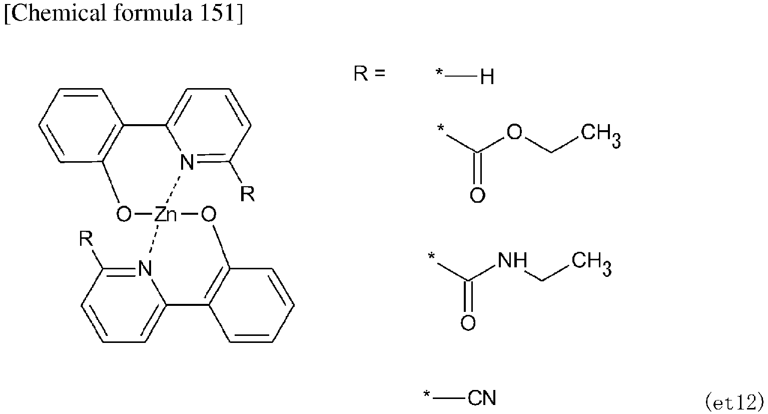

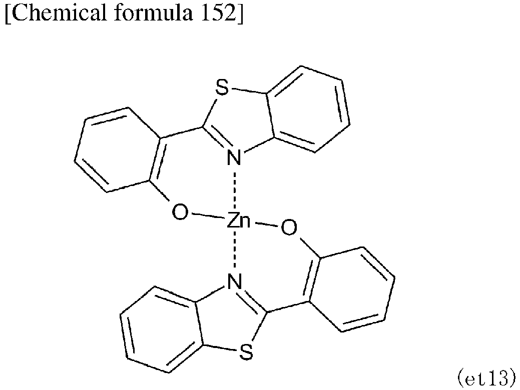

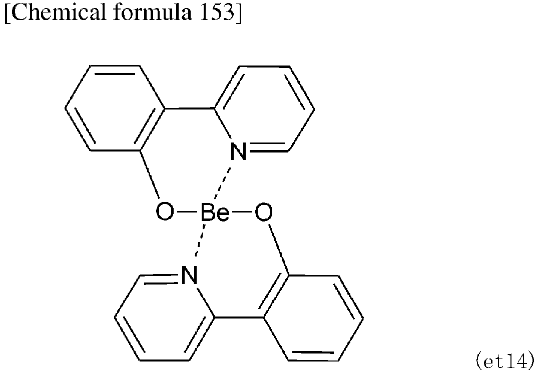

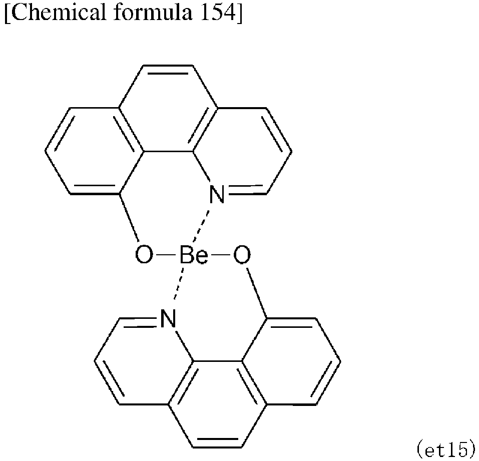

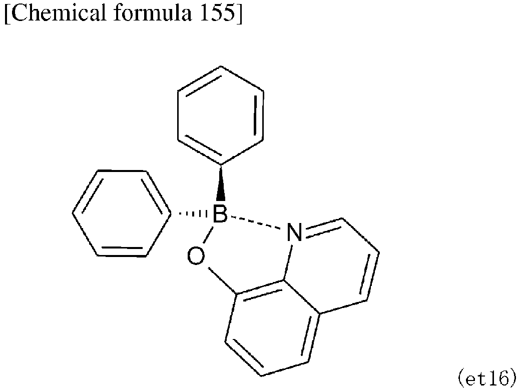

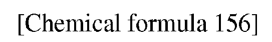

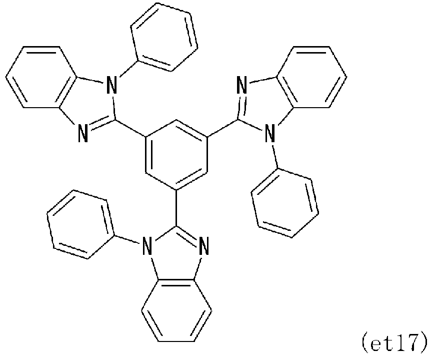

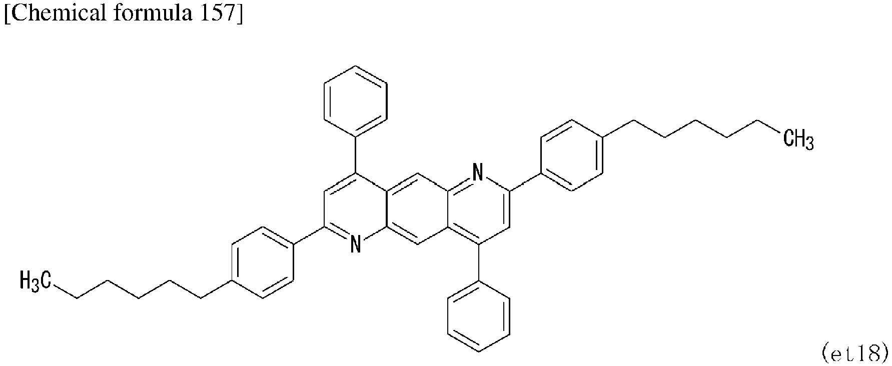

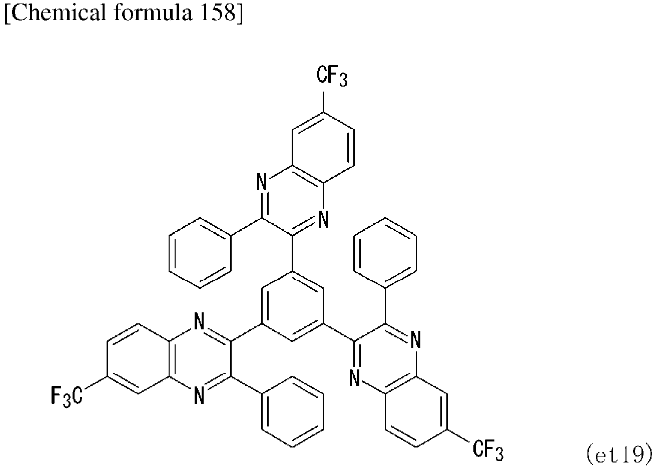

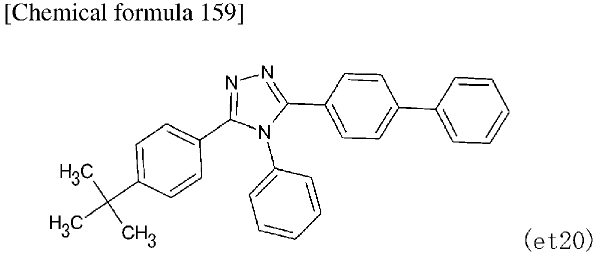

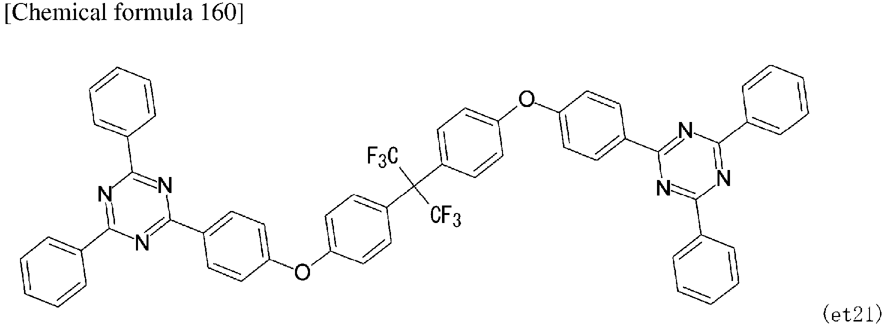

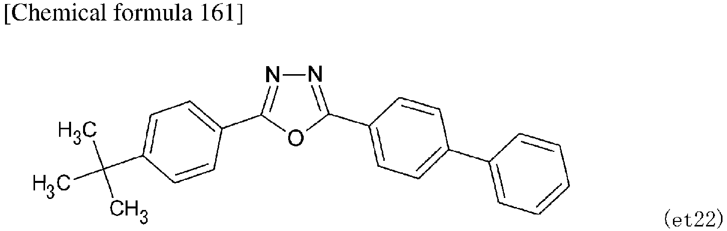

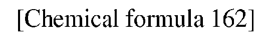

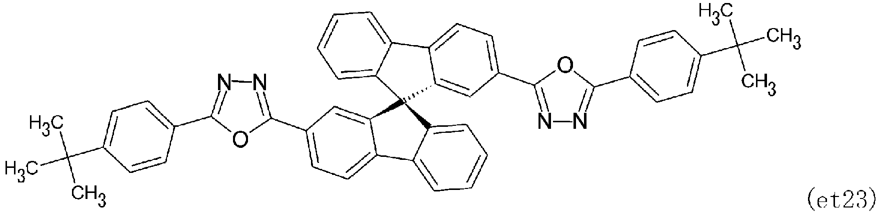

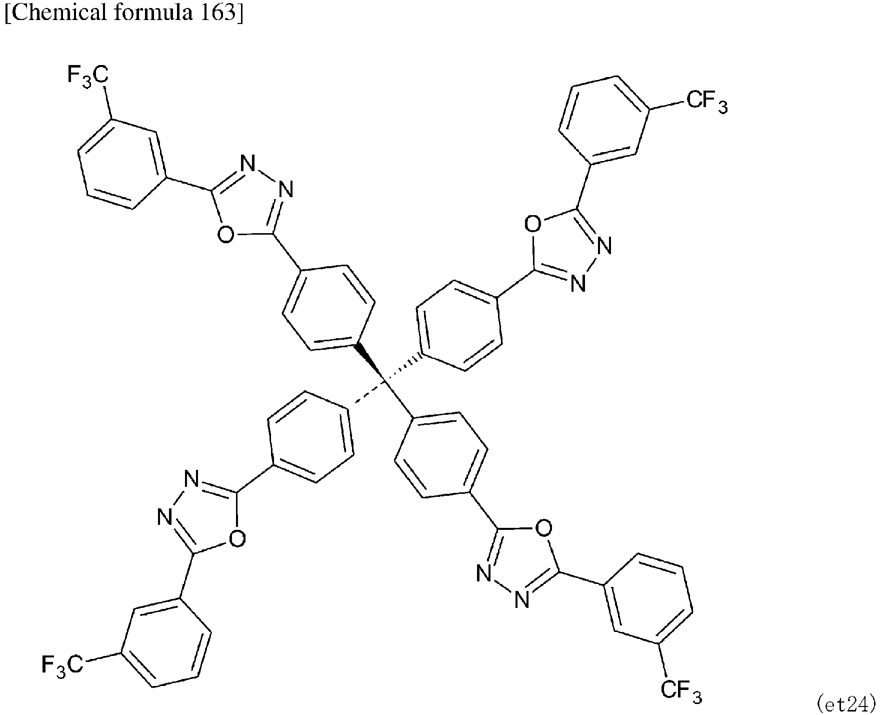

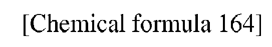

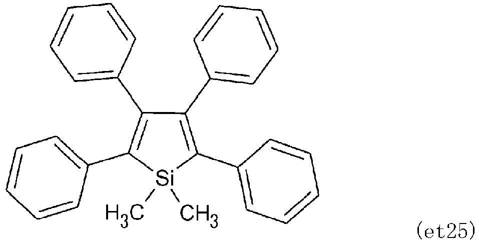

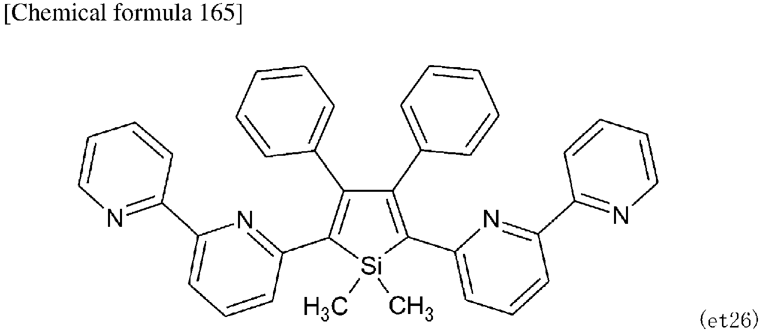

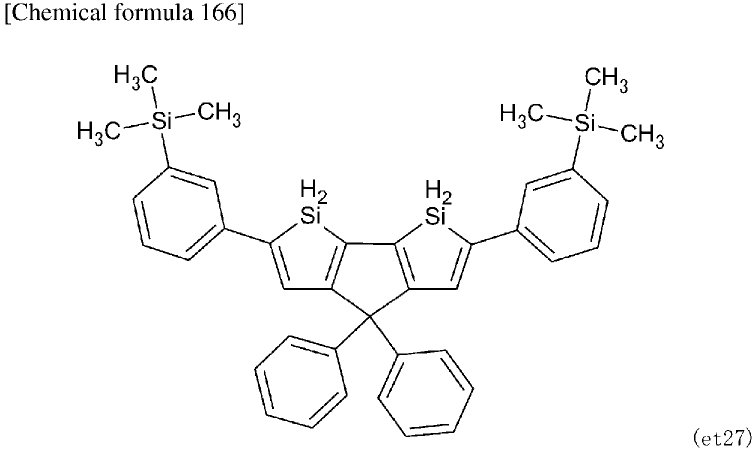

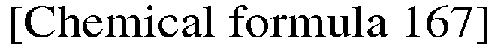

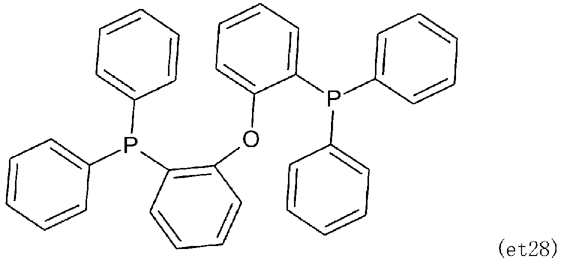

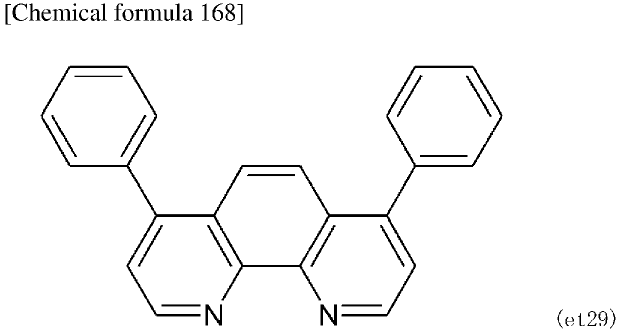

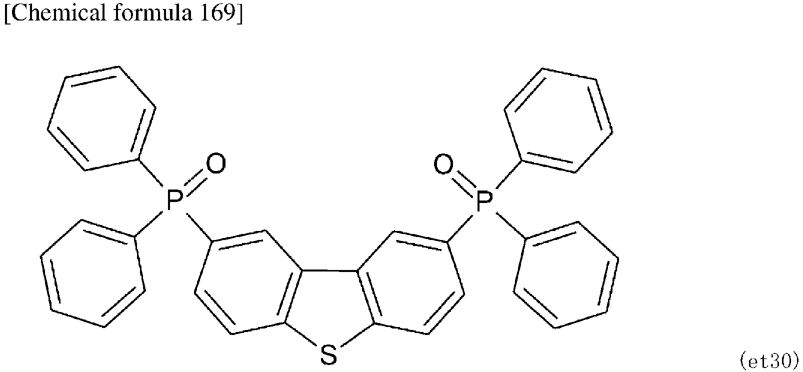

Compounds (ei1) to (ei4) which may be preferably used as electron injection materials are shown below.

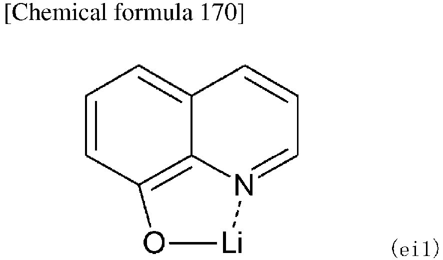

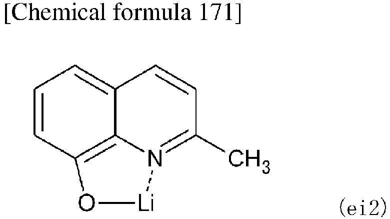

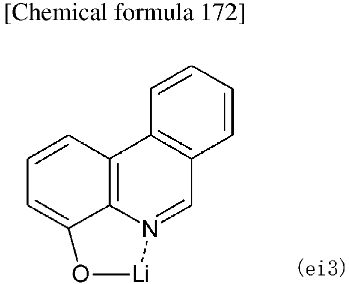

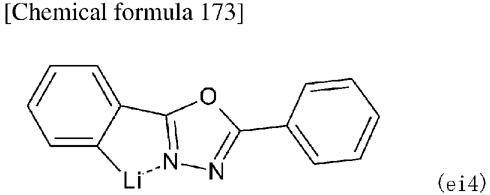

Compounds (st1) to (st5) which may be preferably used as stabilizing materials are shown below.

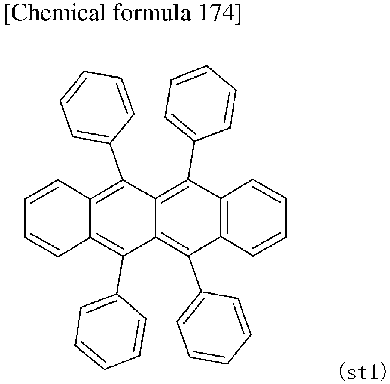

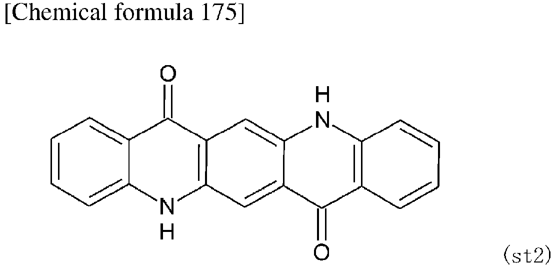

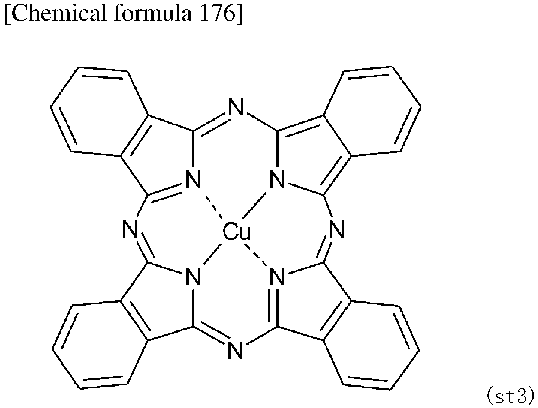

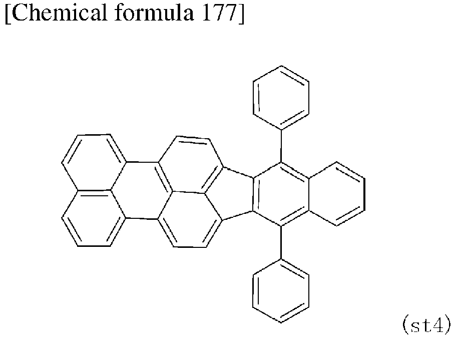

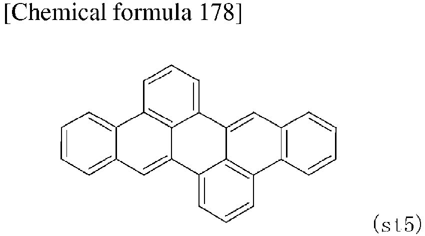

A material having a low work function is generally used in the cathode. Examples of the cathode material include sodium, an alloy of sodium and potassium, lithium, tin, magnesium, a mixture of magnesium and copper, a mixture of magnesium and aluminum, a mixture of magnesium and indium, a mixture of aluminum and aluminum oxide, indium, calcium, aluminum, silver, a mixture of lithium and aluminum, an alloy of magnesium and silver, an alloy of magnesium and indium, and an alloy of aluminum and magnesium. It is possible to obtain a transparent or semi-transparent cathode by using a transparent conductive material. The thickness of the cathode is usually 10 to 5000 nm, and preferably 50 to 200 nm. The sheet resistance of the cathode is preferably at least several hundred Ω/square.

For the purpose of protecting the cathode formed of a metal having a low work function, a layer of metal having a high work function and being stable against the atmosphere, such as aluminum, silver, nickel, chromium, gold, or platinum, is preferably laminated thereon, because the stability of the element is improved. A cathode interface layer may be provided between the cathode and an adjacent organic layer (such as an electron-transporting layer or an electron injection layer) to improve the contact therebetween. Examples of a material used in the cathode interface layer include aromatic diamine compounds, quinacridone compounds, naphthacene derivatives, organic silicon compounds, organic phosphorus compounds, compounds containing a N-phenyl carbazole skeleton, and N- vinylcarbazole polymer.

The light-emitting element according to the present invention may also be applied in any of a single element, an element having a structure in which components thereof are arranged in an array configuration, and an element having a structure in which an anode and a cathode are arranged in the X-Y matrix configuration.

Hereinafter, the present invention will be explained with reference to examples.

### (Example 1)

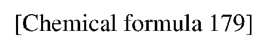

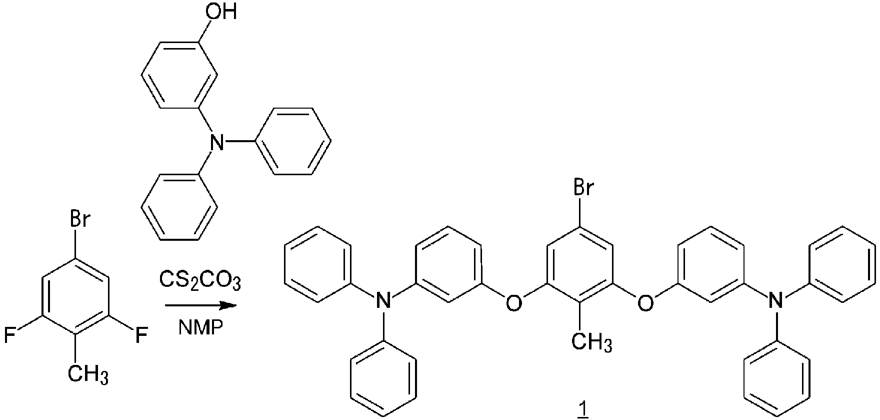

A mixture composed of 5-bromo-1,3-difluoro-2-methylbenzene (0.25 g, 1.2 mmol), 3-(diphenylamino)phenol (0.68 g, 2.6 mmol), Cs₂CO₃ (1.56 g, 4.8 mmol) and N-methyl-2-pyrrolidone (NMP, 12 mL) was stirred under nitrogen atmosphere at 170°C for 18 hours. The resultant was cooled to room temperature, followed by adding the resultant liquid to a large amount of water. The resultant was extracted with ethyl acetate, and then an organic layer was washed with brine and dried over an anhydrous Na₂SO₄. The resultant was subjected to filtration treatment and evaporation treatment, and then the obtained crude product was purified by silica gel column chromatography (eluent: hexane / dichloromethane = 6:1, v/v) to obtain a compound 1 as a white solid (yield = 0.65 g, 79% by mass).

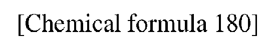

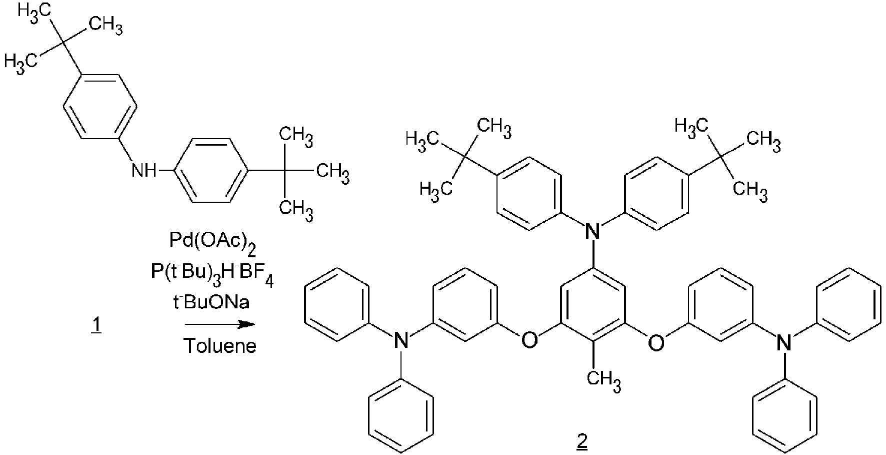

A mixture composed of the compound 1 (0.62 g, 0.9 mmol), bis(4-(tert-butyl)phenyl)amine (0.31 g, 1.1 mmol), NaO(t-Bu) (0.17 g, 1.8 mmol), Pd(OAc)₂ (0.002 g, 0.009 mmol) and P(t-Bu)₃H·BF₄ (0.003 g, 0.009 mmol) was put in dried toluene (9 mL), and then refluxed under nitrogen atmosphere for 14 hours. After the resultant was cooled to room temperature, the resultant liquid was diluted with ethyl acetate, and filtered by passing through a Celite (registered trademark) pad. The filtrate was washed with water, and dried over an anhydrous Na₂SO₄. The resultant was subjected to filtration treatment and evaporation treatment, and the obtained crude product was purified by silica gel column chromatography (eluent: hexane / dichloromethane = 3:1, v/v) to obtain a compound 2 as a white solid (yield = 0.62 g, 77% by mass).

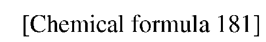

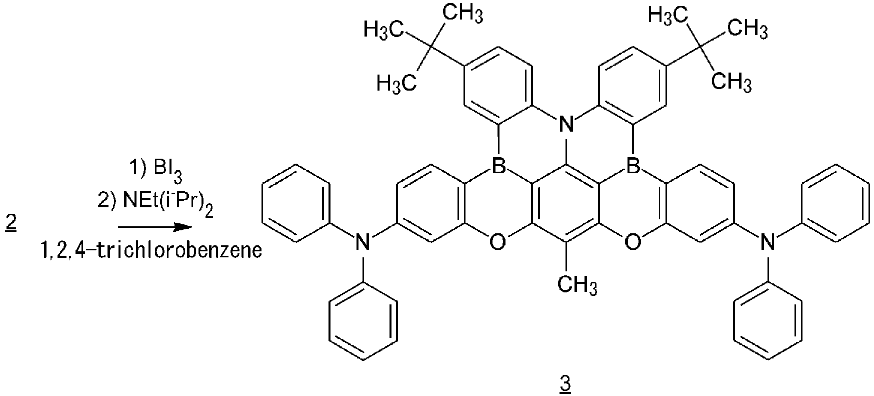

The compound 2 (0.089 g, 0.1 mmol) was dissolved in dried 1,2,4-trichlorobenzene (1.5 mL), followed by adding BI₃ (0.098 g, 0.25 mmol) gradually thereto at room temperature. The resultant was stirred at 180°C (bath temperature) for 20 hours under nitrogen atmosphere. The resultant was cooled to 0°C, followed by diluting the resultant with dichloromethane, adding NEt(i-Pr)₂ (0.03 mL, 0.2 mmol) thereto gradually, and then stirring the mixture at 0°C for 30 minutes. Then, an aqueous solution of Na₂SO₃ was added to the resultant solution to quench the reaction. Then, the resultant was extracted with dichloromethane. An organic layer was dried over anhydrous Na₂SO₄. The resultant was subjected to filtration treatment and evaporation treatment, followed by purifying the obtained crude product by silica gel column chromatography (eluent: hexane / dichloromethane = 4:1, v/v) to obtain a compound 3 (BOBO-Ω) as a yellow solid (yield = 0.030 g, 33% by mass).

### (Example 2)

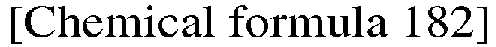

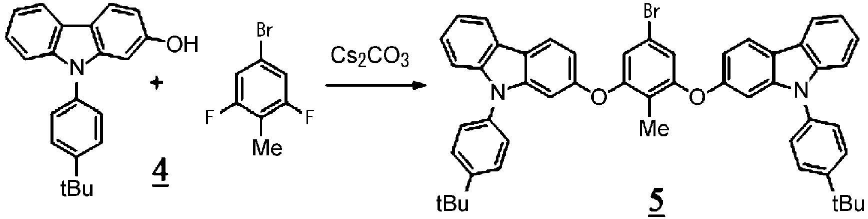

A mixture composed of 5-bromo-1,3-difluoro-2-methylbenzene (1.00 g, 4.84 mmol), 9-(4-(t-butyl)phenyl)9H-carbazol-2-ol (compound 4: 3.20 g, 10.2 mmol), Cs₂CO₃ (4.72 g, 14.4 mmol) and N-methyl-2-pyrrolidone (NMP, 20 mL) was stirred under nitrogen atmosphere at 170°C for 20 hours. The resultant was cooled to room temperature, and then added to 100 ml of 5% by volume of hydrochloric acid, followed by extracting the precipitated crystals with chloroform. An organic layer was washed with brine and then dried over anhydrous magnesium sulfate, followed by subjecting the resultant to filtration treatment and evaporation treatment, and then washing the obtained crude product with ether to obtain a compound 5 as a white solid (yield = 3.88 g, 87.6% by mass).

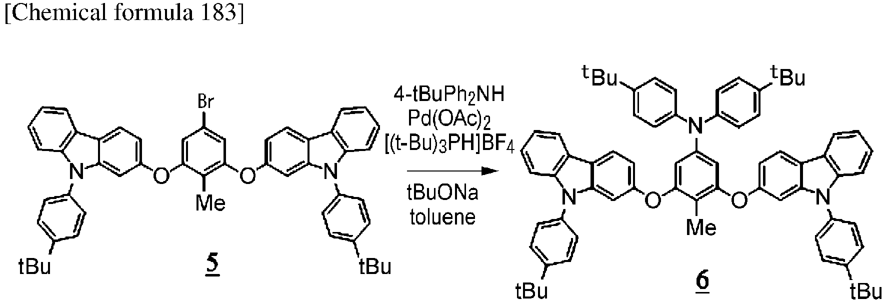

A mixture composed of the compound 5 (1.00 g, 1.25 mmol), bis(4-(t-butyl)phenyl)amine (0.53 g, 1.88 mmol), NaO(t-Bu) (0.22 g, 2.29 mmol), Pd(OAc)₂ (14.0 mg, 0.065 mmol) and P(t-Bu)3H·BF4 (29.7 mg, 0.10 mmol) was put in dried toluene (16 mL), and then refluxed under nitrogen atmosphere for six hours. After the resultant was cooled to room temperature, the resultant liquid was diluted with ethyl acetate, and filtered by passing through a Celite (registered trademark) pad. The filtrate was washed with water, and dried over an anhydrous magnesium sulfate. The resultant was subjected to filtration treatment and evaporation treatment, and the obtained crude product was purified by silica gel column chromatography (eluent: hexane / chloroform = 4:1, v/v) to obtain a compound 6 as a white solid (yield = 1.16 g, 93.1 % by mass).

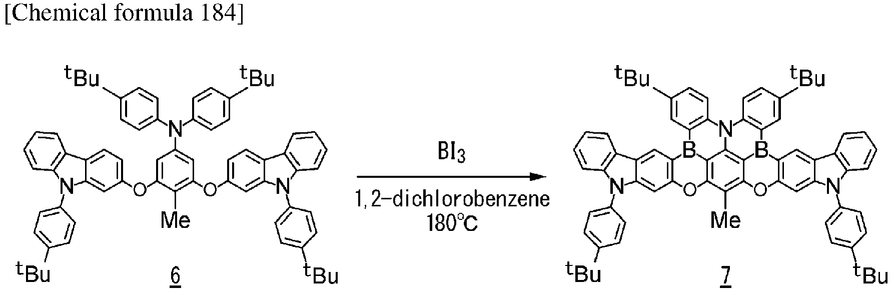

The compound 6 (1.00 g, 1.0 mmol) was dissolved in dried 1,2-dichlorobenzene (80 mL), followed by adding BI₃ (1.37 g, 3.50 mmol) gradually thereto at room temperature. The resultant was stirred at 180°C (bath temperature) for 48 hours under nitrogen atmosphere. The resultant was cooled to 0°C, followed by diluting the resultant with dichloromethane, and adding an aqueous solution of Na₂SO₃ (0.50 mol/L, 10 mL) thereto to quench the reaction. The resultant was stirred for ten minutes at 0°C, and then extracted with dichloromethane. An organic layer was dried over anhydrous Na₂SO₄. The resultant was subjected to filtration treatment and evaporation treatment, followed by purifying the obtained crude product by silica gel column chromatography (eluent: hexane / dichloromethane = 1:3, v/v) to obtain a compound 7 (BOBO-Ψ) as a yellow solid (yield = 0.08 g, 8% by mass).

¹H NMR (400 MHz, CDCl₃, δ): 9.52 (s, 2H), 9.00 (s, 2H), 8.33 (t, 4H), 7.69 (t, 6H), 7.61 (t, 6H), 7.46 (m, 4H), 7.44-7.38 (m, 2H), 2.79 (s, 3H), 1.61-1.56 (m, 18H), 1.51-1.47 (m, 18H). MS (MALDI-TOF): m / z calculated value 1013.53 [M]+; measured value 1013.76.

### (Example 3)

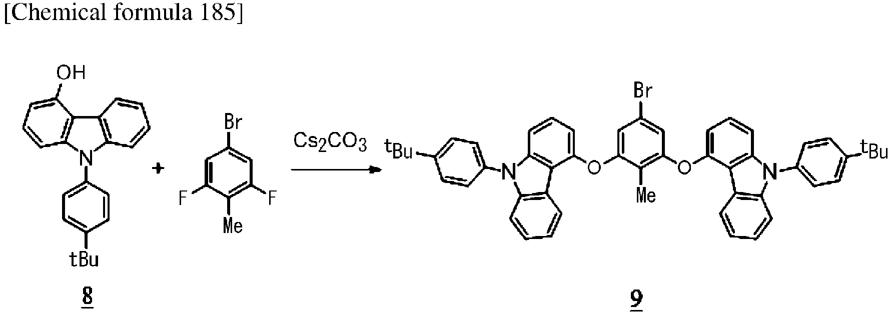

A mixture composed of 5-bromo-1,3-difluoro-2-methylbenzene (1.00 g, 4.84 mmol), 9-(4-(t-butyl)phenyl)9H-carbazol-4-ol (compound 8) (3.20 g, 10.2 mmol), Cs₂CO₃ (4.72 g, 14.4 mmol) and N-methyl-2-pyrrolidone (NMP, 20 mL) was stirred under nitrogen atmosphere at 170°C for 24 hours. The resultant was cooled to room temperature, and then added to 100 ml of 5% by volume of hydrochloric acid, followed by extracting the precipitated crystals with chloroform. An organic layer was washed with brine and then dried over anhydrous magnesium sulfate, followed by subjecting the resultant to filtration treatment and evaporation treatment, and then washing the obtained crude product with ether to obtain a compound 9 as a white solid (yield = 3.05 g, 79.1% by mass).

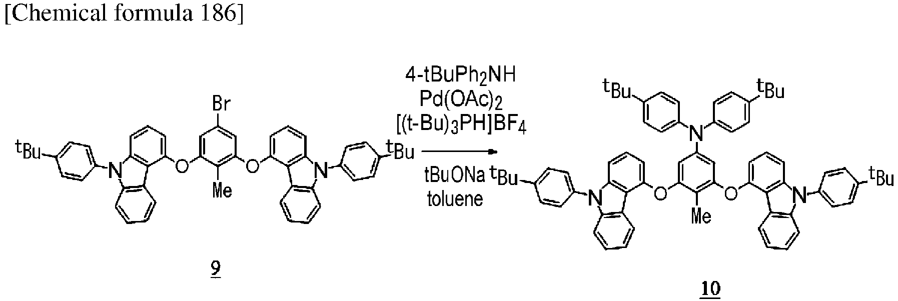

A mixture composed of the compound 9 (1.00 g, 1.25 mmol), bis(4-(t-butyl)phenyl)amine (0.53 g, 1.88 mmol), NaO(t-Bu) (0.22 g, 2.29 mmol), Pd(OAc)₂ (14.0 mg, 0.065 mmol) and P(t-Bu)₃H·BF₄ (29.7 mg, 0.10 mmol) was put in dried toluene (10 mL), and then refluxed under nitrogen atmosphere for four hours. The resultant was cooled to room temperature, and then the resultant liquid was diluted with ethyl acetate, and filtered by passing through a Celite (registered trademark) pad. The filtrate was washed with water, and dried over an anhydrous magnesium sulfate. The resultant was subjected to filtration treatment and evaporation treatment, and the obtained crude product was washed with a mixture solvent composed of hexane / chloroform = 4 / 1, thereby obtaining 1.21 g of crude crystals of a compound 10. The crude crystals were purified by silica gel column chromatography (eluent: hexane / chloroform = 4:1, v/v) to obtain a compound 10 as a white solid (yield = 1.10 g, 88.3% by mass).

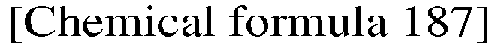

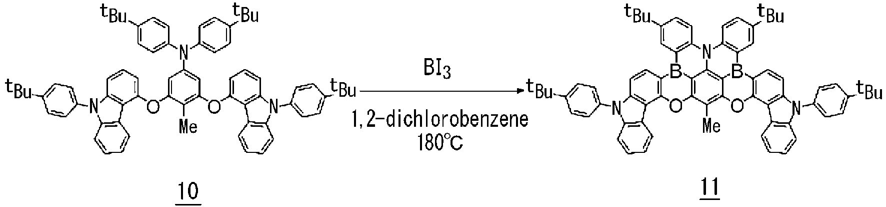

The compound 10 (1.00 g, 1.0 mmol) was dissolved in dried 1,2-dichlorobenzene (80 mL), followed by adding BI₃ (1.37 g, 3.50 mmol) gradually thereto at room temperature. The resultant was stirred at 180°C (bath temperature) for 48 hours under nitrogen atmosphere. The resultant was cooled to 0°C, followed by diluting the resultant with dichloromethane, and adding an aqueous solution of Na₂SO₃ (0.50 mol/L, 10 mL) thereto to quench the reaction. The resultant was stirred for ten minutes at 0°C, and then extracted with dichloromethane. An organic layer was dried over anhydrous Na₂SO₄. The resultant was subjected to filtration treatment and evaporation treatment, followed by purifying the obtained crude product by silica gel column chromatography (eluent: hexane / dichloromethane = 4:1, v/v) to obtain a compound 11 (BOBO-X) as a light yellow solid (yield = 0.16 g, 16% by mass).

¹H NMR (400 MHz, CDCl₃, δ): 9.15 (d, J = 7.60 Hz, 2H), 8.85 (s, 2H), 8.80 (d, J = 8.80 Hz, 2H), 8.30 (d, J = 8.80 Hz, 2H), 7.69 (d, J = 8.40 Hz, 2H), 7.64-7.50 (m, 14H), 3.49 (s, 3H), 1.50-1.48 (m, 36H). MS (MALDI-TOF): m / z calculated value 1013.53 [M]+; measured value 1013.67.

Evaluations of the luminescent characteristics shown below were carried out using SourceMeter (manufactured by Keithley Instruments: 2400 series), a spectroradiometer (manufactured by Konica Minolta Inc.: CS-2000), a fluorescence spectrophotometer (manufactured by JASCO Corporation: FP-8600), and a 100 mm Φ integrating sphere (manufactured by JASCO Corporation: ILF-835).

### (Test Example 1)

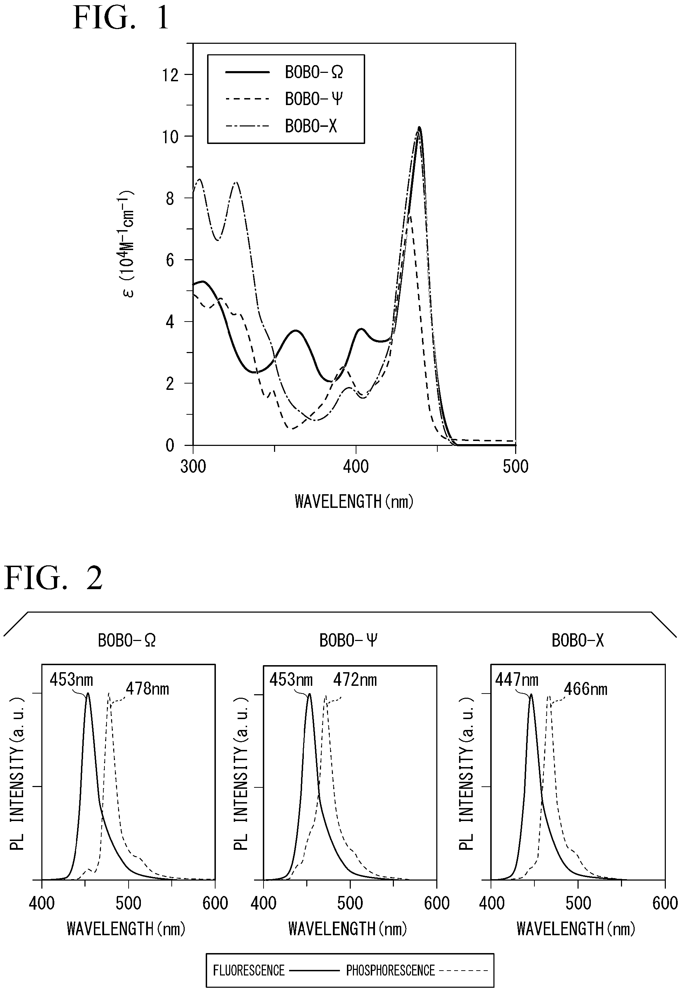

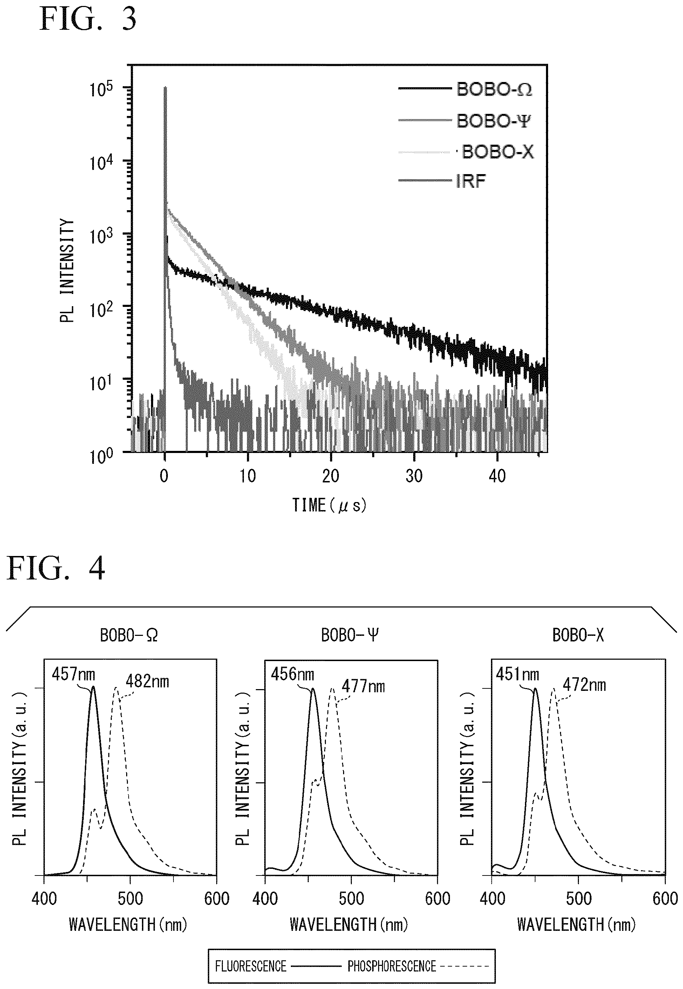

In a glove box under a nitrogen atmosphere, 10⁻⁵ M toluene solutions of BOBO-Ω (the compound of formula (I-1)), BOBO-Ψ (the compound of the formula (I-6)), and BOBO-X (the compound of the formula (I-7)) were prepared. PL spectra of these solutions were measured. The results are shown in Table 1. In Fig. 1, absorption spectra thereof are shown. In Fig. 2, the PL spectra thereof (the wavelength of fluorescence or phosphorescence emitted at 77K (non-thermal activation)) are shown. In Fig. 3, transient TRPLcharacteristics thereof are shown. The term "IRF" in Fig. 3 indicates the device response function.

The absorption spectra were measured using an ultraviolet-visible near-infrared spectrophotometer (manufactured by JASCO Corporation: V-670), the PL spectra were measured using a fluorescence spectrophotometer (manufactured by JASCO Corporation: FP-8600), and the TRPL characteristics were measured using a Quantaurus-Tau compact fluorescence lifetime measurement apparatus C-11367 (manufactured by Hamamatsu Photonics K.K.), in a conventional manner.

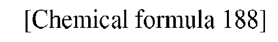

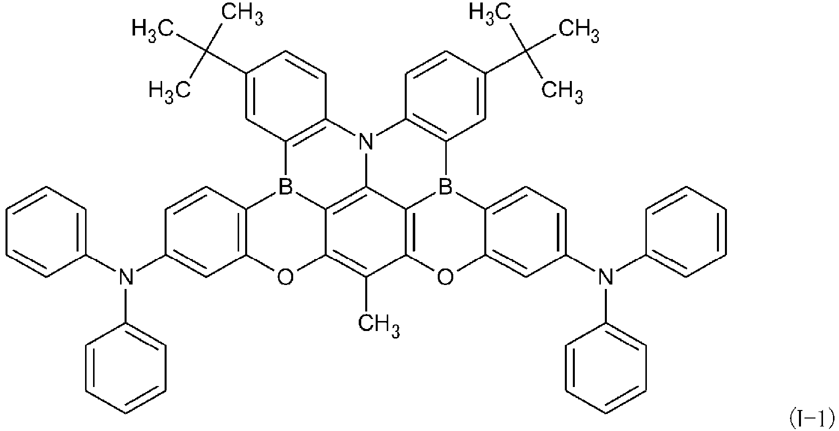

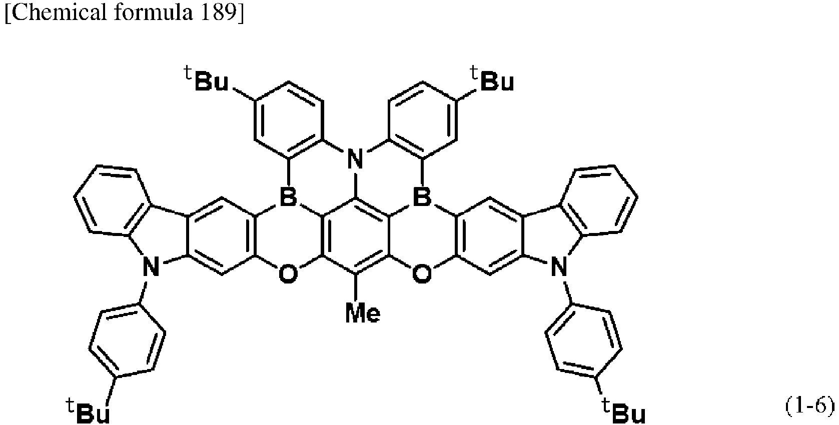

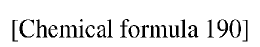

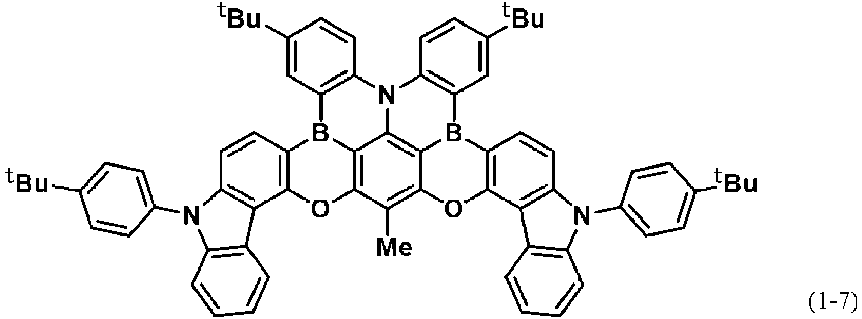

**[Table 1]**

| | λ_{PL} [nm] | λ_{FWHM} [nm] | E_{FWHM} [eV] | Φ_{PL} [%] | τ^{p}[ns] / τ^{d}[µs] | kr,S [10⁸s⁻¹] | k_{ISC} [10⁸s⁻¹] | k_{RISC} [10⁵s⁻¹] | Φₚ / Φ_{d} [%] | ΔE_{ST} [eV] |
|---|---|---|---|---|---|---|---|---|---|---|
| BOBO-Ω | 453 | 19 | 0.11 | 85 | 1.7 / 14 | 1.5 | 44 | 2.2 | 26 / 59 | 0.14 |
| BOBO-Ψ | 453 | 19 | 0.11 | 91 | 1.2 / 3.4 | 1.7 | 6.6 | 12 | 20 / 71 | 0.11 |
| BOBO-X | 447 | 19 | 0.11 | 90 | 1.4 / 2.8 | 1.9 | 5.3 | 12 | 27 / 63 | 0.11 |

λ_{FWHM}: half width (wavelength); E_{FWHM}: half width (energy); Φ_{PL}: luminescent quantum yield; τₚ/τ_{d}: instantaneous fluorescence lifetime / delayed fluorescence lifetime; k_{r,s}: fluorescence emission rate constant; k_{ISC}: intersystem crossing rate constant; k_{RISC}: reverse intersystem crossing rate constant; Φₚ/Φ_{d}: instantaneous fluorescence quantum yield / delayed fluorescence quantum yield; ΔE_{ST}: energy difference between the S₁ state and the T₁ state.

### (Test Example 2)

A thin film having a thickness of 100 nm was obtained by evaporating a host material of 3,3'-di(9H-carbazol-9-yl)-1,1'-biphenyl (mCBP) with 1% by mass of each of BOBO-Ω (the compound of the formula (1-1)), BOBO-Ψ (the compound of the formula (I-6)) and BOBO-X (the compound of the formula (I-7)) as vapor deposition sources onto a quartz substrate under a condition of 10⁻⁴ Pa or less using a vacuum evaporation apparatus E-200 (manufactured by ALS Technology co., ltd.).

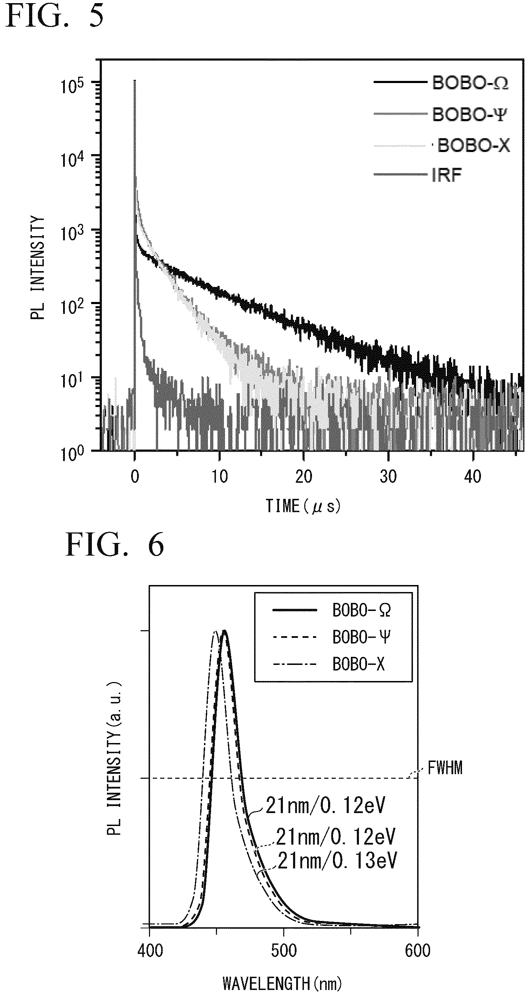

In FIG. 4, PL spectra (the wavelength of fluorescence or phosphorescence emitted at 77 K (non-thermal activation)) are shown. In FIG. 5, transient TRPL characteristics are shown. The term "IRF" in FIG. 5 indicates the device response function. The PL spectra were measured using a fluorescence spectrophotometer (manufactured by JASCO Corporation: FP-8600), and the TRPL characteristics were measured using a Quantaurus-Tau compact fluorescence lifetime measurement apparatus C-11367 (manufactured by Hamamatsu Photonics K.K.), in a conventional manner.

**[Table 2]**

| | λ_{PL} [nm] | λ_{FWHM} [nm] | E_{FWHM} [eV] | Φ_{PL} [%] | τ^{p}[µs] / | kr,S [10⁸s⁻¹] | k_{ISC} [10⁸s⁻¹] | k_{RISC} [10⁵s⁻¹] | Φₚ / Φ_{d} [%] | ΔE_{ST} [eV] |
|---|---|---|---|---|---|---|---|---|---|---|
| BOBO-Ω | 457 | 22 | 0.13 | 83 | 1.6 / 8.1 | 1.3 | 4.9 | 4.5 | 21 / 62 | 0.14 |
| BOBO-Ψ | 456 | 22 | 0.13 | 82 | 1.8 / 2.2 | 1.8 | 3.7 | 11 | 33 / 49 | 0.12 |
| BOBO-X | 451 | 21 | 0.13 | 93 | 2.1 / 2.2 | 1.8 | 3.0 | 11 | 38 / 55 | 0.12 |

### (Test Example 3)

A layer of 2,3,6,7,10,11-hexacyano-1,4,5,8,9,12-hexaazatriphenylene (HAT-CN) having a thickness of 10 nm, a layer of 1,1-bis[4-[N,N-di(p-tolyl)amino]phenyl]cyclohexane (TAPC) having a thickness of 40 nm, a layer of 1, 3-bis(1,8-dimethylcarbazol-9-yl)benzene (mMCP) having a thickness of 10 nm, a layer of 1% by weight of BOBO-Ω: 3,3'-di(9H-carbazol-9-yl)-1,1'-biphenyl (mCBP) having a thickness of 30 nm, a layer of 2,8-bis(diphenylphosphoryl)dibenzo[b,d]furan (PPF) having a thickness of 10 nm, and a layer of 1,3-bis[3,5-di(pyridin-3-yl)phenyl]benzene (B3PyPB) having a thickness of 30 nm were laminated in this order by a vacuum deposition method (at 5.0x10⁻⁴ Pa or less) on a glass substrate on which an anode (with a thickness of 50 nm) made of indium tin oxide (ITO) was formed.

Then, a layer of 8-hydroxyquinolinolato-lithium having a thickness of 1 nm, and a layer of aluminum having a thickness of 100 nm were further laminated in this order by a vacuum deposition method (vacuum evaporation apparatus E-200 (manufactured by ALS Technology co., ltd.) to form a cathode, thereby obtaining an organic electroluminescence element.

An organic electroluminescence element was obtained by the above-mentioned method, except that 2% by weight of BOBO-Ψ or 2% by weight of BOBO-X was used instead of 1% by weight of BOBO-Ω.

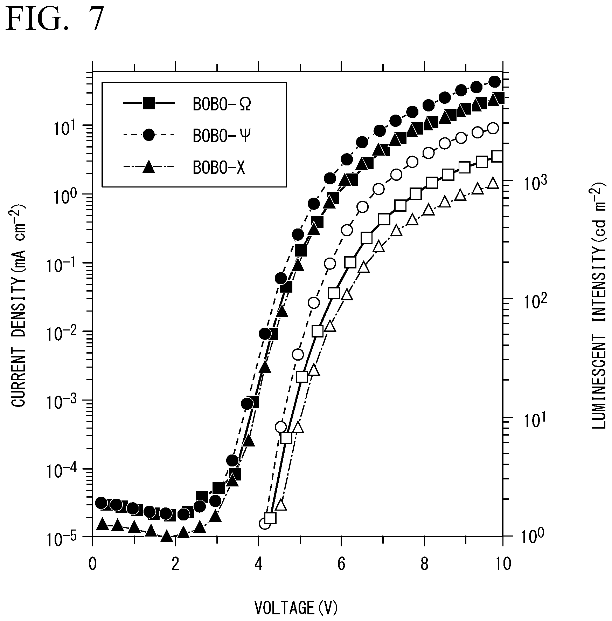

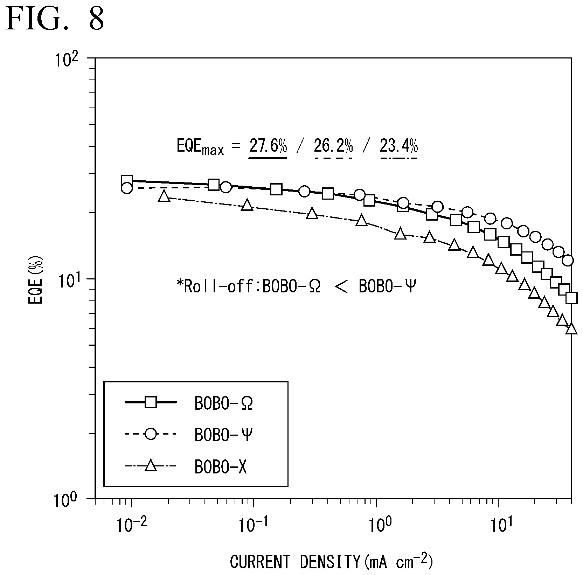

Characteristics of each of the obtained organic electroluminescence elements were measured. In Table 3, each luminescent characteristic is shown. In Fig. 6, EL spectra are shown. In Fig. 7, voltage-current density-luminescent intensity characteristics are shown. In Fig. 8, luminescent intensity-external quantum efficiency characteristics are shown. The evaluation of the electroluminescent characteristics was carried out in a conventional manner using a source meter (manufactured by Keithley Instruments: 2400 series) and a spectroradiometer (manufactured by KONICA MINOLTA, INC.: CS-2000).

**[Table 3]**

| | λ_{EL} [nm] | λ_{FWHM} [nm] | E_{FWHM} [eV] | Vₒₙ [V] | Lₘₐₓ [cdm⁻²] | EQE[%]Max / @ 10²cdm⁻² / @ 10³cdm⁻² | CEₘₐₓ [cdA⁻¹] | PEₘₐₓ [1mW⁻¹] | CIE (x,y) |
|---|---|---|---|---|---|---|---|---|---|
| BOBO-Ω (1wt%) | 456 | 21 | 0.12 | 4.3 | 3100 | 27.6 / 22.6 / 14.6 | 15.3 | 11.2 | (0.140, 0.056) |
| BOBO-Ψ (2wt%) | 455 | 21 | 0.12 | 4.2 | 3519 | *26.2* / 23.7 / 17.6 | 14.2 | 10.6 | (0.143, 0.052) |
| BOBO-X (2wt%) | 449 | 21 | 0.13 | 4.5 | 1506 | 23.4 / 15.8 / 7.02 | 10.1 | 6.89 | (0.156, 0.048) |

Vₒₙ: turn-on voltage; Lₘₐₓ: maximum luminescent intensity; CEₘₐₓ: maximum current efficiency; PEₘₐₓ: maximum electric power efficiency; CIE(x,y): CIE chromaticity coordinate (CIE 1931 chromaticity diagram); @ 10² cdm⁻²: EQE (%) at a luminescent intensity of 10² cdm⁻²; @ 10³ cdm⁻²: EQE (%) at a luminescent intensity of 10³ cdm⁻²

The light-emitting element according to the present invention emitted narrowband blue light with a high external quantum efficiency.

## Claims

1. A compound of formula (1): 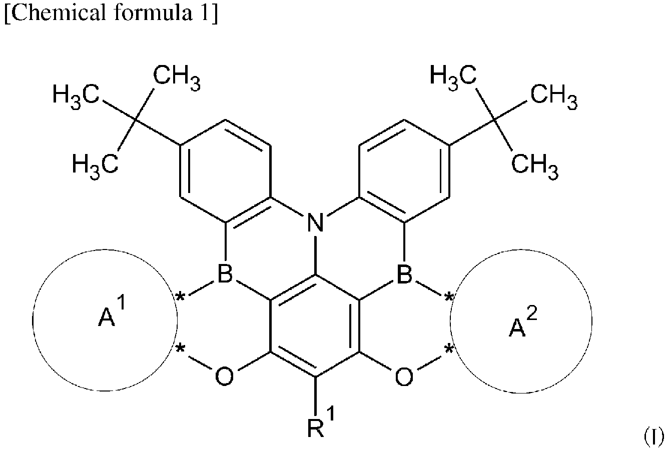 in the formula (I),
R¹ is a C1-4 alkyl group, a substituted or unsubstituted phenyl group, a substituted or unsubstituted naphthyl group, a substituted or unsubstituted anthryl group or a substituted or unsubstituted phenanthryl group,
A¹ and A² are each independently a group of formula (II), a group of formula (III), a group of formula (IV), a group of formula (V), a group of formula (VI), a group of formula (VII), a group of formula (VIII) or a group of formula (IX), 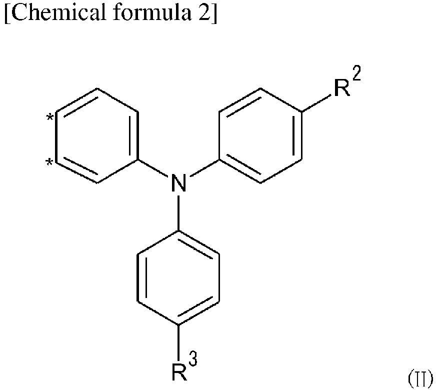 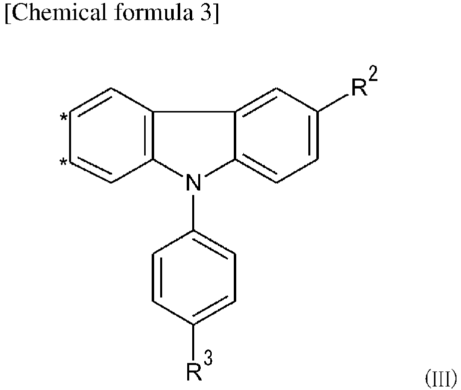 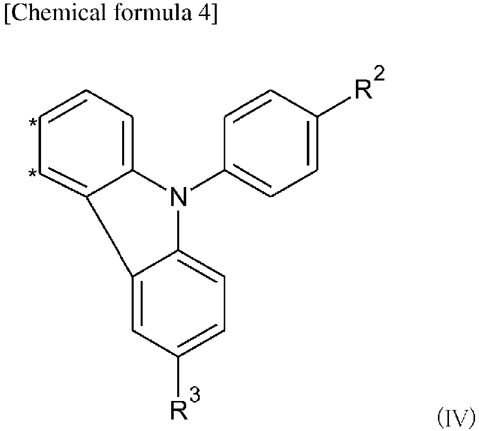 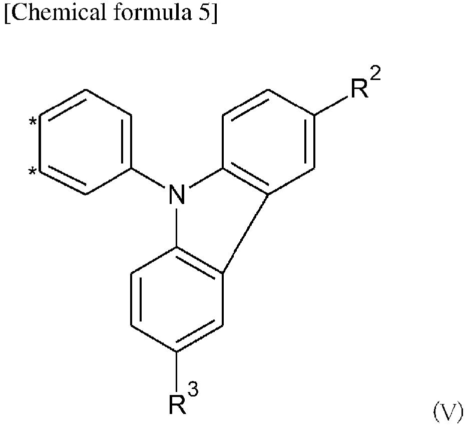 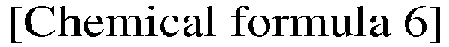 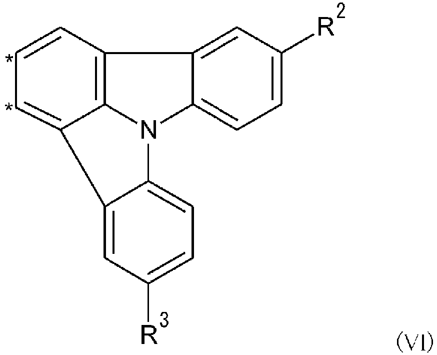 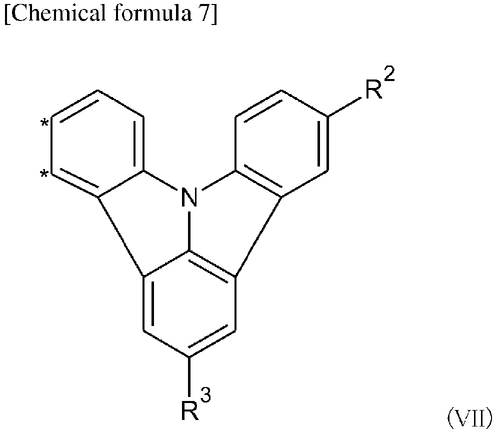 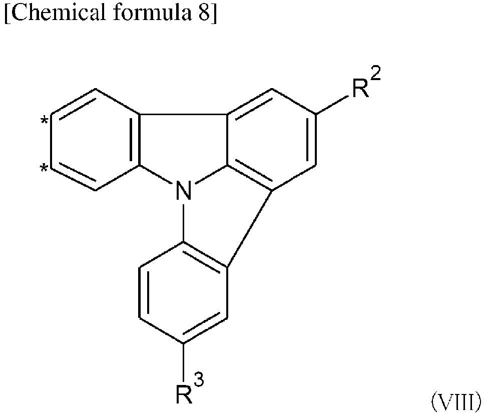 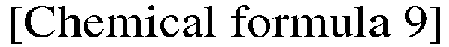 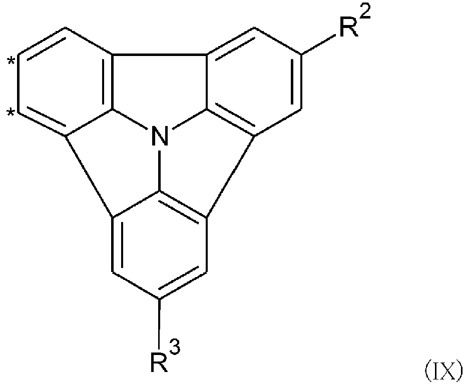
in the formula (II), the formula (III), the formula (IV), the formula (V), the formula (VI), the formula (VII), the formula (VIII) and the formula (IX), R² and R³ are each independently a hydrogen atom, a C1-4 alkyl group or a substituted or unsubstituted phenyl group, and
* indicates a binding site.

2. The compound according to claim 1, wherein in the formula (II), the formula (III), the formula (IV), the formula (V), the formula (VI), the formula (VII), the formula (VIII) and the formula (IX), R² and R³ are each independently a hydrogen atom or a t-butyl group.

3. A light-emitting material comprising a compound of claim 1 or 2.

4. A light-emitting element comprising a light-emitting material of claim 3.
